(19) Europäisches Patentamt / European Patent Office / Office européen des brevets

(11) **EP 4 418 577 A1**

(12) **EUROPEAN PATENT APPLICATION**
published in accordance with Art. 153(4) EPC

(43) Date of publication:
**21.08.2024 Bulletin 2024/34**

(21) Application number: **22900241.5**

(22) Date of filing: **09.11.2022**

(51) International Patent Classification (IPC):
**H04L 1/00** (2006.01)   **H03M 13/00** (2006.01)
**H04L 27/34** (2006.01)

(52) Cooperative Patent Classification (CPC):
**H03M 13/00; H04B 7/185; H04L 1/00; H04L 27/34**

(86) International application number:
**PCT/CN2022/130890**

(87) International publication number:
**WO 2023/098436 (08.06.2023 Gazette 2023/23)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.12.2021 CN 202111473306**

(71) Applicant: **Huawei Technologies Co., Ltd.
Shenzhen, Guangdong 518129 (CN)**

(72) Inventors:
• **WANG, Xiaolu
  Shenzhen, Guangdong 518129 (CN)**
• **LI, Rong
  Shenzhen, Guangdong 518129 (CN)**
• **LUO, Hejia
  Shenzhen, Guangdong 518129 (CN)**
• **WANG, Jun
  Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **INTERLEAVING AND MODULATION METHOD, APPARATUS, AND SYSTEM**

(57)   This application provides an interleaving and modulation method, an apparatus, and a system, to improve transmission reliability. The method includes: A transmitting apparatus obtains to-be-interleaved bits, performs first interleaving on the to-be-interleaved bits, to obtain interleaved bits, performs modulation on the interleaved bits to obtain modulation symbols, and sends the modulation symbols. After receiving the modulation symbols, a receiving apparatus performs demodulation and deinterleaving on the modulation symbols in a demodulation mode and a deinterleaving mode that are corresponding to the transmitting end, to obtain an LLR, and determines an information bit based on the LLR. The first interleaving includes: writing the to-be-interleaved bits onto a first matrix column by column in a first order, and reading the to-be-interleaved bits from the first matrix row by row in a second order. A quantity of columns of the first matrix is a modulation order M, and M is greater than or equal to 3. A first bit read row by row is an MSB, and an $M^{th}$ bit read row by row is an LSB. In an implementation when M is equal to 3, the first order is the third column to the second column to the first column, and the second order is the first column to the second column to the third column.

FIG. 14

## Description

This application claims priority to Chinese Patent Application No. 202111473306.5, filed with the China National Intellectual Property Administration on December 2, 2021 and entitled "INTERLEAVING AND MODULATION METHOD, APPARATUS, AND SYSTEM", which is incorporated herein by reference in its entirety.

## TECHNICAL FIELD

Embodiments of this application relate to the communication field, and in particular, to an interleaving and modulation method, an apparatus, and a system.

## BACKGROUND

Future wireless communication networks need to provide wider service coverage while meeting service requirements of various industries. However, a coverage capability of a conventional terrestrial mobile communication network is limited, and cannot meet a requirement of people for obtaining information at any time and any place. In addition, it is very challenging to provide ultra-wide coverage in a current base station-based coverage mode in terms of costs and feasibility in scenarios such as a remote area, a desert, an ocean, and the air.

Compared with the conventional terrestrial mobile communication network, satellite communication has the following advantages: global coverage, long-distance transmission, flexible networking, easy deployment, and no geographical location restriction, which can be used as an effective supplement to the conventional network.

At present, in order to integrate a satellite communication technology with terrestrial communication to achieve better effect, research institutes and standards organizations are studying adaptation of a new radio (new radio, NR) protocol to satellite communication. However, when an interleaving manner of NR is adapted to phase shift keying (phase shift keying, PSK) or amplitude phase shift keying (amplitude phase shift keying, APSK) modulation supported by a satellite device, transmission reliability is low.

## SUMMARY

This application provides an interleaving and modulation method, an apparatus, and a system, to improve transmission reliability, thereby improving decoding performance of a receiving end.

According to a first aspect, an interleaving and modulation method is provided. The method may be performed by a transmitting apparatus, or may be performed by a component of the transmitting apparatus, for example, a processor, a chip, or a chip system of the transmitting apparatus, or may be implemented by a logical module or software that can implement all or some functions of the transmitting apparatus. The method includes: obtaining to-be-interleaved bits; performing first interleaving on the to-be-interleaved bits, to obtain interleaved bits; performing modulation on the interleaved bits to obtain modulation symbols; and sending the modulation symbols. The first interleaving includes: writing the to-be-interleaved bits onto a first matrix column by column in a first order, and reading the to-be-interleaved bits from the first matrix row by row in a second order. A quantity of columns of the first matrix is a modulation order M, and M is greater than or equal to 3. A first bit read row by row is a most significant bit (MSB), and an $M^{th}$ bit read row by row is a least significant bit (LSB).

In a possible design, when M is equal to 3, a mode used for the modulation is digital video broadcasting-satellite second generation DVB-S2 8 phase shift keying PSK.

The first order is the third column to the second column to the first column of the first matrix, and the second order is the first column to the second column to the third column of the first matrix.

Alternatively, the first order is the second column to the third column to the first column of the first matrix, and the second order is the first column to the second column to the third column of the first matrix.

Alternatively, the first order is the first column to the second column to the third column of the first matrix, and the second order is the second column to the third column to the first column of the first matrix.

Based on this solution, this application proposes a new interleaving manner. When the interleaving manner is used in combination with a modulation type in satellite communication, a system bit may be mapped to a bit with high reliability for transmission, thereby improving transmission reliability and system decoding performance. For example, when M is equal to 3, based on the interleaving solution, the system bit may be mapped to a bit 0 for transmission. However, in DVB-S2 8PSK modulation, the bit 0 has higher reliability than a bit 2. Therefore, when the system bit is transmitted at the bit 0, transmission reliability of the system bit can be improved, thereby improving system decoding performance.

In a possible design, when M is equal to 4, a mode used for the modulation is DVB-S2 16 amplitude phase shift keying APSK. The second order is the first column to the second column to the third column to the fourth column of the first matrix.

The first order is the fourth column to the third column to the second column to the first column of the first matrix.

Alternatively, the first order is the fourth column to the third column to the first column to the second column of the first matrix.

Alternatively, the first order is the third column to the fourth column to the second column to the first column of the first matrix.

Alternatively, the first order is the third column to the fourth column to the first column to the second column of the first matrix.

Based on this possible design, the system bit may be mapped to the bit 0 or a bit 1 for transmission. In DVB-S2 16APSK modulation, the bit 0 and the bit 1 have higher reliability than a bit 3. Therefore, when the system bit is transmitted at the bit 0 or the bit 1, transmission reliability and decoding performance of the system bit can be improved.

In a possible design, when M is equal to 5, a mode used for the modulation is DVB-S2 32APSK. The second order is the first column to the second column to the third column to the fourth column to the fifth column of the first matrix.

The first order is the fourth column to the third column to the second column to the first column to the fifth column of the first matrix.

Alternatively, the first order is the fourth column to the second column to the third column to the first column to the fifth column of the first matrix.

Alternatively, the first order is the fourth column to the third column to the second column to the fifth column to the first column of the first matrix.

Alternatively, the first order is the fourth column to the second column to the third column to the fifth column to the first column of the first matrix.

Based on this possible design, the system bit may be mapped to the bit 1 for transmission. In DVB-S2 32APSK modulation, the bit 1 has higher reliability than a bit 4. Therefore, when the system bit is transmitted at the bit 1, transmission reliability and decoding performance of the system bit can be improved.

According to a second aspect, an interleaving and modulation method is provided. The method may be performed by a transmitting apparatus, or may be performed by a component of the transmitting apparatus, for example, a processor, a chip, or a chip system of the transmitting apparatus, or may be implemented by a logical module or software that can implement all or some functions of the transmitting apparatus. The method includes: obtaining to-be-interleaved bits; performing first interleaving on the to-be-interleaved bits, to obtain interleaved bits; performing modulation on the interleaved bits to obtain modulation symbols; and sending the modulation symbols. The first interleaving includes: writing the to-be-interleaved bits onto a first matrix column by column from left to right, and reading the to-be-interleaved bits from the first matrix row by row from left to right. A quantity of columns of the first matrix is a modulation order M, and M is greater than or equal to 3. A first bit read row by row is a most significant bit (MSB), and an $M^{th}$ bit read row by row is a least significant bit (LSB). A constellation diagram used for the modulation includes $2^M$ constellation points, the $2^M$ constellation points are distributed on N rings, a constellation point on at least one of the N rings meets a Gray mapping principle, and N is a positive integer.

Based on this solution, this application proposes a new constellation diagram. When the constellation diagram is used in combination with an interleaving manner in NR, system bit transmission reliability can be improved, thereby improving system decoding performance.

In a possible design, when M is equal to 3, eight constellation points are evenly distributed on one ring. A phase corresponding to a first constellation point is $\pi / 4$ or $\pi / 8$, bits corresponding to the first constellation point are 000, and by using the first constellation point as a reference, bits corresponding to the remaining seven constellation points in a clockwise direction are respectively 010, 011, 111, 110, 100, 101, and 001, or are respectively 100, 101, 111, 110, 010, 011, and 001.

Based on this possible design, when the modulation order M is equal to 3, system bit transmission reliability can be improved, thereby improving system decoding performance.

In a possible design, when M is equal to 4, four constellation points of 16 constellation points are evenly distributed on a first ring, the other 12 constellation points are evenly distributed on a second ring, the first ring and the second ring are concentric rings, and phases corresponding to the first constellation point on the first ring and a second constellation point on the second ring are $\pi / 4$.

Bits corresponding to the first constellation point are 0011, and by using the first constellation point as a reference, bits corresponding to the remaining three constellation points on the first ring in a clockwise direction are respectively 0111, 1111, and 1011.

Bits corresponding to the second constellation point are 0000, and by using the second constellation point as a reference, bits corresponding to the remaining 11 constellation points on the second ring in a clockwise direction are respectively 0001, 0101, 0100, 0110, 1110, 1100, 1101, 1001, 1000, 1010 and 0010.

Alternatively, bits corresponding to the first constellation point are 0011, and by using the first constellation point as a reference, bits corresponding to the remaining three constellation points on the first ring in a clockwise direction are respectively 0111, 1111, and 1011.

Bits corresponding to the second constellation point are 0000, and by using the second constellation point as a reference, bits corresponding to the remaining 11 constellation points on the second ring in a clockwise direction are respectively 0010, 0110, 0100, 0101, 1101, 1100, 1110, 1010, 1000, 1001 and 0001.

Alternatively, bits corresponding to the first constellation point are 0011, and by using the first constellation point as a reference, bits corresponding to the remaining three constellation points on the first ring in a clockwise direction are respectively 1011, 1111, and 0111.

Bits corresponding to the second constellation point are 0000, and by using the second constellation point as a reference, bits corresponding to the remaining 11 constellation points on the second ring in a clockwise direction are respectively 0001, 1001, 1000, 1010, 1110, 1100, 1101, 0101, 0100, 0110 and 0010.

Alternatively, bits corresponding to the first constellation point are 0011, and by using the first constellation point as a reference, bits corresponding to the remaining three constellation points on the first ring in a clockwise direction are respectively 1011, 1111, and 0111.

Bits corresponding to the second constellation point are 0000, and by using the second constellation point as a reference, bits corresponding to the remaining 11 constellation points on the second ring in a clockwise direction are respectively 0010, 1010, 1000, 1001, 1101, 1100, 1110, 0110, 0100, 0101 and 0001.

Based on this possible design, when the modulation order M is equal to 4, system bit transmission reliability can be improved, thereby improving system decoding performance.

In a possible design, when M is equal to 5, four constellation points of 32 constellation points are evenly distributed on the first ring, other 12 constellation points are evenly distributed on the second ring, the remaining 16 constellation points are evenly distributed on a third ring, the first ring, the second ring, and the third ring are concentric rings; and phases corresponding to the first constellation point on the first ring, the second constellation point on the second ring, and a third constellation point on the third ring are $\pi / 4$.

Bits corresponding to the first constellation point are 00011, and by using the first constellation point as a reference, bits corresponding to the remaining three constellation points on the first ring in a clockwise direction are respectively 00111, 01111, and 01011.

Bits corresponding to the second constellation point are 00000, and by using the second constellation point as a reference, bits corresponding to the remaining 11 constellation points on the second ring in a clockwise direction are respectively 00001, 00101, 00100, 00110, 01110, 01100, 01101, 01001, 01000, 01010 and 00010.

Bits corresponding to the third constellation point are 10011, and by using the third constellation point as a reference, bits corresponding to the remaining 15 constellation points on the third ring in a clockwise direction are respectively 10000, 10001, 10101, 10100, 10111, 10110, 11110, 11111, 11100, 11101, 11001, 11000, 11011, 11010 and 10010.

Alternatively, bits corresponding to the first constellation point are 00101, and by using the first constellation point as a reference, bits corresponding to the remaining three constellation points on the first ring in a clockwise direction are respectively 00111, 01111, and 01101.

Bits corresponding to the second constellation point are 00000, and by using the second constellation point as a reference, bits corresponding to the remaining 11 constellation points on the second ring in a clockwise direction are respectively 00001, 00011, 00010, 00110, 01110, 01010, 01011, 01001, 01000, 01100 and 00100.

Bits corresponding to the third constellation point are 10101, and by using the third constellation point as a reference, bits corresponding to the remaining 15 constellation points on the third ring in a clockwise direction are respectively 10000, 10001, 10011, 10010, 10111, 10110, 11110, 11111, 11010, 11011, 11001, 11000, 11101, 11100 and 10100.

Alternatively, bits corresponding to the first constellation point are 10010, and by using the first constellation point as a reference, bits corresponding to the remaining three constellation points on the first ring in a clockwise direction are respectively 10110, 11110, and 11010.

Bits corresponding to the second constellation point are 00000, and by using the second constellation point as a reference, bits corresponding to the remaining 11 constellation points on the second ring in a clockwise direction are respectively 10000, 10100, 00100, 00110, 01110, 01100, 11100, 11000, 01000, 01010 and 00010.

Bits corresponding to the third constellation point are 10011, and by using the third constellation point as a reference, bits corresponding to the remaining 15 constellation points on the third ring in a clockwise direction are respectively 00001, 10001, 10101, 00101, 10111, 00111, 01111, 11111, 01101, 11101, 11001, 01001, 11011, 01011 and 00011.

Alternatively, bits corresponding to the first constellation point are 10100, and by using the first constellation point as a reference, bits corresponding to the remaining three constellation points on the first ring in a clockwise direction are respectively 10110, 11110, and 11100.

Bits corresponding to the second constellation point are 00000, and by using the second constellation point as a reference, bits corresponding to the remaining 11 constellation points on the second ring in a clockwise direction are respectively 10000, 10010, 00010, 00110, 01110, 01010, 11010, 11000, 01000, 01100 and 00100.

Bits corresponding to the third constellation point are 10101, and by using the third constellation point as a reference, bits corresponding to the remaining 15 constellation points on the third ring in a clockwise direction are respectively 00001, 10001, 10011, 00011, 10111, 00111, 01111, 11111, 01011, 11011, 11001, 01001, 11101, 01101 and 00101.

Based on this possible design, when the modulation order M is equal to 5, system bit transmission reliability can be improved, thereby improving system decoding performance.

With reference to the first aspect or the second aspect, in a possible design, the to-be-interleaved bits are coded bits, or the to-be-interleaved bits are bits obtained after second interleaving is performed on coded bits.

With reference to the first aspect or the second aspect, in a possible design, the second interleaving includes: performing random or pseudo-random interleaving on the last N-X bits of the coded bits, where X is greater than or equal to a quantity of system bits, and N is a quantity of the coded bits.

Based on this possible design, when the to-be-interleaved bits are the bits obtained after the second interleaving is performed on the coded bits, it is equivalent to that the transmitting apparatus performs interleaving twice, so that a fluctuation range of a mapping probability of a constellation point can be reduced, and decoding performance can be improved.

According to a third aspect, a deinterleaving and demodulation method is provided. The method may be performed by a receiving apparatus, or may be performed by a component of the receiving apparatus, for example, a processor, a chip, or a chip system of the receiving apparatus, or may be implemented by a logical module or software that can implement all or some functions of the receiving apparatus. The method includes: receiving a modulation symbol; performing demodulation on the modulation symbol to obtain a to-be-deinterleaved log-likelihood ratio LLR sequence; performing first deinterleaving on the to-be-deinterleaved LLR sequence to obtain a first deinterleaved LLR sequence; and determining an information bit based on the first deinterleaved LLR sequence. The first deinterleaving includes: writing the to-be-deinterleaved LLR sequence onto a second matrix row by row in a second order, and reading the to-be-deinterleaved LLR sequence from the second matrix column by column in a first order. A quantity of columns of the second matrix is a modulation order M, and M is greater than or equal to 3. A first bit written row by row is a most significant bit MSB, and an $M^{th}$ bit written row by row is a least significant bit LSB.

In a possible design, when M is equal to 3, a modulation type corresponding to the demodulation is digital video broadcasting-satellite second generation DVB-S2 8 phase shift keying PSK.

The first order is the third column to the second column to the first column of the second matrix, and the second order is the first column to the second column to the third column of the second matrix.

Alternatively, the first order is the second column to the third column to the first column of the second matrix, and the second order is the first column to the second column to the third column of the second matrix.

Alternatively, the first order is the first column to the second column to the third column of the second matrix, and the second order is the second column to the third column to the first column of the second matrix.

In a possible design, when M is equal to 4, a modulation type corresponding to the demodulation is DVB-S2 16 amplitude phase shift keying APSK; and the second order is the first column to the second column to the third column to the fourth column of the second matrix.

The first order is the fourth column to the third column to the second column to the first column of the second matrix.

Alternatively, the first order is the fourth column to the third column to the first column to the second column of the second matrix.

Alternatively, the first order is the third column to the fourth column to the second column to the first column of the second matrix.

Alternatively, the first order is the third column to the fourth column to the first column to the second column of the second matrix.

In a possible design, when M is equal to 5, a modulation type corresponding to the demodulation is DVB-S2 32APSK; and the second order is the first column to the second column to the third column to the fourth column to the fifth column of the second matrix.

The first order is the fourth column to the third column to the second column to the first column to the fifth column of the second matrix.

Alternatively, the first order is the fourth column to the second column to the third column to the first column to the fifth column of the second matrix.

Alternatively, the first order is the fourth column to the third column to the second column to the fifth column to the first column of the second matrix.

Alternatively, the first order is the fourth column to the second column to the third column to the fifth column to the first column of the second matrix.

For a technical effect brought by the third aspect or the possible designs of the third aspect, refer to the technical effect brought by the first aspect or the corresponding design of the first aspect. Details are not described herein again.

According to a fourth aspect, a deinterleaving and demodulation method is provided. The method may be performed by a receiving apparatus, or may be performed by a component of the receiving apparatus, for example, a processor, a chip, or a chip system of the receiving apparatus, or may be implemented by a logical module or software that can implement all or some functions of the receiving apparatus. The method includes: receiving a modulation symbol; performing demodulation on the modulation symbol to obtain a to-be-deinterleaved log-likelihood ratio LLR sequence; performing first deinterleaving on the to-be-deinterleaved LLR sequence to obtain a first deinterleaved LLR sequence; and determining an information bit based on the first deinterleaved LLR sequence. The first deinterleaving includes: writing the to-be-deinterleaved LLR sequence onto a second matrix row by row from left to right, and reading the to-be-deinterleaved LLR sequence from the second matrix column by column from left to right. A quantity of columns of the second matrix is a modulation order M, and M is greater than or equal to 3. A first bit written row by row is a most significant bit MSB, and an $M^{th}$ bit written row by row is a least significant bit LSB. A constellation diagram used for the demodulation includes $2^M$ constellation points, the $2^M$ constellation points are distributed on N rings, a constellation point on at least one of the N rings meets a Gray mapping principle, and N is a positive integer.

In a possible design, when M is equal to 3, eight constellation points are evenly distributed on one ring. A phase corresponding to a first constellation point is $\pi / 4$ or $\pi / 8$, bits corresponding to the first constellation point are 000, and by using the first constellation point as a reference, bits corresponding to the remaining seven constellation points in a clockwise direction are respectively 010, 011, 111, 110, 100, 101, and 001, or are respectively 100, 101, 111, 110, 010, 011, and 001.

In a possible design, when M is equal to 4, four constellation points of 16 constellation points are evenly distributed on a first ring, the other 12 constellation points are evenly distributed on a second ring, the first ring and the second ring are concentric rings, and phases corresponding to the first constellation point on the first ring and a second constellation point on the second ring are $\pi / 4$.

Bits corresponding to the first constellation point are 0011, and by using the first constellation point as a reference, bits corresponding to the remaining three constellation points on the first ring in a clockwise direction are respectively 0111, 1111, and 1011.

Bits corresponding to the second constellation point are 0000, and by using the second constellation point as a reference, bits corresponding to the remaining 11 constellation points on the second ring in a clockwise direction are respectively 0001, 0101, 0100, 0110, 1110, 1100, 1101, 1001, 1000, 1010 and 0010.

Alternatively, bits corresponding to the first constellation point are 0011, and by using the first constellation point as a reference, bits corresponding to the remaining three constellation points on the first ring in a clockwise direction are respectively 0111, 1111, and 1011.

Bits corresponding to the second constellation point are 0000, and by using the second constellation point as a reference, bits corresponding to the remaining 11 constellation points on the second ring in a clockwise direction are respectively 0010, 0110, 0100, 0101, 1101, 1100, 1110, 1010, 1000, 1001 and 0001.

Alternatively, bits corresponding to the first constellation point are 0011, and by using the first constellation point as a reference, bits corresponding to the remaining three constellation points on the first ring in a clockwise direction are respectively 1011, 1111, and 0111.

Bits corresponding to the second constellation point are 0000, and by using the second constellation point as a reference, bits corresponding to the remaining 11 constellation points on the second ring in a clockwise direction are respectively 0001, 1001, 1000, 1010, 1110, 1100, 1101, 0101, 0100, 0110 and 0010.

Alternatively, bits corresponding to the first constellation point are 0011, and by using the first constellation point as a reference, bits corresponding to the remaining three constellation points on the first ring in a clockwise direction are respectively 1011, 1111, and 0111.

Bits corresponding to the second constellation point are 0000, and by using the second constellation point as a reference, bits corresponding to the remaining 11 constellation points on the second ring in a clockwise direction are respectively 0010, 1010, 1000, 1001, 1101, 1100, 1110, 0110, 0100, 0101 and 0001.

In a possible design, when M is equal to 5, four constellation points of 32 constellation points are evenly distributed on the first ring, other 12 constellation points are evenly distributed on the second ring, the remaining 16 constellation points are evenly distributed on a third ring, the first ring, the second ring, and the third ring are concentric rings; and phases corresponding to the first constellation point on the first ring, the second constellation point on the second ring, and a third constellation point on the third ring are $\pi / 4$.

Bits corresponding to the first constellation point are 00011, and by using the first constellation point as a reference, bits corresponding to the remaining three constellation points on the first ring in a clockwise direction are respectively 00111, 01111, and 01011.

Bits corresponding to the second constellation point are 00000, and by using the second constellation point as a reference, bits corresponding to the remaining 11 constellation points on the second ring in a clockwise direction are respectively 00001, 00101, 00100, 00110, 01110, 01100, 01101, 01001, 01000, 01010 and 00010.

Bits corresponding to the third constellation point are 10011, and by using the third constellation point as a reference, bits corresponding to the remaining 15 constellation points on the third ring in a clockwise direction are respectively 10000, 10001, 10101, 10100, 10111, 10110, 11110, 11111, 11100, 11101, 11001, 11000, 11011, 11010 and 10010.

Alternatively, bits corresponding to the first constellation point are 00101, and by using the first constellation point as a reference, bits corresponding to the remaining three constellation points on the first ring in a clockwise direction are respectively 00111, 01111, and 01101.

Bits corresponding to the second constellation point are 00000, and by using the second constellation point as a reference, bits corresponding to the remaining 11 constellation points on the second ring in a clockwise direction are respectively 00001, 00011, 00010, 00110, 01110, 01010, 01011, 01001, 01000, 01100 and 00100.

Bits corresponding to the third constellation point are 10101, and by using the third constellation point as a reference, bits corresponding to the remaining 15 constellation points on the third ring in a clockwise direction are respectively 10000, 10001, 10011, 10010, 10111, 10110, 11110, 11111, 11010, 11011, 11001, 11000, 11101, 11100 and 10100.

Alternatively, bits corresponding to the first constellation point are 10010, and by using the first constellation point as a reference, bits corresponding to the remaining three constellation points on the first ring in a clockwise direction are respectively 10110, 11110, and 11010.

Bits corresponding to the second constellation point are 00000, and by using the second constellation point as a reference, bits corresponding to the remaining 11 constellation points on the second ring in a clockwise direction are respectively 10000, 10100, 00100, 00110, 01110, 01100, 11100, 11000, 01000, 01010 and 00010.

Bits corresponding to the third constellation point are 10011, and by using the third constellation point as a reference, bits corresponding to the remaining 15 constellation points on the third ring in a clockwise direction are respectively 00001, 10001, 10101, 00101, 10111, 00111, 01111, 11111, 01101, 11101, 11001, 01001, 11011, 01011 and 00011.

Alternatively, bits corresponding to the first constellation point are 10100, and by using the first constellation point as a reference, bits corresponding to the remaining three constellation points on the first ring in a clockwise direction are respectively 10110, 11110, and 11100.

Bits corresponding to the second constellation point are 00000, and by using the second constellation point as a reference, bits corresponding to the remaining 11 constellation points on the second ring in a clockwise direction are respectively 10000, 10010, 00010, 00110, 01110, 01010, 11010, 11000, 01000, 01100 and 00100.

Bits corresponding to the third constellation point are 10101, and by using the third constellation point as a reference, bits corresponding to the remaining 15 constellation points on the third ring in a clockwise direction are respectively 00001, 10001, 10011, 00011, 10111, 00111, 01111, 11111, 01011, 11011, 11001, 01001, 11101, 01101 and 00101.

With reference to the third aspect or the fourth aspect, in a possible design, the determining an information bit based on the first deinterleaved LLR sequence includes: decoding the first deinterleaved LLR sequence, to obtain the information bit.

With reference to the third aspect or the fourth aspect, in a possible design, the determining an information bit based on the first deinterleaved LLR sequence includes: performing second deinterleaving on the first deinterleaved LLR sequence, to obtain a second deinterleaved LLR sequence; and decoding the second deinterleaved LLR sequence, to obtain the information bit.

With reference to the third aspect or the fourth aspect, in a possible design, the second deinterleaving includes: performing deinterleaving on the last N-X elements of the first LLR sequence in a preset order, where N is a quantity of information bits, and X is greater than or equal to a quantity of system bits.

For a technical effect brought by the fourth aspect or the possible designs of the fourth aspect, refer to the technical effect brought by the second aspect or the corresponding design of the second aspect. Details are not described herein again.

According to a fifth aspect, a communication apparatus is provided to implement the foregoing methods. The communication apparatus may be the transmitting apparatus in the first aspect or the second aspect, or a device including the transmitting apparatus, or an apparatus included in the transmitting apparatus, such as a chip; or the communication apparatus may be the receiving apparatus in the third aspect or the fourth aspect, or a device including the receiving apparatus, or an apparatus included in the receiving apparatus, such as a chip. The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In a possible design, the communication apparatus may include a transceiver module and a processing module. The transceiver module may also be referred to as a transceiver unit, and is configured to implement a sending function and/or a receiving function in any one of the foregoing aspects and any one of the possible implementations of the foregoing aspects. The transceiver module may include a transceiver circuit, a transceiver machine, a transceiver, or a communication interface. The processing module may be configured to implement a processing function in any one of the foregoing aspects and any one of the possible implementations of the foregoing aspects.

In some possible designs, the transceiver module includes a sending module and a receiving module, respectively configured to implement the sending function and the receiving function in any one of the foregoing aspects and any one of the possible implementations of the foregoing aspects.

According to a sixth aspect, a communication apparatus is provided, including a processor and a memory. The memory is configured to store computer instructions, and when the processor executes the instructions, the communication apparatus performs the method in any one of the foregoing aspects. The communication apparatus may be the transmitting apparatus in the first aspect or the second aspect, or a device including the transmitting apparatus, or an apparatus included in the transmitting apparatus, such as a chip; or the communication apparatus may be the receiving apparatus in the third aspect or the fourth aspect, or a device including the receiving apparatus, or an apparatus included in the receiving apparatus, such as a chip.

According to a seventh aspect, a communication apparatus is provided, including a processor and a communication interface. The communication interface is configured to communicate with a module outside the communication apparatus. The processor is configured to execute a computer program or instructions, to enable the communication apparatus to perform the method in any one of the foregoing aspects. The communication apparatus may be the transmitting apparatus in the first aspect or the second aspect, or a device including the transmitting apparatus, or an apparatus included in the transmitting apparatus, such as a chip; or the communication apparatus may be the receiving apparatus in the third aspect or the fourth aspect, or a device including the receiving apparatus, or an apparatus included in the receiving apparatus, such as a chip.

According to an eighth aspect, a communication apparatus is provided, including a logic circuit and an interface circuit. The interface circuit is configured to input and/or output information. The logic circuit is configured to: perform the method in any one of the foregoing aspects, to generate information output by the interface circuit, and/or to process information input by the interface circuit. The communication apparatus may be the transmitting apparatus in the first aspect or the second aspect, or a device including the transmitting apparatus, or an apparatus included in the transmitting apparatus, such as a chip; or the communication apparatus may be the receiving apparatus in the third aspect or the fourth aspect, or a device including the receiving apparatus, or an apparatus included in the receiving apparatus, such as a chip.

With reference to the eighth aspect, in a possible design, when the communication apparatus is configured to implement a function of the foregoing transmitting apparatus, output information is a modulation symbol.

With reference to the eighth aspect, in a possible design, when the communication apparatus is configured to implement a function of the foregoing receiving apparatus, input information is a modulation symbol. Processing the input information includes: performing demodulation on the modulation symbol to obtain a to-be-deinterleaved log-likelihood ratio (LLR) sequence; performing first deinterleaving on the to-be-deinterleaved LLR sequence to obtain a first deinterleaved LLR sequence; and determining an information bit based on the first deinterleaved LLR sequence.

According to a ninth aspect, a communication apparatus is provided, including an interface circuit and a processor. The interface circuit may be a code/data read and write interface circuit. The interface circuit is configured to receive computer-executable instructions (the computer-executable instructions are stored in a memory, may be read directly from the memory, or may pass through another device) and transmit the computer-executable instructions to the processor. The processor is configured to run the computer-executable instructions to enable the communication apparatus to perform the method in any one of the foregoing aspects. The communication apparatus may be the transmitting apparatus in the first aspect or the second aspect, or a device including the transmitting apparatus, or an apparatus included in the transmitting apparatus, such as a chip; or the communication apparatus may be the receiving apparatus in the third aspect or the fourth aspect, or a device including the receiving apparatus, or an apparatus included in the receiving apparatus, such as a chip.

According to a tenth aspect, a communication apparatus is provided, including at least one processor. The processor is configured to execute a computer program or instructions, to enable the communication apparatus to perform the method in any one of the foregoing aspects. The communication apparatus may be the transmitting apparatus in the first aspect or the second aspect, or a device including the transmitting apparatus, or an apparatus included in the transmitting apparatus, such as a chip; or the communication apparatus may be the receiving apparatus in the third aspect or the fourth aspect, or a device including the receiving apparatus, or an apparatus included in the receiving apparatus, such as a chip.

In a possible design, the communication apparatus further includes a memory. The memory is configured to store necessary program instructions and data. The memory may be coupled to the processor, or may be independent of the processor.

In a possible design, the communication apparatus may be a chip or a chip system. When the apparatus is the chip system, the apparatus may include a chip, or may include a chip and another discrete device.

According to an eleventh aspect, a computer-readable storage medium is provided. The computer-readable storage medium stores instructions, and when the instructions are run on a communication apparatus, the communication apparatus is enabled to perform the method in any one of the foregoing aspects.

According to a twelfth aspect, a computer program product including instruction is provided. When the computer program product runs on a communication apparatus, the communication apparatus is enabled to perform the method in any one of the foregoing aspects.

It can be understood that when the communication apparatus provided in any one of the fifth aspect to the twelfth aspect is a chip, the foregoing sending action/function can be understood as output, and the foregoing receiving action/function can be understood as input.

For technical effects brought by any one of design manners in the fifth aspect to the twelfth aspect, refer to technical effects brought by different design manners in the first aspect, the second aspect, the third aspect, or the fourth aspect. Details are not described herein again.

According to a thirteenth aspect, a communication system is provided. The communication system includes the transmitting apparatus and the receiving apparatus in the foregoing aspects.

## BRIEF DESCRIPTION OF DRAWINGS

FIG. 1 is a DVB-S2 8PSK constellation diagram according to this application;
FIG. 2 is a DVB-S2 16APSK constellation diagram according to this application;
FIG. 3 is a DVB-S2 32APSK constellation diagram according to this application;
FIG. 4 is a bit reliability simulation diagram of DVB-S2 8PSK according to this application;
FIG. 5 is a bit reliability simulation diagram of DVB-S2 16APSK according to this application;
FIG. 6 is a bit reliability simulation diagram of DVB-S2 32APSK according to this application;
FIG. 7 is a diagram of data processing of an NR transmitting end according to this application;
FIG. 8 is a diagram of an interleaving manner of an NR transmitting end according to this application;
FIG. 9 is a diagram of a deinterleaving manner of an NR receiving end according to this application;
FIG. 10 is a diagram of LDPC coded bit interleaving according to this application;
FIG. 11 is a schematic of a structure of a communication system according to this application;
FIG. 12 is a schematic of a structure of another communication system according to this application;
FIG. 13 is a schematic of structures of a terminal device and a network device according to this application;
FIG. 14 is a schematic flowchart of an interleaving and modulation method according to this application;
FIG. 15 is a diagram of an interleaving manner when a modulation order is equal to 3 according to this application;
FIG. 16a is a simulation diagram of BLER performance in different interleaving manners when a modulation order is equal to 3 according to this application;
FIG. 16b is a diagram of another interleaving manner when a modulation order is equal to 3 according to this application;
FIG. 17 is a diagram of another interleaving manner when a modulation order is equal to 3 according to this application;
FIG. 18 is a diagram of another interleaving manner when a modulation order is equal to 3 according to this application;
FIG. 19 is a diagram of an interleaving manner when a modulation order is equal to 4 according to this application;
FIG. 20 is a simulation diagram of BLER performance in different interleaving manners when a modulation order is equal to 4 according to this application;
FIG. 21 is a diagram of another interleaving manner when a modulation order is equal to 4 according to this application;
FIG. 22 is a diagram of another interleaving manner when a modulation order is equal to 4 according to this application;
FIG. 23 is a diagram of another interleaving manner when a modulation order is equal to 4 according to this application;
FIG. 24 is a diagram of an interleaving manner when a modulation order is equal to 5 according to this application;
FIG. 25 is a simulation diagram of BLER performance in different interleaving manners when a modulation order is equal to 5 according to this application;
FIG. 26 is a diagram of another interleaving manner when a modulation order is equal to 5 according to this application;
FIG. 27 is a diagram of another interleaving manner when a modulation order is equal to 5 according to this application;
FIG. 28 is a diagram of another interleaving manner when a modulation order is equal to 5 according to this application;
FIG. 29 is a schematic flowchart of another interleaving and modulation method according to this application;
FIG. 30 is a constellation diagram when a modulation order is equal to 3 according to this application;
FIG. 31 is a simulation diagram of BLER performance of different constellation diagrams when a modulation order is equal to 3 according to this application;
FIG. 32 is another constellation diagram when a modulation order is equal to 3 according to this application;
FIG. 33 is another constellation diagram when a modulation order is equal to 3 according to this application;

FIG. 34 is another constellation diagram when a modulation order is equal to 3 according to this application;
FIG. 35 is a constellation diagram when a modulation order is equal to 4 according to this application;
FIG. 36 is another constellation diagram when a modulation order is equal to 4 according to this application;
FIG. 37 is another constellation diagram when a modulation order is equal to 4 according to this application;
FIG. 38 is another constellation diagram when a modulation order is equal to 4 according to this application;
FIG. 39 is a constellation diagram when a modulation order is equal to 5 according to this application;
FIG. 40 is another constellation diagram when a modulation order is equal to 5 according to this application;
FIG. 41 is another constellation diagram when a modulation order is equal to 5 according to this application;
FIG. 42 is another constellation diagram when a modulation order is equal to 5 according to this application;
FIG. 43 is a diagram of a two-level interleaving manner according to this application;
FIG. 44 is a diagram of another two-level interleaving manner according to this application;
FIG. 45 is a simulation diagram of BLER performance in a two-level interleaving manner when a modulation order is equal to 5 according to this application;
FIG. 46 is another simulation diagram of BLER performance in a two-level interleaving manner when a modulation order is equal to 5 according to this application;
FIG. 47 is another simulation diagram of BLER performance in a two-level interleaving manner when a modulation order is equal to 5 according to this application;
FIG. 48 is a schematic of a structure of a transmitting apparatus according to this application; and
FIG. 49 is a schematic of a structure of a receiving apparatus according to this application.

## DESCRIPTION OF EMBODIMENTS

In descriptions of this application, "/" represents an "or" relationship between associated objects unless otherwise specified. For example, A/B may represent A or B. In this application, "and/or" describes only an association relationship for describing associated objects and represents that three relationships may exist. For example, A and/or B may represent the following three cases: Only A exists, both A and B exist, and only B exists, where A and B may be singular or plural.

In addition, in the descriptions of this application, "a plurality of" means two or more than two unless otherwise specified. "At least one of the following items (pieces)" or a similar expression thereof refers to any combination of these items, including any combination of singular items (pieces) or plural items (pieces). For example, at least one of a, b, or c may represent a, b, c, a and b, a and c, b and c, or a, b, and c, where a, b, and c may be singular or plural.

In addition, to clearly describe the technical solutions in embodiments of this application, terms such as first and second are used in embodiments of this application to distinguish between same items or similar items that provide basically same functions or purposes. A person skilled in the art may understand that the words such as "first" and "second" do not limit a quantity or an execution sequence, and the words such as "first" and "second" do not indicate a definite difference.

In embodiments of this application, the term "example", "for example", or the like is used to represent giving an example, an illustration, or a description. Any embodiment or design scheme described by "example" or "for example" in embodiments of this application should not be construed as being more preferred or advantageous than another embodiment or design. Exactly, use of the terms such as "example" or "for example" are intended to present a related concept in a specific manner for ease of understanding.

It may be understood that "an embodiment" mentioned in the entire specification means that particular features, structures, or characteristics related to the embodiment are included in at least one embodiment of this application. Therefore, embodiments in the entire specification do not necessarily refer to a same embodiment. In addition, these particular features, structures, or characteristics may be combined in one or more embodiments in any appropriate manner. It may be understood that sequence numbers of processes do not mean execution sequences in various embodiments of this application. The execution sequences of the processes should be determined based on functions and internal logic of the processes, and should not be construed as any limitation on implementation processes of embodiments of this application.

It may be understood that, in this application, "when" and "if" mean that corresponding processing is performed in an objective situation, are not intended to limit time, do not require a determining action during implementation, and do not mean any other limitation.

It may be understood that, in some scenarios, some optional features in embodiments of this application may be independently implemented without depending on another feature, for example, a solution on which the optional features are currently based, to resolve a corresponding technical problem and achieve a corresponding effect. Alternatively, in some scenarios, the optional features may be combined with other features based on requirements. Correspondingly, the apparatus provided in embodiments of this application may also correspondingly implement these features or functions. Details are not described herein.

In this application, unless otherwise specified, for identical or similar parts in embodiments, refer to each other. In embodiments of this application and the implementations/implementation methods in embodiments, unless otherwise specified or a logical conflict occurs, terms and/or descriptions are consistent and may be mutually referenced between different embodiments and between the implementations/implementation methods in embodiments. Technical features in the different embodiments and the implementations/implementation methods in embodiments may be combined to form a new embodiment, implementation, or implementation method based on an internal logical relationship thereof. The following implementations of this application are not intended to limit the protection scope of this application.

To facilitate understanding of technical solutions in embodiments of this application, technologies related to this application are first briefly described below.

1. Non-terrestrial network (non-terrestrial network, NTN) communication

The NTN communication includes satellite communication, air to ground (air to ground, ATG) communication, and the like. Based on a height from a platform carrying a base station or a base station function to the ground, an NTN can be classified into a low altitude platform (low altitude platform, LAP) subnetwork (LAP subnetwork), a high altitude platform (high altitude platform, HAP) subnetwork (HAP subnetwork), and a satellite communication subnetwork (SATCOM subnetwork).

In the LAP subnetwork, the base station or the base station function is deployed on a low altitude flight platform 0.1 km to 1 km away from the ground to provide coverage for a terminal device, for example, an uncrewed aerial vehicle. In the HAP subnetwork, the base station or the base station function is deployed on a high altitude flight platform 1 km to 50 km away from the ground to provide coverage for a terminal device, for example, an airplane. In the SATCOM subnetwork, the base station or the base station function is deployed on a satellite more than 50 km away from the ground to provide coverage for a terminal device.

Further, based on different orbital altitudes, satellite communication systems may be classified into the following three types: a geostationary earth orbit (geostationary earth orbit, GEO) satellite communication system, also referred to as a synchronous orbit satellite system; a medium earth orbit (medium earth orbit, MEO) satellite communication system; and a low earth orbit (low earth orbit, LEO) satellite communication system.

A GEO satellite, also known as a geostationary orbit satellite, has an orbital altitude of 35,786 kilometers (km). Main advantages of GEO satellite communication are that the GEO satellite communication is stationary relative to the ground and provides a large coverage area. However, disadvantages of the GEO satellite communication are prominent. For example, (1) a distance between the GEO and the earth is quite large, and an antenna with a large diameter is required; (2) a transmission delay is long and is about 0.5s, which cannot meet a requirement of a real-time service; and (3) rail resources are relatively limited, transmission costs are high, and coverage cannot be provided for polar areas.

An orbital altitude of an MEO satellite is 2,000-35,786 km. In MEO satellite communication, a small quantity of satellites can be used to achieve global coverage, but a transmission delay of the MEO satellite communication is longer than that of LEO satellite communication. The MEO satellite communication is mainly used for positioning and navigation.

An orbital altitude of an LEO satellite ranges from 300-2,000 km. The orbital altitude of the LEO satellite is lower than that of the MEO satellite and the GEO satellite. Therefore, a data transmission delay is shorter, a power loss is smaller, and transmission costs are lower. Therefore, the LEO satellite communication has made great progress in recent years and has attracted much attention.

A conventional satellite communication standard usually uses a communication system of a single carrier plus phase shift keying (phase shift keying, PSK) or amplitude phase shift keying (amplitude phase shift keying, APSK) modulation, and uses a low peak to average power ratio (peak to average power ratio, PAPR) characteristic of a combination of the single carrier plus PSK/APSK to improve power amplification efficiency and transmitting power. For example, in a digital video broadcasting-satellite second generation (digital video broadcasting-satellite second generation, DVB-S2) standard, a communication system of a combination of a single carrier plus 8PSK, 16APSK, or 32APSK modulation is used.

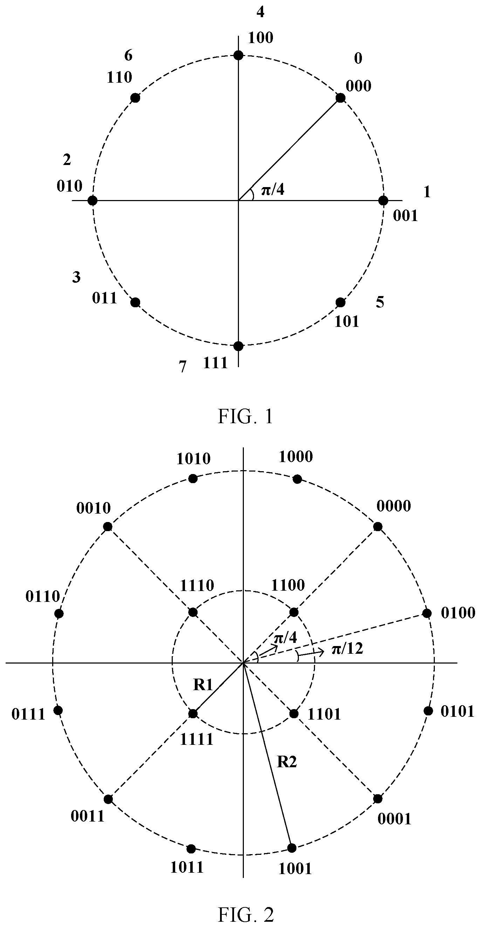

For example, FIG. 1 shows an 8PSK constellation diagram in the current DVB-S2 standard. A black point is a constellation point (or may be described as a symbol), and corresponds to three bits (bits), which may be represented as a bit 2, a bit 1, and a bit 0 in descending order of bits. A projection of a constellation point on the horizontal axis represents a peak amplitude of an in-phase component, and a projection of the constellation point on the vertical axis represents a peak amplitude of an orthogonal component. A length of a line (or referred to as vector) between the constellation point and the original represents a peak amplitude of a signal, and an angle between the line and the horizontal axis represents a phase.

In this application, the constellation diagram may also be referred to as a constellation mapping diagram, and may be replaced with each other. This is not specifically limited in this application.

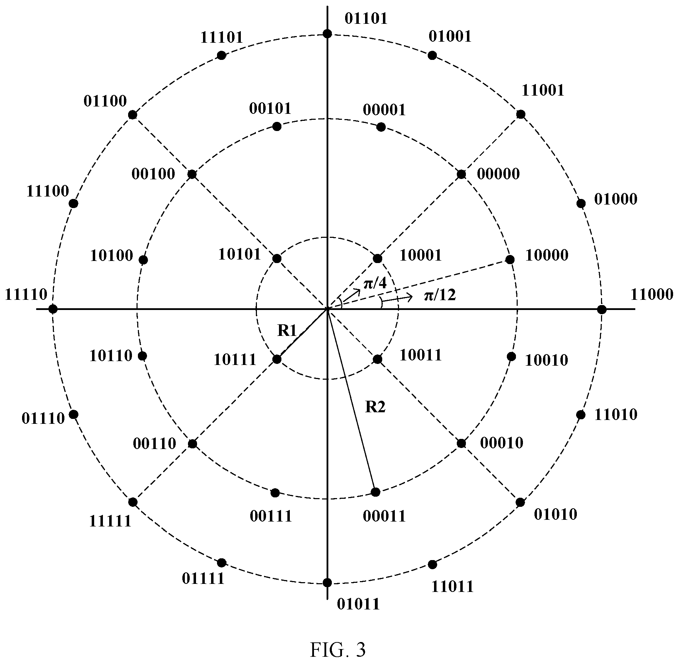

FIG. 2 shows a 16APSK constellation diagram in the DVB-S2 standard. Each constellation point corresponds to four bits, which may be represented as a bit 3, a bit 2, a bit 1, and a bit 0 in descending order of bits. FIG. 3 shows a 32APSK constellation diagram in the DVB-S2 standard. Each constellation point corresponds to five bits, which may be represented as a bit 4, a bit 3, a bit 2, a bit 1, and a bit 0 in descending order of bits. For other descriptions, refer to related descriptions corresponding to FIG. 1. Details are not described herein again.

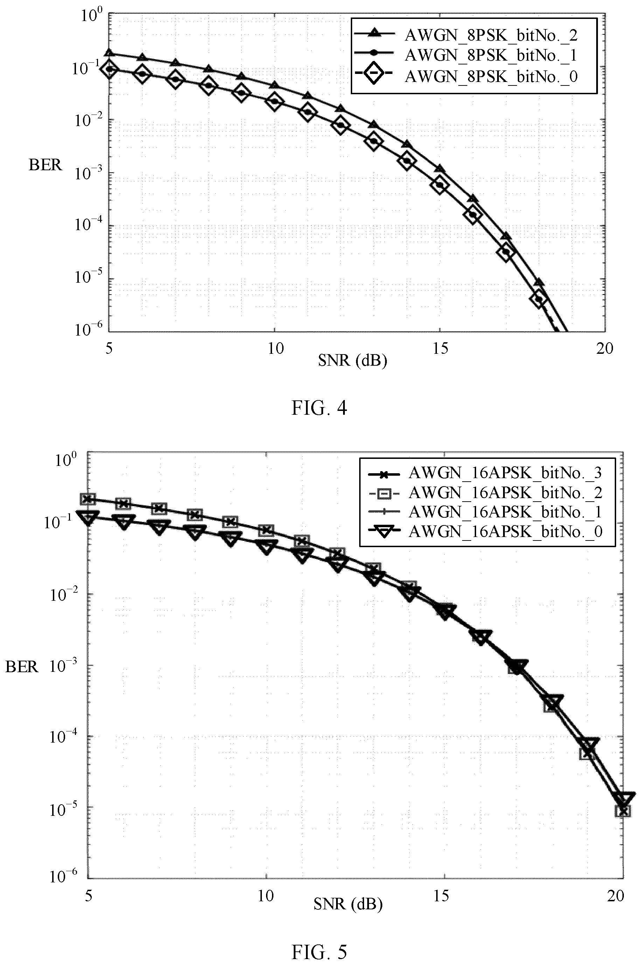

As shown in FIG. 4, a simulation result of bit reliability of the constellation diagram shown in FIG. 1 is shown. AWGN refers to additive white Gaussian noise (additive white Gaussian noise, AWGN), that is, simulation is performed in an AWGN channel; a BER refers to a bit error ratio (bit error ratio, BER); and an SNR refers to a signal-to-noise ratio (signal-to-noise ratio, SNR). The simulation result shows that low-order bits (the bit 1, the bit 0) of 8PSK are more reliable than a high-order bit (the bit 2). That is, under the same SNR, a BER of the low-order bit is lower than that of the high-order bit.

As shown in FIG. 5, a simulation result of bit reliability of the constellation diagram shown in FIG. 2 is shown. It can be seen from the simulation result that, in a working signal-to-noise ratio (signal-to-noise ratio, SNR) range of 16APSK, when an SNR$\leq$16 dB, low-order bits (the bit 1, the bit 0) of 16APSK are more reliable than the high-order bits (the bit 3, the bit 2).

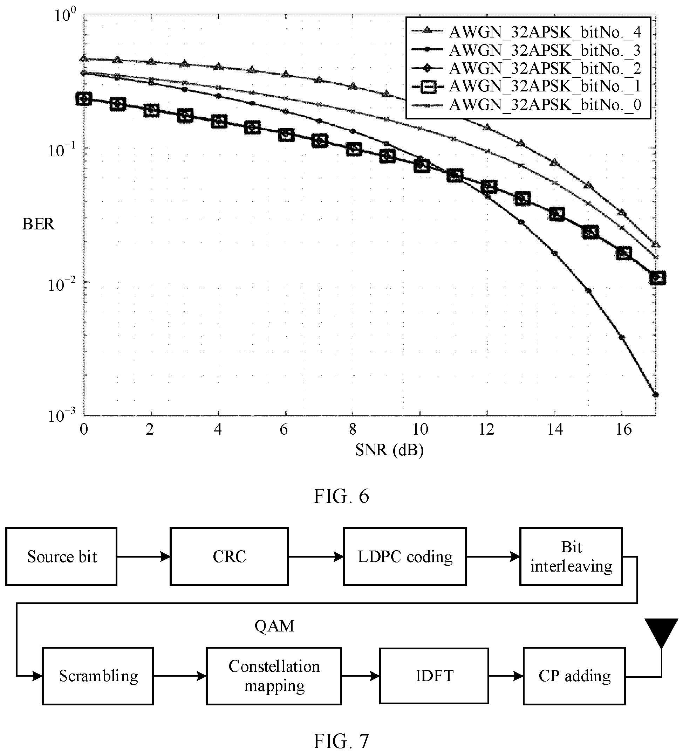

As shown in FIG. 6, a simulation result of bit reliability of the constellation diagram shown in FIG. 3 is shown. It can be seen from the simulation result that, in a working signal-to-noise ratio range of 32APSK, when 10.8 dB<an SNR$\leq$20.5 dB, reliability of the bit 3 of 32APSK is the highest, reliability of the bit 2 and the bit 1 is the second highest, and reliability of the bit 4 and the bit 0 is poor.

With reference to FIG. 4, FIG. 5, and FIG. 6, in 8PSK, 16APSK, and 32APSK, a reliability order of bits may be shown in Table 1. That is, in 8PSK, 16APSK, and 32APSK, reliability of the low and medium-order bit is high, and reliability of the high-order bit is low.

**Table 1**

| Modulation type | Bit reliability order |
|---|---|
| 8PSK (bit 2, bit 1, bit 0) | bit 1, bit 0>bit 2 |
| 16APSK (SNR$\leq$16 dB) (bit 3, bit 2, bit 1, bit 0) | bit 1, bit 0>bit 3, bit 2 |
| 32APSK (10.8 dB<SNR$\leq$20.5 dB) (bit 4, bit 3, bit 2, bit 1, bit 0) | bit 3>bit 2, bit 1>bit 0>bit 4 |

2. New radio (new radio, NR) interleaving and mapping

FIG. 7 is a diagram of data processing at an NR transmitting end. After cyclic redundancy check (cyclic redundancy check, CRC) information is added to a source bit (bit source), low-density parity-check code (low-density parity-check code, LDPC code) coding is performed to obtain an LDPC coded bit.

After bit interleaving (bit interleaver) and scrambling (scrambler) are performed on the LDPC coded bit, constellation mapping (constellation mapping) is performed.

After constellation mapping, inverse discrete Fourier transform (inverse discrete Fourier transform, IDFT) is performed to obtain a base band orthogonal frequency division multiplexing (orthogonal frequency division multiplexing, OFDM) signal, and a cyclic prefix (cyclic prefix, CP) is added to the base band OFDM signal for transmission.

To resist burst interference, an NR protocol uses row-column interleaving, and uses the row-column interleaving to discretize a local burst error into a random error, thereby improving decoding performance.

In this application, a system bit is a bit input to a coder. For example, in LDPC coding, the system bit is a bit input to an LDPC coder. Based on an example shown in FIG. 7, the system bit may be a bit obtained after CRC is added to the source bit.

During constellation mapping, the NR uses quadrature amplitude modulation (quadrature amplitude modulation, QAM), such as 16QAM and 64QAM. In this modulation type, a high-order bit is more reliable than a low-order bit.

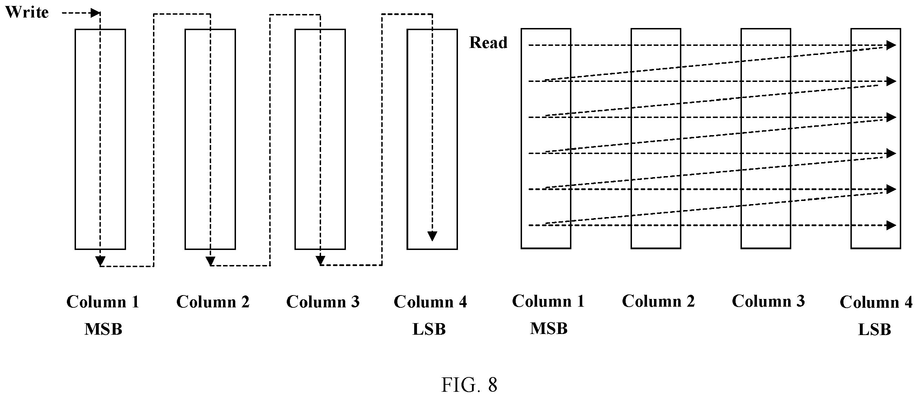

For example, a modulation type of 16QAM is used as an example. As shown in FIG. 8, in row-column interleaving, an LDPC coded bit is first written onto a bit matrix column by column. A quantity of columns in the bit matrix is a modulation order (16QAM corresponds to a modulation order 4), and a writing order is from the leftmost column to the rightmost column, which may be represented as [W-1 2 3 4]. Then, the bit matrix is read row by row, and each row is read from left to right to form a bit stream, which may be represented as [R-1 2 3 4]. The leftmost bit of each row is a most significant bit (most significant bit, MSB), and the rightmost bit is a least significant bit (least significant bit, LSB).

For example, LDPC coded bits are represented as $a_0a_1a_2a_3a_4a_5a_6a_7a_8a_9a_{10}a_{11}$. According to an interleaving manner shown in FIG. 8, $a_0a_1a_2$ are written onto the first column, $a_3a_4a_5$ are written onto the second column, $a_6a_7a_8$ are written onto the third column, and $a_9a_{10}a_{11}$ are written onto the fourth column. Then, $a_0a_3a_6a_9$ are read from the first row, $a_1a_4a_7a_{10}$ are read from the second row, and $a_2a_5a_8a_{11}$ are read from the third row. Because the leftmost bit is the MSB, and the rightmost bit is the LSB, after row-column interleaving, $a_0$, $a_1$ and $a_2$ can be transmitted at a high order.

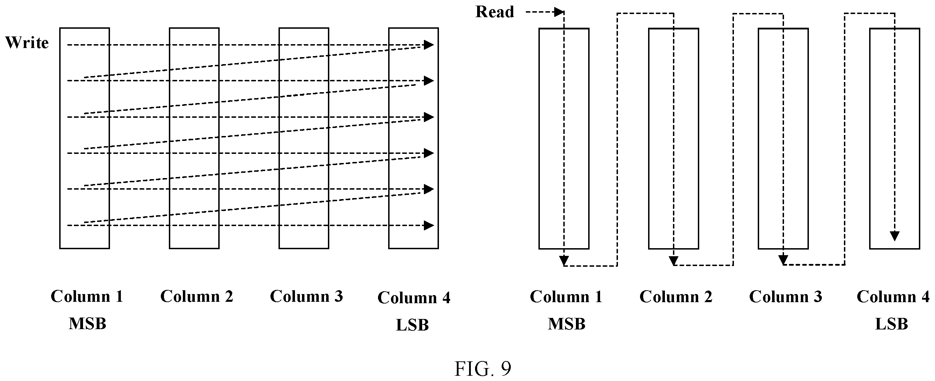

Correspondingly, FIG. 9 is a diagram of deinterleaving at a receiving end. An order of deinterleaving is opposite to that of interleaving. The bits are first written row by row from left to right, and then read column by column left to right.

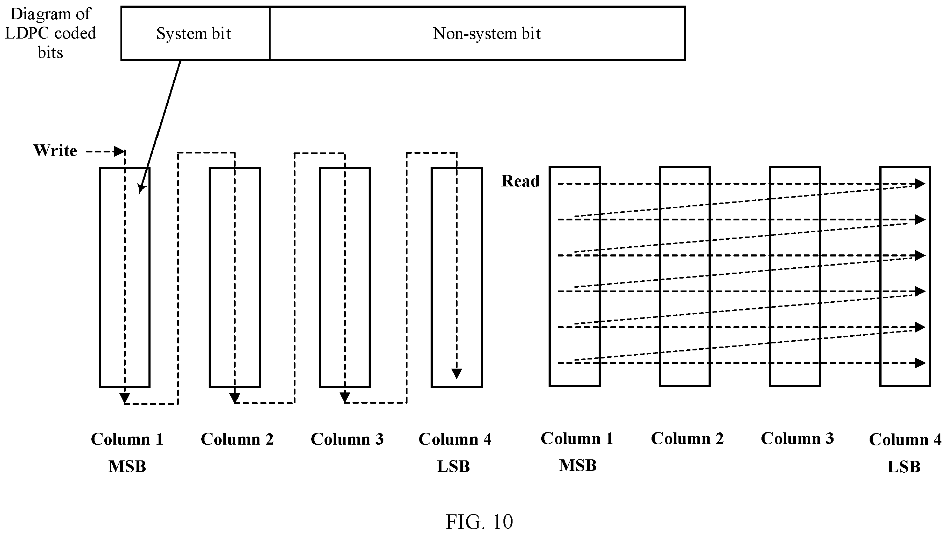

FIG. 10 is a diagram of composition of LDPC coded bits. To be specific, after LDPC coding, a system bit is before a non-system bit. In this scenario, a system bit of the LDPC coded bits may be mapped to a high-order bit in an NR-based interleaving manner. In addition, in a QAM modulation type, a high-order bit has higher reliability than a low-order bit. Therefore, in NR, the system bit can be mapped to the high-order bit to obtain better decoding performance.

However, it can be learned from Table 1 that reliability of low and medium-order bits in 8PSK, 16APSK, and 32APSK is high, and reliability of high-order bits is low. When 8PSK, 16APSK, and 32APSK are used in combination with NR interleaving, a system bit is transmitted in a high-order bit with low reliability. As a result, the system bit cannot be well protected, system decoding performance is reduced, and transmission reliability is low.

Based on this, this application provides a data processing method. The data processing method may include an interleaving and modulation method applied to a transmitting apparatus, and a deinterleaving and demodulation method applied to a receiving apparatus. When the NR protocol adapts to satellite communication, the method can improve system decoding performance, thereby improving transmission reliability.

The technical solutions in embodiments of this application may be applied to various communication systems, for example, an orthogonal frequency division multiple access (orthogonal frequency division multiple access, OFDMA) system, a single carrier frequency division multiple access (single carrier FDMA, SC-FDMA) system, a satellite communication system, an NTN system, an internet of things (internet of things, IoT) system, or a future evolved communication system. Terms "system" and "network" are interchangeable.

The technical solutions in embodiments of this application may be used in various communication scenarios, for example, may be used in one or more of the following communication scenarios: enhanced mobile broadband (enhanced mobile broadband, eMBB), ultra-reliable and low latency communication (ultra-reliable and low latency communication, URLLC), machine type communication (machine type communication, MTC), massive machine type communication (massive machine type communication, mMTC), device-to-device (device-to-device, D2D), vehicle to everything (vehicle to everything, V2X), IoT, or the like.

The technical solutions in embodiment of this application may be further used in a long-distance communication scenario, for example, used in a satellite communication scenario in which a distance between a terminal device and a network device continuously changes, or in another long-distance communication scenario. This is not limited.

The foregoing communication system to which this application is applicable is merely an example for description, and the communication system to which this application is applicable is not limited thereto. This is stated herein once for all, and details are not described below.

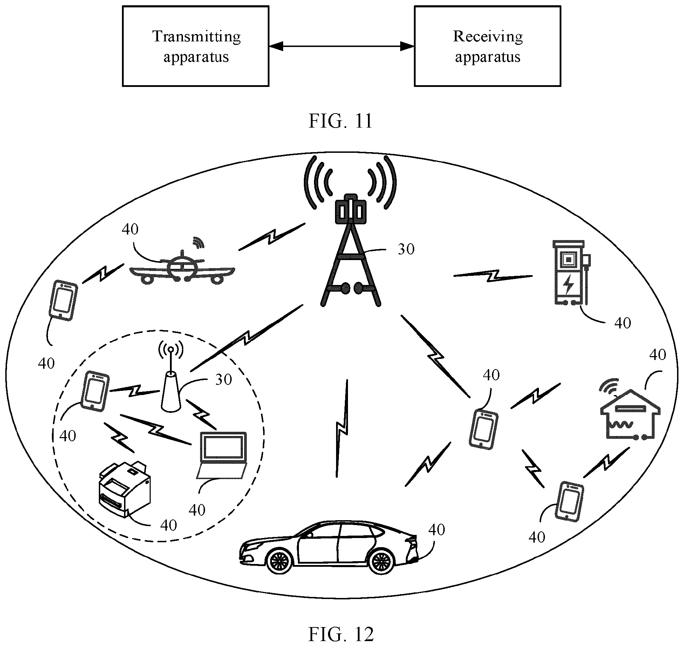

FIG. 11 is a schematic of a structure of a communication system according to this application. The communication system includes a transmitting apparatus and a receiving apparatus.

Optionally, the transmitting apparatus may be a terminal device, and correspondingly, the receiving apparatus is a network device; or the transmitting apparatus may be a network device, and correspondingly, the receiving apparatus is a terminal device; or both the transmitting apparatus and the receiving apparatus are terminal devices; or both the transmitting apparatus and the receiving apparatus are network devices.

For example, FIG. 12 is a diagram of a possible structure of the communication system according to this application. In FIG. 12, an example in which the communication system includes at least one network device 30 and one or more terminal devices 40 connected to the network device 30 is used for description. It should be understood that quantities of terminal devices and network devices in FIG. 12 are merely examples, and may be more or less.

For example, in the communication system shown in FIG. 12, the terminal device 40 may be used as a transmitting apparatus, and correspondingly, the network device 30 is used as a receiving apparatus; or the terminal device 40 may be used as a receiving apparatus, and correspondingly, the network device 30 is used as a transmitting apparatus.

Optionally, the network device 30 in embodiments of this application may be deployed on a high altitude platform or a satellite. The network device 30 is a device for connecting the terminal device 40 to a wireless network. The network device 30 may be a node in a radio access network, or may be referred to as a base station, or may be referred to as a radio access network (radio access network, RAN) node (or device).

For example, the network device may include an evolved NodeB (NodeB or eNB or e-NodeB, or evolved NodeB) in a long term evolution (long term evolution, LTE) system or an evolved LTE (LTE-Advanced, LTE-A) system, for example, a conventional macro base station eNB and a micro base station eNB in a heterogeneous network scenario. Alternatively, the network device may include a next generation NodeB (next generation NodeB, gNB) in an NR system. Alternatively, the network device may include a transmission reception point (transmission reception point, TRP), a home NodeB (for example, a home evolved NodeB, or a home NodeB, an HNB), a base band unit (base band unit, BBU), a base band pool BBU pool, a Wi-Fi access point (access point, AP), or the like. Alternatively, the network device may include a centralized unit (centralized unit, CU) and/or a distributed unit (distributed unit, DU) in a cloud access network (cloud radio access network, CloudRAN) system. Alternatively, the network device may include a base station in an NTN, that is, may be deployed on a high altitude platform or a satellite. In the NTN, the network device may serve as a layer 1 (L1) relay (relay), or may serve as a base station, or may serve as a DU, or may serve as an integrated access and backhaul (integrated access and backhaul, IAB) node. Alternatively, the network device may be a device that implements a base station function in IoT, for example, a device that implements a base station function in V2X, D2D, or machine to machine (machine to machine, M2M). This is not limited in embodiments of this application.

Optionally, the base station in embodiments of this application may include base stations in various forms, for example, a macro base station, a micro base station (also referred to as a small cell), a relay station, an access point, a home base station, a TRP, a transmitting point (transmitting point, TP), or a mobile switching center. This is not specifically limited in embodiments of this application.

Optionally, the terminal device 40 in embodiments of this application may be a device, such as a terminal or a chip that can be used in the terminal, configured to implement a wireless communication function. The terminal may be user equipment (user equipment, UE), an access terminal, a terminal unit, a terminal station, a mobile station, a remote station, a remote terminal, a mobile device, a wireless communication device, a terminal agent, a terminal apparatus, or the like in a 5G network or a future evolved public land mobile network (public land mobile network, PLMN). The access terminal may be a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device or another processing device connected to a wireless modem, a vehicle-mounted device or a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), or the like. Alternatively, the terminal may be a terminal having a communication function in IoT, for example, a terminal in V2X (for example, an internet of vehicles device), a terminal in D2D communication, or a terminal in M2M communication. The terminal may be mobile or fixed.

Optionally, the network device 30 and the terminal device 40 in embodiments of this application may also be referred to as communication apparatuses, and each may be a general-purpose device or a special-purpose device. This is not specifically limited in embodiments of this application.

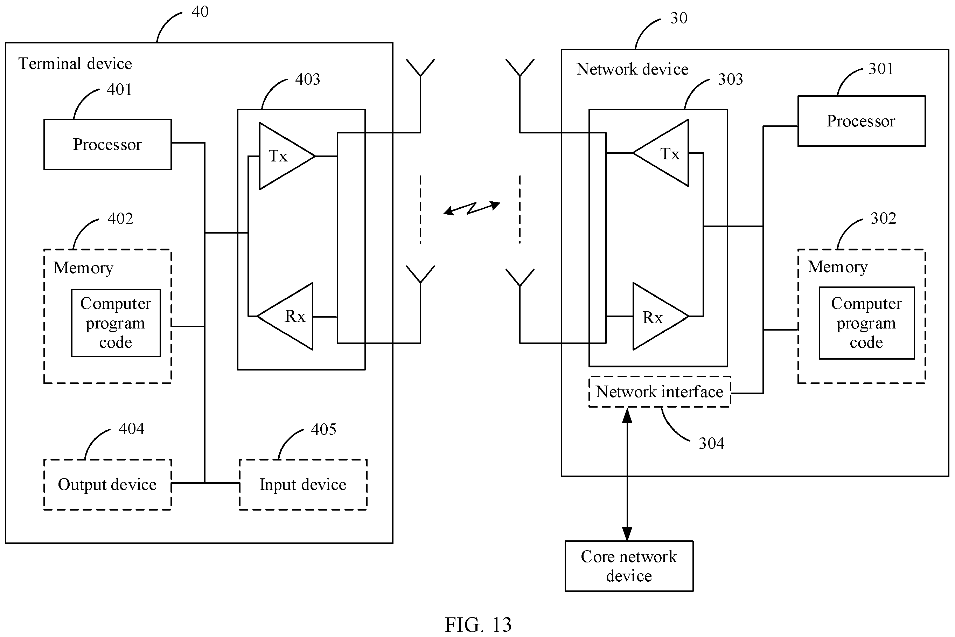

Optionally, FIG. 13 is a schematic of a structure of the network device 30 and the terminal device 40 according to embodiments of this application.

The terminal device 40 includes at least one processor (an example in which a processor 401 is included is used for description in FIG. 13) and at least one transceiver (an example in which a transceiver 403 is included is used for description in FIG. 13). Optionally, the terminal device 40 may further include at least one memory (an example in which a memory 402 is included is used for description in FIG. 13), at least one output device (an example in which an output device 404 is included is used for description in FIG. 13), and at least one input device (an example in which an input device 405 is included is used for description in FIG. 13).

The processor 401, the memory 402, and the transceiver 403 are connected to each other through communication lines. The communication line may include a path for transmitting information between the foregoing components.

The processor 401 may be a general-purpose central processing unit (central processing unit, CPU), a microprocessor, an application-specific integrated circuit (application-specific integrated circuit, ASIC), or one or more integrated circuits configured to control program execution of the solutions in this application. During specific implementation, in an embodiment, the processor 401 may alternatively include a plurality of CPUs, and the processor 401 may be a single-core (single-CPU) processor or a multi-core (multi-CPU) processor. The processor herein may be one or more devices, circuits, or processing cores configured to process data (for example, computer program instructions).

The memory 402 may be an apparatus having a storage function. For example, the memory 402 may be a read-only memory (read-only memory, ROM) or another type of static storage device that can store static information and instructions, or a random access memory (random access memory, RAM) or another type of dynamic storage device that can store information and instructions, or may be an electrically erasable programmable read-only memory (electrically erasable programmable read-only memory, EEPROM), a compact disc read-only memory (compact disc read-only memory, CD-ROM) or another optical disc storage, an optical disc storage (including a compact optical disc, a laser disc, an optical disc, a digital versatile optical disc, a Blu-ray disc, and the like), a magnetic disk storage medium or another magnetic storage device, or any other medium that can be used to carry or store expected program code in a form of an instruction or a data structure and that can be accessed by a computer. However, this is not limited herein. The memory 402 may exist independently, and is connected to the processor 401 through the communication line. Alternatively, the memory 402 and the processor 401 may be integrated together.

The memory 402 is configured to store computer-executable instructions for executing the solution of this application, and the processor 401 controls execution of the computer-executable instructions. Specifically, the processor 401 is configured to execute the computer-executable instructions stored in the memory 402, to implement the method in embodiments of this application.

Optionally, the computer-executable instructions in embodiments of this application may also be referred to as application program code or computer program code. This is not specifically limited in embodiments of this application.

The transceiver 403 may use any apparatus such as a transceiver, and is configured to communicate with another device or a communication network. The transceiver 403 includes a transmitter (transmitter, Tx) and a receiver (receiver, Rx).

The output device 404 communicates with the processor 401, and may display information in a plurality of manners. For example, the output device 404 may be a liquid crystal display (liquid crystal display, LCD), a light emitting diode (light emitting diode, LED) display device, a cathode ray tube (cathode ray tube, CRT) display device, a projector (projector), or the like.

The input device 405 communicates with the processor 401, and may receive a user input in a plurality of manners. For example, the input device 405 may be a mouse, a keyboard, a touchscreen device, a sensor device, or the like.

The network device 30 includes at least one processor (an example in which a processor 301 is included is used for description in FIG. 13) and at least one transceiver (an example in which a transceiver 303 is included is used for description in FIG. 13). Optionally, the network device 30 may further include at least one memory (an example in which a memory 302 is included is used for description in FIG. 13) and at least one network interface (an example in which a network interface 304 is included is used for description in FIG. 13). The processor 301, the memory 302, the transceiver 303, and the network interface 304 are connected to each other through communication lines. The network interface 304 is configured to be connected to a core network device through a link (for example, an S1 interface), or be connected to a network interface of another network device through a wired or wireless link (for example, an X2 interface) (not shown in the FIG. 13). This is not specifically limited in embodiments of this application. In addition, descriptions about the processor 301, the memory 302, and the transceiver 303 may refer to descriptions about the processor 401, the memory 402, and the transceiver 403 in the terminal device 40. Details are not described again herein.

It may be understood that the structure shown in FIG. 13 does not constitute a specific limitation on the network device 30 or the terminal device 40. For example, in some other embodiments of this application, the network device 30 or the terminal device 40 may include more or fewer components than those shown in FIG. 13, or some components may be combined, or some components may be split, or the components may be differently arranged. The components shown in the figure may be implemented by hardware, software, or a combination of software and hardware.

With reference to the accompanying drawings, the following describes in detail an interleaving and modulation method provided in embodiments of this application through interaction between the transmitting apparatus and the receiving apparatus as an example.

It may be understood that in embodiments of this application, the transmitting apparatus and/or the receiving apparatus may perform some or all steps in embodiments of this application. These steps or operations are merely examples. In embodiments of this application, other operations or variations of various operations may be further performed. In addition, the steps may be performed in a sequence different from a sequence presented in embodiments of this application, and not all the operations in embodiments of this application may be performed.

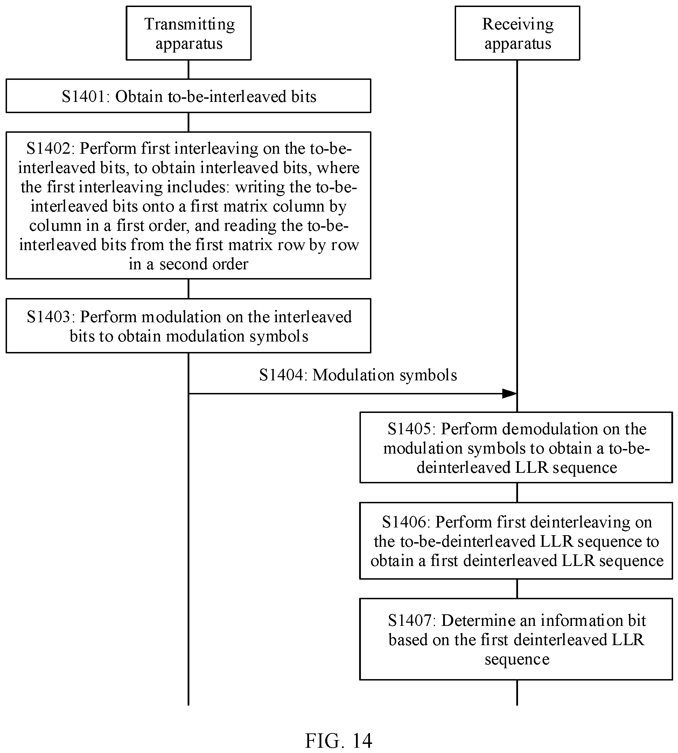

FIG. 14 shows a data processing method according to an embodiment of this application, including an interleaving and modulation method applied to a transmitting apparatus and a deinterleaving and demodulation method applied to a receiving apparatus. The method includes the following steps.

S1401: The transmitting apparatus obtains to-be-interleaved bits.

In a possible implementation, the to-be-interleaved bits may be coded bits.

In another possible implementation, the to-be-interleaved bits are bits obtained after second interleaving is performed on coded bits. This is described in a subsequent embodiment, and details are not described herein again.

Optionally, the coded bit is a bit obtained after a bit input to a coder is coded by using the coder. For example, the coded bit may be an LDPC coded bit, or may be another type of coded bit, for example, polar code or turbo code. A type of the coded bit is not specifically limited in this application.

S1402: The transmitting apparatus performs first interleaving on the to-be-interleaved bits, to obtain interleaved bits.

In a possible implementation, the first interleaving includes: writing the to-be-interleaved bits onto a first matrix column by column in a first order, and reading the to-be-interleaved bits from the first matrix row by row in a second order. In this scenario, a quantity of columns of the first matrix is a modulation order M, and M is greater than or equal to 3. A first bit read row by row is an MSB, and an $M^{th}$ bit read row by row is an LSB. The first order and the second order are described in detail in a subsequent embodiment, and details are not described herein again.

Optionally, each read row of bits forms a bit stream. The leftmost bit of each row is an MSB, and the rightmost bit is an LSB.

Optionally, when a quantity $N$ of the to-be-interleaved bits is not divisible by $M$, a quantity of rows of the first

matrix may be $\left\lfloor \dfrac{N}{M} \right\rfloor$. Herein, $\lfloor\ \rfloor$ indicates rounding down. In this scenario, the last $N - \left\lfloor \dfrac{N}{M} \right\rfloor \times M$ bits of the to-be-interleaved bits may not participate in the first interleaving.

Alternatively, the quantity of rows of the first matrix may be $\left\lceil \dfrac{N}{M} \right\rceil$. Herein, $\lceil\ \rceil$ indicates rounding up. In this scenario, $\left\lceil \dfrac{N}{M} \right\rceil \times M - N$ 0s may be added after the to-be-interleaved bits, and then the first interleaving is performed on the bits after which the 0s are added.

In another possible implementation, the first interleaving may include: writing the to-be-interleaved bits onto the first matrix row by row in a third order, and reading the to-be-interleaved bits from the first matrix column by column in a fourth order. In this scenario, a quantity of rows of the first matrix is a modulation order M, and M is greater than or equal to 3. A first bit read column by column is an MSB, and a last bit column by column is an LSB. For example, a column of the first order may be replaced with a row to obtain the third order. The column of the second order is replaced with a row to obtain the fourth order.

S1403: The transmitting apparatus performs modulation on the interleaved bits to obtain modulation symbols.

Optionally, a modulation type used by the transmitting apparatus may be a related modulation type defined in a DVB-S2 standard.

S1404: The transmitting apparatus sends the modulation symbol. Correspondingly, the receiving apparatus receives the modulation symbol.

Optionally, that the transmitting apparatus sends the modulation symbol may include: A modulation module of the transmitting apparatus outputs the modulation symbol. After the modulation module outputs the modulation symbol, another module of the transmitting apparatus may perform processing such as IDFT and adding a cyclic prefix on the modulation symbol to generate a to-be-sent signal, and send the to-be-sent signal to the receiving apparatus.

Correspondingly, the receiving apparatus may receive a signal obtained after the to-be-sent signal is transmitted through a channel, and perform operations such as CP removal and DFT removal on the received signal to obtain the modulation symbol. That is, that the receiving apparatus receives the modulation symbol may include: A demodulation module of the receiving apparatus receives (or inputs) the modulation symbol.

S1405: The receiving apparatus performs demodulation on the modulation symbol to obtain a to-be-deinterleaved log-likelihood ratio (log-likelihood ratio, LLR) sequence.

It may be understood that a modulation type corresponding to the demodulation is the modulation type used by the transmitting apparatus in step S1403. This is described in a subsequent embodiment, and details are not described herein again.

S1406: The receiving apparatus performs first deinterleaving on the to-be-deinterleaved LLR sequence, to obtain a first deinterleaved LLR sequence.

The first deinterleaving includes: writing the to-be-deinterleaved LLR sequence onto the second matrix row by row in the second order, and reading the to-be-deinterleaved LLR sequence from the second matrix column by column in the first order. A quantity of columns of the second matrix is a modulation order M. For the quantity of rows of the second matrix, refer to related descriptions of the first matrix. Details are not described herein again. A first bit written row by row is an MSB, and an $M^{th}$ bit written row by row is an LSB.

S1407: The receiving apparatus determines an information bit based on the deinterleaved first LLR sequence.

In a possible implementation, the receiving apparatus may decode the deinterleaved first LLR sequence, to obtain the information bit.

In another possible implementation, the receiving apparatus may perform second deinterleaving on the first deinterleaved LLR sequence, to obtain a second deinterleaved LLR sequence. The second deinterleaved LLR sequence is decoded, to obtain the information bit. This is described in a subsequent embodiment, and details are not described herein again.

Optionally, after determining the information bit, the receiving apparatus may obtain content sent by the transmitting apparatus, to perform corresponding processing based on the content. This is not specifically limited in this application.

The foregoing describes an overall procedure of the data processing method provided in this application. The following describes the interleaving and modulation type in detail.

Optionally, in embodiments of this application, columns of the first matrix are sequentially sorted from left to right, the leftmost column is the first column, the rightmost column is the $M^{th}$ column, and the columns are sequentially numbered as a column 1, a column 2, ..., and a column M.

Optionally, when the transmitting apparatus uses a DVB-S2 modulation type, and the to-be-interleaved bits are written onto the first matrix column by column in the first order, M columns of the first matrix may correspond to M bits. The first column corresponds to the highest bit, and the M$^{th}$ column corresponds to the lowest bit. For example, when M is equal to 3, the first column corresponds to a bit 2, the second column corresponds to a bit 1, and the third column corresponds to a bit 0. In this scenario, the first order and the second order may have the following two cases.

Case 1: The first order is associated with bit reliability of a bit in the modulation type. For example, a bit corresponding to a column onto which the to-be-interleaved bits are first written may be a bit having the highest bit reliability, and bit reliability corresponding to a next column onto which the to-be-interleaved bits are written is second or equal to the previous bit reliability. By analogy, bit reliability corresponding to a column onto which the to-be-interleaved bits are last written is the lowest. Correspondingly, the second order may be an arrangement order of columns of the first matrix. For example, when M is equal to 3, the second order is the first column to the second column to the third column of the first matrix.

Case 2: The first order is an arrangement order of columns of the first matrix. For example, when M is equal to 3, the first order is the first column to the second column to the third column of the first matrix. The second order is associated with bit reliability of a bit in the modulation type. For example, a bit corresponding to a first read column may be a bit having the highest bit reliability, bit reliability of a bit corresponding to a next read column is second or equal to the bit reliability of the previous bit. By analogy, bit reliability of a bit corresponding to a last read column is the lowest.

The following separately describes in detail specific implementation of the first order and the second order when the DVB-S2 modulation type is used and the modulation order M is equal to 3, 4, or 5.

When the modulation order M is equal to 3, the modulation type used when the transmitting apparatus performs modulation in step S1403 is DVB-S2 8PSK, and a constellation diagram is shown in FIG. 1. The first order and the second order in the foregoing steps S1402 and S1406 may be implemented in the following three manners.

Manner 11: The first order is the third column to the second column to the first column of the first matrix, and may be represented as [W-3 2 1]. The second order is the first column to the second column to the third column of the first matrix, and may be represented as [R-1 2 3].

Optionally, implementation of the manner 11 belongs to the foregoing case 1. The third column to the second column to the first column of the first matrix respectively correspond to a bit 0, a bit 1, and a bit 2 of DVB-S2 8PSK.

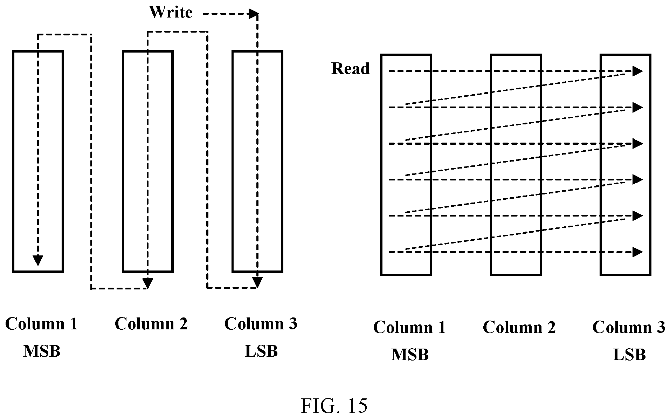

FIG. 15 shows a pattern of column-by-column writing and row-by-row reading by the transmitting apparatus in the manner 11. It is assumed that the to-be-interleaved bits are $a_0a_1a_2a_3a_4a_5a_6a_7a_8$, and system bits are $a_0a_1a_2$. According to the interleaving pattern shown in FIG. 15, after the transmitting apparatus writes the to-be-interleaved bits onto the first matrix column by column, $a_0a_1a_2$ are written onto the third column of the first matrix, $a_3a_4a_5$ are written onto the second column, and $a_6a_7a_8$ are written onto the first column. Then, $a_6a_3a_0$ are read from the first row, $a_7a_4a_1$ are read from the second row, and $a_8a_5a_2$ are read from the third row.

Based on the interleaving solution, the system bit may be mapped to the bit 0 for transmission. It can be learned from Table 1 that in DVB-S2 8PSK modulation, the bit 0 has higher reliability than the bit 2. Therefore, when the system bit is transmitted at the bit 0, transmission reliability of the system bit can be improved, thereby improving system decoding performance.

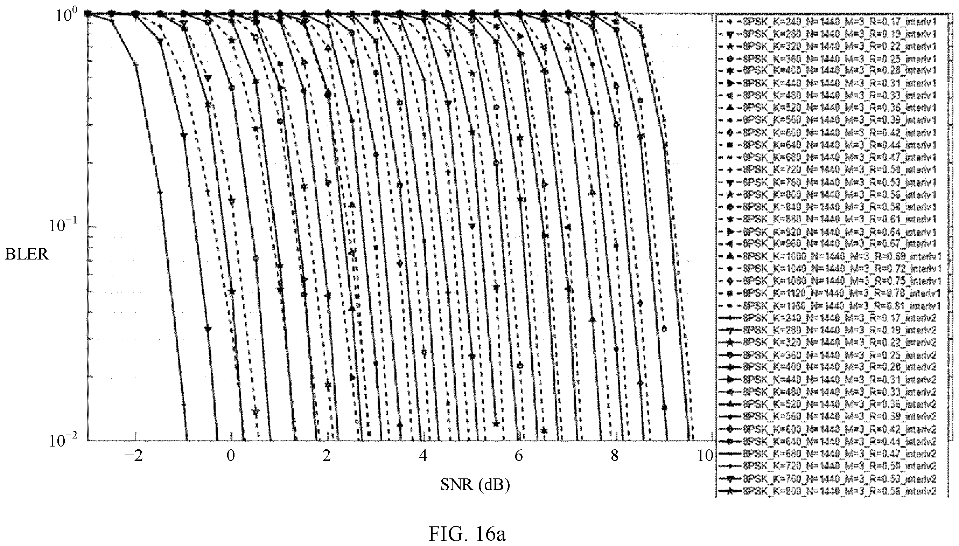

As shown in FIG. 16a, in a case in which the modulation type is DVB-S2 8PSK, performance comparison between a block error rate (block error rate, BLER) generated when an NR interleaving manner is used and a block error rate generated when an interleaving manner shown in the manner 11 is used is shown. Simulation conditions are shown in Table 2 below.

**Table 2**

| | |
|---|---|
| Channel (Channel) | AW GN |
| Interleaver (Interleaver) | Interlv1 indicates an NR interleaver<br>Interlv2 indicates an interleaver in the manner 11 |
| Transport block size (including 16-bit CRC) | 240:40:1160 |
| Coded LDPC length (Coded LDPC length) | 1440 |
| Channel estimation (Channel estimation) | Ideal (Ideal) |
| Modulation type (Modulation type) | 8PSK |
| Channel (Channel) | AWGN |
| Constellation diagram | FIG. 1 |

240:40: 1160 in Table 2 indicates that the minimum value of a quantity of system bits is 240, and the value increases by using 40 as a step until the value increases to the maximum value 1160. LDPC coding in Table 2 is a to-be-interleaved bit. In FIG. 16a, K is the quantity of system bits, N is a quantity of to-be-interleaved bits, and M is a modulation order. It can be learned from FIG. 16a that, under a same BLER, an SNR of the interleaving manner 11 shown in FIG. 15 is 0.1-1.2 dB lower than that of the NR interleaving manner. That is, for a same BLER, the interleaving manner 11 shown in FIG. 15 has a lower requirement for the SNR. In other words, when the interleaving manner 11 shown in FIG. 15 is used, BLER performance may be improved by 0.1-1.2 dB.

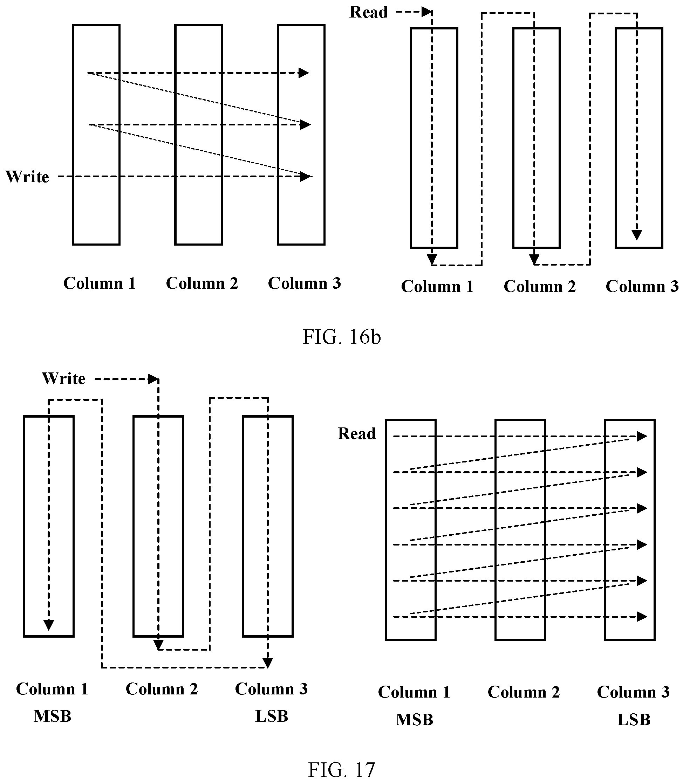

Optionally, when the first order and the second order are shown in the manner 11, the third order may be the third row to the second row to the first row of the first matrix. That is, the to-be-interleaved bits are first written onto the third row, then written onto the second row, and finally written onto the first row. When writing is performed in each row, writing is performed from left to right. The fourth order may be the first row to the second row to the third row of the first matrix. That is, when each column is read, the first row is read first, then the second row is read, and finally the third row is read. In addition, each column is read from left to right. That is, the first row to the second row to the third row of the first column are read first, then the first row to the second row to the third row of the second column are read, and finally the first row to the second row to the third row of the third column are read. An interleaving pattern is shown in FIG. 16b.

For example, it is assumed that the to-be-interleaved bits are $a_0a_1a_2a_3a_4a_5a_6a_7a_8$, and the system bits are $a_0a_1a_2$ . After the transmitting apparatus writes the to-be-interleaved bits onto the first matrix column by column in the third order, $a_0a_1a_2$ are written onto the third row of the first matrix, $a_3a_4a_5$ are written onto the second row, and $a_6a_7a_8$ are written onto the first row. Then, $a_6a_3a_0$ are read from the first column, $a_7a_4a_1$ are read from the second column, and $a_8a_5a_2$ are read from the third column.

It may be understood that in embodiments of this application, each implementation of the first order and the second order may correspond to the implementations of the third order and the fourth order. For details, refer to related descriptions in step S1402 and the manner 11. Details are not described subsequently.

Manner 12: The first order is the second column to the third column to the first column of the first matrix, and may be represented as [W-2 3 1]. The second order is the first column to the second column to the third column of the first matrix, and may be represented as [R-1 2 3].

FIG. 17 shows a pattern of column-by-column writing and row-by-row reading by the transmitting apparatus in the manner 12. It is assumed that the to-be-interleaved bits are $a_0a_1a_2a_3a_4a_5a_6a_7a_8$, and the system bits are $a_0a_1a_2$. According to the interleaving pattern shown in FIG. 17, after the transmitting apparatus writes the to-be-interleaved bits onto the first matrix column by column, $a_0a_1a_2$ are written onto the second column of the first matrix, $a_3a_4a_5$ are written onto the third column, and $a_6a_7a_8$ are written onto the first column. Then, $a_6a_0a_3$ are read from the first row, $a_7a_1a_4$ are read from the second row, and $a_8a_2a_5$ are read from the third row.

Based on the interleaving solution, the system bit may be mapped to the bit 1 for transmission. In DVB-S2 8PSK modulation, the bit 1 has higher reliability than the bit 2. Therefore, compared with that of transmission at the bit 2, transmission reliability of the system bit at the bit 1 can be improved, thereby improving system decoding performance.

Manner 13: The first order is the first column to the second column to the third column of the first matrix, and may be represented as [W -1 2 3]. The second order is the second column to the third column to the first column of the first matrix, and may be represented as [R-2 3 1].

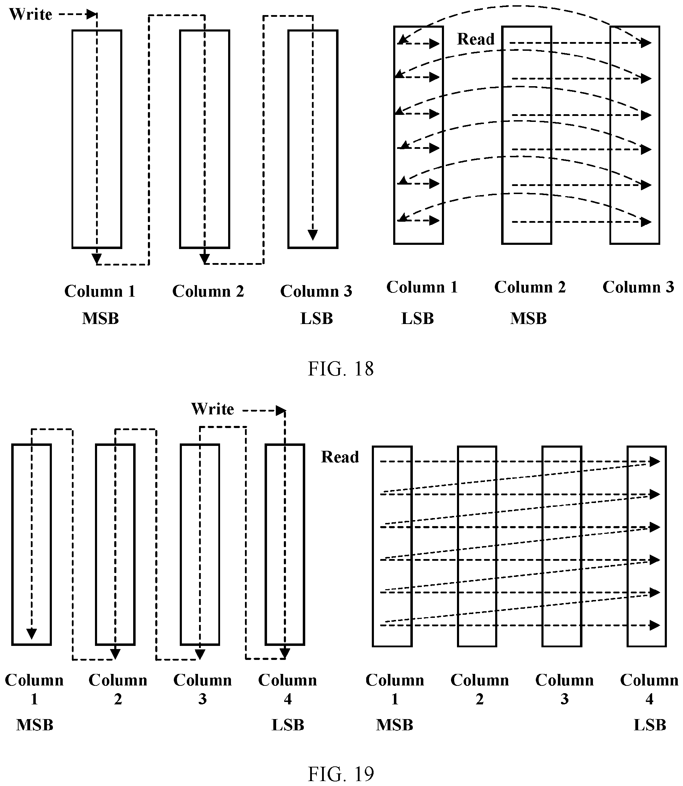

FIG. 18 shows a pattern of column-by-column writing and row-by-row reading by the transmitting apparatus in the manner 13. It is assumed that the to-be-interleaved bits are $a_0a_1a_2a_3a_4a_5a_6a_7a_8$, and the system bits are $a_0a_1a_2$. According to the interleaving pattern shown in FIG. 18, after the transmitting apparatus writes the to-be-interleaved bits onto the first matrix column by column, $a_0a_1a_2$ are written onto the first column of the first matrix, $a_3a_4a_5$ are written onto the second column, and $a_6a_7a_8$ are written onto the third column. Then, $a_3a_6a_0$ are read from the first row, $a_4a_7a_1$ are read from the second row, and $a_5a_8a_2$ are read from the third row.

Based on the interleaving solution, because the first bit read row by row is an MSB, and the Mth bit is an LSB, the system bit may be mapped to the lowest order for transmission. In addition, in DVB-S2 8PSK modulation, a lower-order bit has higher reliability than a higher-order bit. Therefore, compared with that of transmission of the higher-order bit, transmission reliability of the system bit can be improved when the system bit is transmitted at the lowest order, thereby improving system decoding performance.

When the modulation order M is equal to 4, the modulation type used when the transmitting apparatus performs modulation in step S1403 is DVB-S2 16APSK, and a constellation diagram is shown in FIG. 2. The first order and the second order in the foregoing steps S1402 and S1406 may be implemented in the following four manners.

Manner 21: The first order is the fourth column to the third column to the second column to the first column of the first matrix, and may be represented as [W-4 3 2 1]. The second order is the first column to the second column to the third column to the fourth column of the first matrix, and may be represented as [R-1 2 3 4].

FIG. 19 shows a pattern of column-by-column writing and row-by-row reading by the transmitting apparatus in the manner 21. It is assumed that the to-be-interleaved bits are $a_0a_1a_2a_3a_4a_5a_6a_7a_8a_9a_{10}a_{11}$, and the system bits are

$a_0a_1a_2$. According to the interleaving pattern shown in FIG. 19, after the transmitting apparatus writes the to-be-interleaved bits onto the first matrix column by column, $a_0a_1a_2$ are written onto the fourth column of the first matrix, $a_3a_4a_5$ are written onto the third column, $a_6a_7a_8$ are written onto the second column, and $a_9a_{10}a_{11}$ are written onto the first column. Then, $a_9a_6a_3a_0$ are read from the first row, $a_{10}a_7a_4a_1$ are read from the second row, and $a_{11}a_8a_5a_2$ are read from the third row.

Based on the interleaving solution, the system bit may be mapped to the lowest order for transmission. In DVB-S2 16APSK modulation, the bit 0 has higher reliability than the bit 3. Therefore, when the system bit is transmitted at the bit 0, transmission reliability of the system bit can be improved, thereby improving system decoding performance.

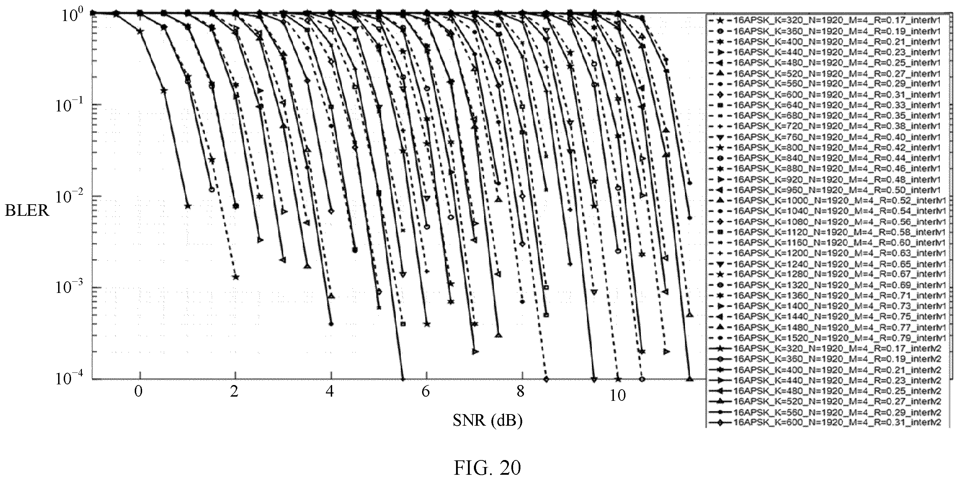

As shown in FIG. 20, in a case in which the modulation type is DVB-S2 16PSK, performance comparison between a BLER generated when an NR interleaving manner is used and a BLER generated when an interleaving manner shown in manner 21 is used is shown. Simulation conditions are shown in Table 3 below.

**Table 3**

| Channel (Channel) | AWGN |
|---|---|
| Interleaver (Interleaver) | Interlv1 indicates an NR interleaver<br>Interlv2 indicates an interleaver in the implementation 21 |
| Transport block size (including 16-bit CRC) | 320:40:1520 |
| Coded LDPC length (Coded LDPC length) | 1920 |
| Channel estimation (Channel estimation) | Ideal (Ideal) |
| Modulation type (Modulation type) | 16APSK |
| Constellation diagram | FIG. 2 |

For related parameters in Table 3 and FIG. 20, refer to related descriptions in Table 2 and FIG. 16a. Details are not described herein again. It can be learned from FIG. 20 that, under a same BLER, an SNR of the interleaving manner 21 is 0.1-0.7 dB lower than that of the NR interleaving manner. That is, for a same BLER, the interleaving manner 21 has a lower requirement for the SNR. In other words, when the interleaving manner 21 is used, BLER performance may be improved by 0.1-0.7 dB.

Manner 22: The first order is the fourth column to the third column to the first column to the second column of the first matrix, and may be represented as [W-4 3 1 2]. The second order is the first column to the second column to the third column to the fourth column of the first matrix, and may be represented as [R-1 2 3 4].

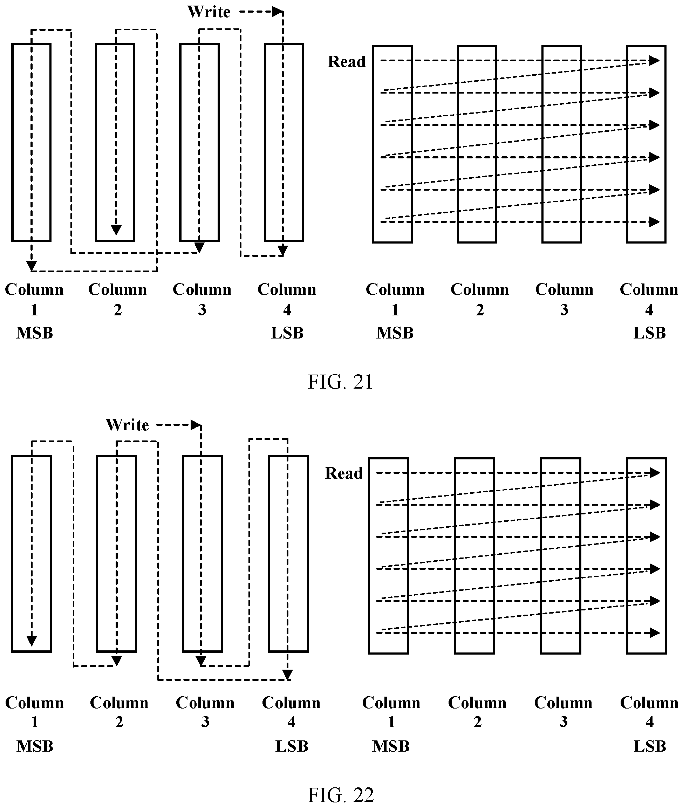

FIG. 21 shows a pattern of column-by-column writing and row-by-row reading by the transmitting apparatus in the manner 22. It is assumed that the to-be-interleaved bits are $a_0a_1a_2a_3a_4a_5a_6a_7a_8a_9a_{10}a_{11}$, and the system bits are $a_0a_1a_2$. According to the interleaving pattern shown in FIG. 21, after the transmitting apparatus writes the to-be-interleaved bits onto the first matrix column by column, $a_0a_1a_2$ are written onto the fourth column of the first matrix, $a_3a_4a_5$ are written onto the third column, $a_9a_{10}a_{11}$ are written onto the second column, and $a_6a_7a_8$ are written onto the first column. Then, $a_6a_9a_3a_0$ are read from the first row, $a_7a_{10}a_4a_1$ are read from the second row, and $a_8a_{11}a_5a_2$ are read from the third row.

Based on the interleaving solution, the system bit may alternatively be mapped to the lowest order for transmission. In DVB-S2 16APSK modulation, the bit 0 has higher reliability than the bit 3. Therefore, when the system bit is transmitted at the bit 0, transmission reliability of the system bit can be improved, thereby improving system decoding performance.

Manner 23: The first order is the third column to the fourth column to the second column to the first column of the first matrix, and may be represented as [W-3 4 2 1]. The second order is the first column to the second column to the third column to the fourth column of the first matrix, and may be represented as [R-1 2 3 4].

FIG. 22 shows a pattern of column-by-column writing and row-by-row reading by the transmitting apparatus in the manner 23. It is assumed that the to-be-interleaved bits are $a_0a_1a_2a_3a_4a_5a_6a_7a_8a_9a_{10}a_{11}$, and the system bits are $a_0a_1a_2$. According to the interleaving pattern shown in FIG. 22, after the transmitting apparatus writes the to-be-interleaved bits onto the first matrix column by column, $a_3a_4a_5$ are written onto the fourth column of the first matrix, $a_0a_1a_2$ are written onto the third column, $a_6a_7a_8$ are written onto the second column, and $a_9a_{10}a_{11}$ are written onto the first column. Then, $a_9a_6a_0a_3$ are read from the first row, $a_{10}a_7a_1a_4$ are read from the second row, and $a_{11}a_8a_2a_5$ are read from the third row.

Based on the interleaving solution, the system bit may be mapped to the bit 1 for transmission. In DVB-S2 16APSK modulation, the bit 1 has higher reliability than the bit 3 or the bit 2. Therefore, when the system bit is transmitted at the bit 1, transmission reliability of the system bit can be improved, thereby improving system decoding performance.

Manner 24: The first order is the third column to the fourth column to the first column to the second column of the first matrix, and may be represented as [W-3 4 1 2]. The second order is the first column to the second column to the third column to the fourth column of the first matrix, and may be represented as [R-1 2 3 4].

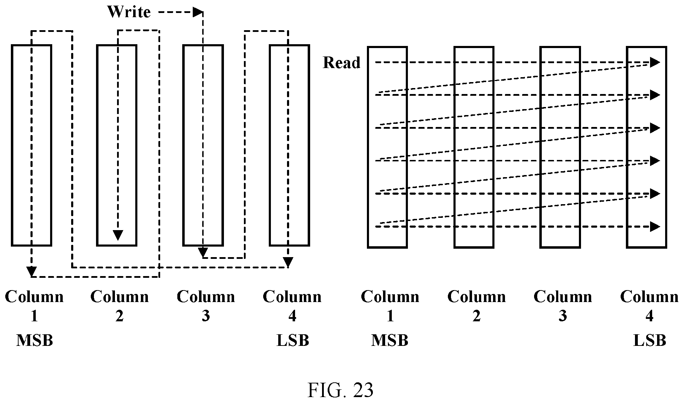

FIG. 23 shows a pattern of column-by-column writing and row-by-row reading by the transmitting apparatus in the manner 24. It is assumed that the to-be-interleaved bits are $a_0a_1a_2a_3a_4a_5a_6a_7a_8a_9a_{10}a_{11}$, and the system bits are $a_0a_1a_2$. According to the interleaving pattern shown in FIG. 23, after the transmitting apparatus writes the to-be-interleaved bits onto the first matrix column by column, $a_3a_4a_5$ are written onto the fourth column of the first matrix, $a_0a_1a_2$ are written onto the third column, $a_9a_{10}a_{11}$ are written onto the second column, and $a_6a_7a_8$ are written onto the first column. Then, $a_6a_9a_0a_3$ are read from the first row, $a_7a_{10}a_1a_4$ are read from the second row, and $a_8a_{11}a_2a_5$ are read from the third row.

Based on the interleaving solution, the system bit may alternatively be mapped to the bit 1 for transmission, so that transmission reliability of the system bit can be improved, thereby improving system decoding performance.

When the modulation order M is equal to 5, the modulation type used when the transmitting apparatus performs modulation in step S1403 is DVB-S2 32APSK, and a constellation diagram is shown in FIG. 3. The first order and the second order in the foregoing steps S1402 and S1406 may be implemented in the following four manners.

Manner 31: The first order is the fourth column to the third column to the second column to the first column to the fifth column of the first matrix, and may be represented as [W-4 3 2 1 5]. The second order is the first column to the second column to the third column to the fourth column to the fifth column of the first matrix, and may be represented as [R-1 2 3 4 5].

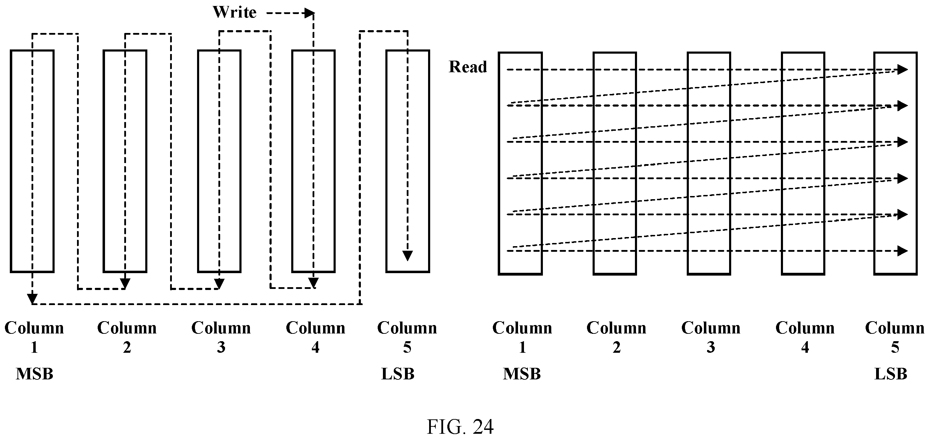

FIG. 24 shows a pattern of column-by-column writing and row-by-row reading by the transmitting apparatus in the manner 31. It is assumed that the to-be-interleaved bits are $a_0a_1a_2a_3a_4a_5a_6a_7a_8a_9a_{10}a_{11}a_{12}a_{13}a_{14}$, and the system bits are $a_0a_1a_2$. According to the interleaving pattern shown in FIG. 24, after the transmitting apparatus writes the to-be-interleaved bits onto the first matrix column by column, $a_0a_1a_2$ are written onto the fourth column of the first matrix, $a_3a_4a_5$ are written onto the third column, $a_6a_7a_8$ are written onto the second column, $a_9a_{10}a_{11}$ are written onto the first column, and $a_{12}a_{13}a_{14}$ are written onto the fifth column. Then, $a_9a_6a_3a_0a_{12}$ are read from the first row, $a_{10}a_7a_4a_1a_{13}$ are read from the second row, and $a_{11}a_8a_5a_2a_{14}$ are read from the third row.

Based on the interleaving solution, the system bit may be mapped to the bit 1 for transmission. It can be learned from Table 1 that, in DVB-S2 32APSK modulation, the bit 1 has higher reliability than the bit 4. Therefore, when the system bit is transmitted at the bit 1, transmission reliability of the system bit can be improved, thereby improving system decoding performance.

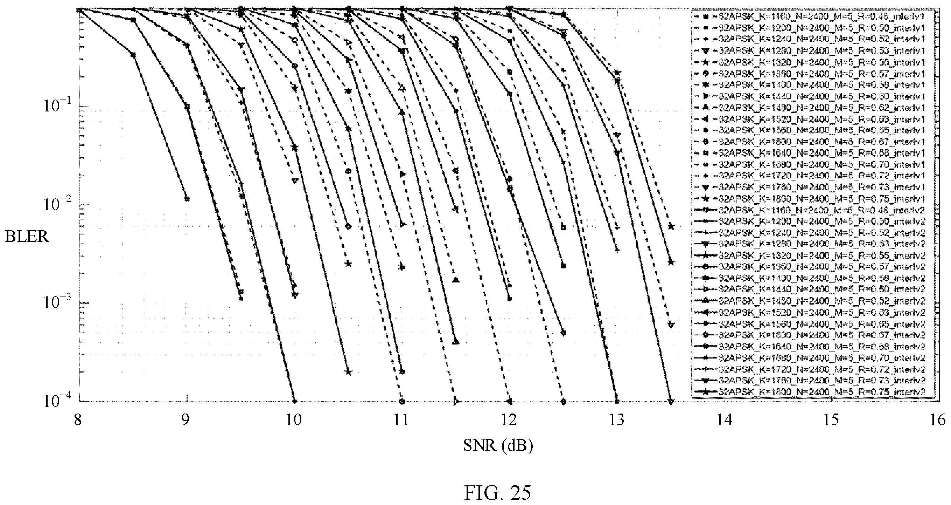

As shown in FIG. 25, in a case in which the modulation type is DVB-S2 32APSK, performance comparison between a BLER generated when an NR interleaving manner is used and a BLER generated when an interleaving manner shown in manner 31 is shown. Simulation conditions are shown in Table 4 below.

**Table 4**

| Channel (Channel) | AWGN |
|---|---|
| Interleaver (Interleaver) | Interlv1 indicates an NR interleaver<br>Interlv2 indicates an interleaver in the implementation 31 |
| Transport block size (including 16-bit CRC) | 1160:40:1800 |
| Coded LDPC length (Coded LDPC length) | 2400 |
| Channel estimation (Channel estimation) | Ideal (Ideal) |
| Modulation type (Modulation type) | 32APSK |
| Constellation diagram | FIG. 3 |

For related parameters in Table 4 and FIG. 25, refer to related descriptions in Table 2 and FIG. 16a. Details are not described herein again. It can be learned from FIG. 25 that, under a same BLER, an SNR of the interleaving manner 31 is 0.1-0.25 dB lower than that of the NR interleaving manner. That is, for a same BLER, the interleaving manner 31 has a lower requirement for the SNR. In other words, when the interleaving manner 31 is used, BLER performance may be improved by 0.1-0.5 dB.

Manner 32: The first order is the fourth column to the second column to the third column to the first column to the fifth column of the first matrix, and may be represented as [W-4 2 3 1 5]. The second order is the first column to the second column to the third column to the fourth column to the fifth column of the first matrix, and may be represented as [R-1 2 3 4 5].

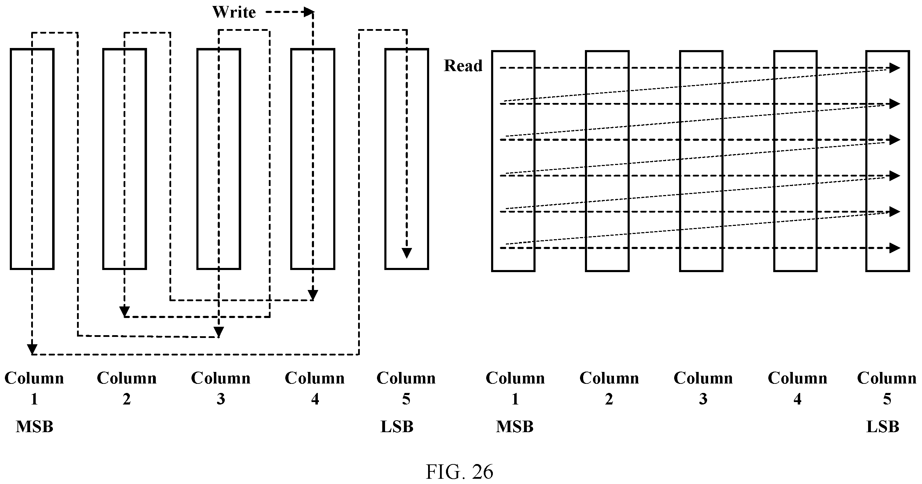

FIG. 26 shows a pattern of column-by-column writing and row-by-row reading by the transmitting apparatus in the manner 32. It is assumed that the to-be-interleaved bits are $a_0a_1a_2a_3a_4a_5a_6a_7a_8a_9a_{10}a_{11}a_{12}a_{13}a_{14}$, and the system bits are $a_0a_1a_2$. According to the interleaving pattern shown in FIG. 26, after the transmitting apparatus writes the to-be-interleaved bits onto the first matrix column by column, $a_0a_1a_2$ are written onto the fourth column of the first matrix, $a_3a_4a_5$ are written onto the second column, $a_9a_{10}a_{11}$ are written onto the first column, $a_6a_7a_8$ are written onto the third

column, and $a_{12}a_{13}a_{14}$ are written onto the fifth column. Then, $a_9a_6a_3a_0a_{12}$ are read from the first row, $a_{10}a_4a_7a_1a_{13}$ are read from the second row, and $a_{11}a_5a_8a_2a_{14}$ are read from the third row.

Based on the interleaving solution, the system bit may alternatively be mapped to the bit 1 for transmission. Therefore, transmission reliability of the system bit can be improved, thereby improving system decoding performance.

Manner 33: The first order is the fourth column to the third column to the second column to the fifth column to the first column of the first matrix, and may be represented as [W-4 3 2 5 1]. The second order is the first column to the second column to the third column to the fourth column to the fifth column of the first matrix, and may be represented as [R-1 2 3 4 5].

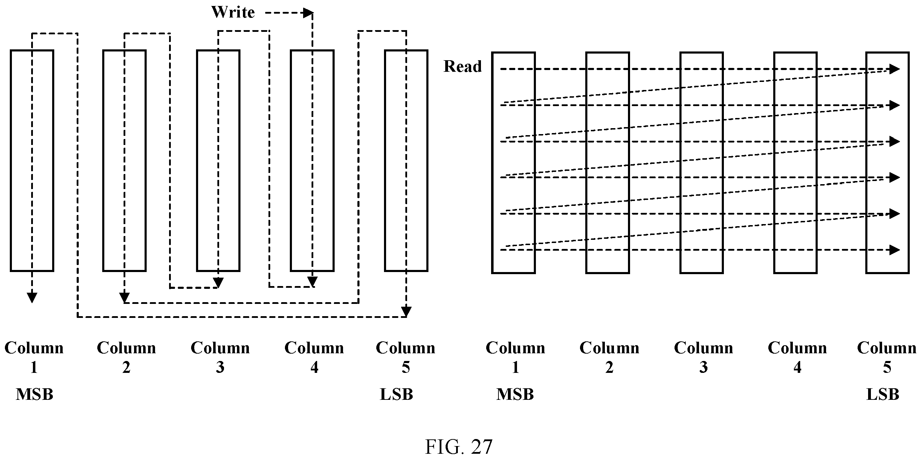

FIG. 27 shows a pattern of column-by-column writing and row-by-row reading by the transmitting apparatus in the manner 33. It is assumed that the to-be-interleaved bits are $a_0a_1a_2a_3a_4a_5a_6a_7a_8a_9a_{10}a_{11}a_{12}a_{13}a_{14}$, and the system bits are $a_0a_1a_2$ . According to the interleaving pattern shown in FIG. 27, after the transmitting apparatus writes the to-be-interleaved bits onto the first matrix column by column, $a_0a_1a_2$ are written onto the fourth column of the first matrix, $a_3a_4a_5$ are written onto the third column, $a_6a_7a_8$ are written onto the second column, $a_9a_{10}a_{11}$ are written onto the fifth column, and $a_{13}a_{14}a_{15}$ are written onto the first column. Then, $a_{13}a_6a_3a_0a_9$ are read from the first row, $a_{14}a_7a_4a_1a_{10}$ are read from the second row, and $a_{15}a_8a_5a_2a_{11}$ are read from the third row.

Manner 34: The first order is the fourth column to the second column to the third column to the fifth column to the first column of the first matrix, and may be represented as [W-4 2 3 5 1]. The second order is the first column to the second column to the third column to the fourth column to the fifth column of the first matrix, and may be represented as [R-1 2 3 4 5].

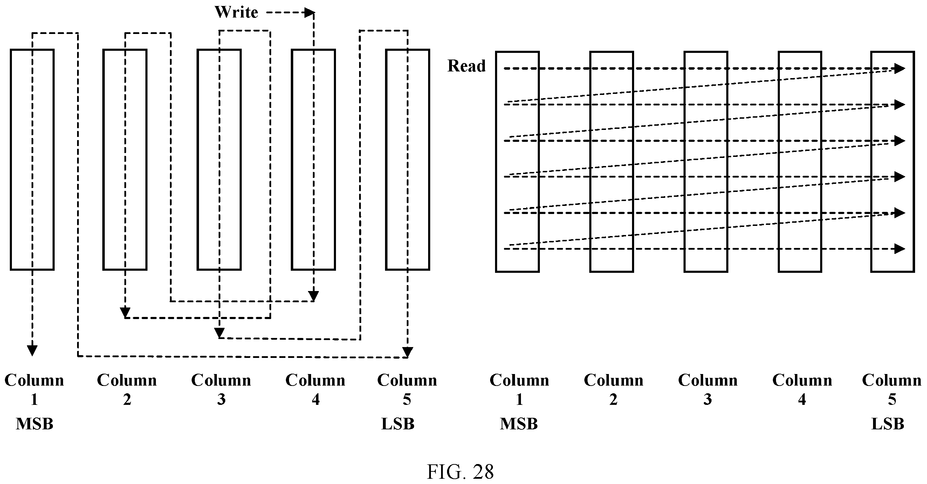

FIG. 28 shows a pattern of column-by-column writing and row-by-row reading by the transmitting apparatus in the manner 34. It is assumed that the to-be-interleaved bits are $a_0a_1a_2a_3a_4a_5a_6a_7a_8a_9a_{10}a_{11}a_{12}a_{13}a_{14}$, and the system bits are $a_0a_1a_2$. According to the interleaving pattern shown in FIG. 28, after the transmitting apparatus writes the to-be-interleaved bits onto the first matrix column by column, $a_0a_1a_2$ are written onto the fourth column of the first matrix, $a_3a_4a_5$ are written onto the second column, $a_6a_7a_8$ are written onto the third column, $a_9a_{10}a_{11}$ are written onto the fifth column, and $a_{13}a_{14}a_{15}$ are written onto the first column. Then, $a_{13}a_3a_6a_0a_9$ are read from the first row, $a_{14}a_4a_7a_1a_{10}$ are read from the second row, and $a_{15}a_5a_8a_2a_{11}$ are read from the third row.

Based on the foregoing manners 32, 33, and 34, the system bit may alternatively be mapped to the bit 1 for transmission, so that transmission reliability of the system bit can be improved, thereby improving system decoding performance.

Optionally, if the modulation type used by the transmitting apparatus is a derivation manner based on DVB-S2, the first order or the second order may alternatively be correspondingly changed to adapt to the derivation manner, so that the system bit can be mapped to a bit with high reliability for transmission.

For example, DVB-S2 8PSK is used as an example. If the derivation manner is to swap a value of the bit 2 and a value of the bit 1 in the constellation diagram shown in FIG. 1, the first order corresponding to the derivation manner may be an order obtained after orders of columns corresponding to the bit 2 and the bit 1 in the first order corresponding to DVB-S2 8PSK are swapped. For example, in the foregoing manner 11, the first order corresponding to DVB-S2 8PSK is the third column to the second column to the first column, and the third column to the second column to the first column respectively correspond to the bit 0, the bit 1, and the bit 2 of DVB-S2 8PSK. After swapping, the first order corresponding to the derivation manner may be: the third column to the first column to the second column. The second order is still the first column to the second column to the third column of the first matrix. In other words, the first order changes with swapping of values of different bits corresponding to each constellation point, and the second order remains unchanged.

Alternatively, the second order may be changed in a similar manner with swapping of values of different bits corresponding to each constellation point, and the first order remains unchanged.

For example, DVB-S2 8PSK is used as an example. If the derivation manner is to swap a value of the bit 2 and a value of the bit 1 in the constellation diagram shown in FIG. 1, the second order corresponding to the derivation manner may be an order obtained after orders of columns corresponding to the bit 2 and the bit 1 in the first order corresponding to DVB-S2 8PSK are swapped. For example, in the foregoing manner 11, the second order corresponding to DVB-S2 8PSK is the first column to the second column to the third column, and the first column to the second column to the third column respectively correspond to the bit 2, the bit 1, and the bit 0 of DVB-S2 8PSK. After swapping, the second order corresponding to the derivation manner may be the second column to the first column to the third column. The first order remains unchanged.

In the foregoing embodiment, this application proposes a new interleaving manner. When the interleaving manner is used in combination with a modulation type in satellite communication, the system bit may be mapped to a bit with high reliability for transmission, thereby improving transmission reliability and system decoding performance.

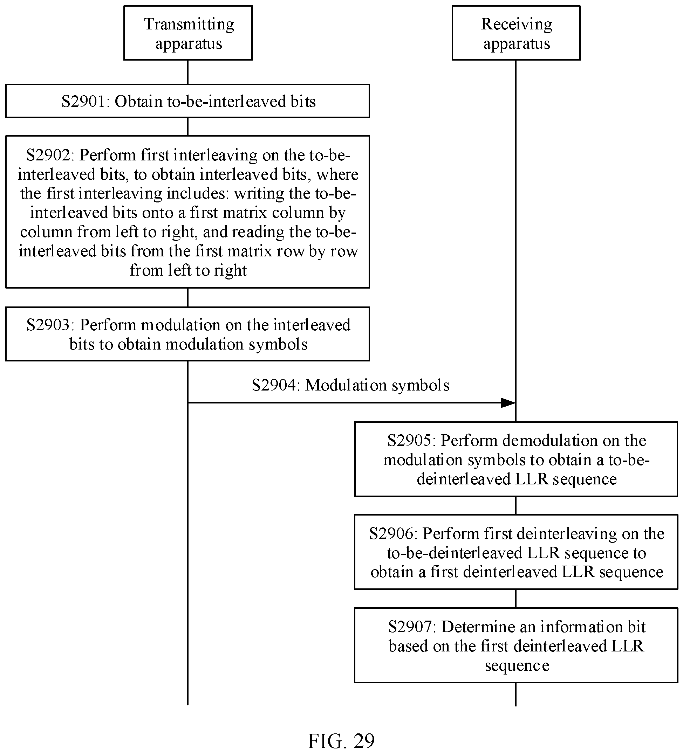

FIG. 29 shows another data processing method according to an embodiment of this application, including an interleaving and modulation method applied to a transmitting apparatus and a deinterleaving and demodulation method applied to a receiving apparatus. The method includes the following steps.

S2901: The transmitting apparatus obtains to-be-interleaved bits.

Optionally, the to-be-interleaved bits may be coded bits. Alternatively, the to-be-interleaved bits are bits obtained after second interleaving is performed on the coded bits. Reference can be made to related descriptions in step S1401. Details are not described herein again.

S2902: The transmitting apparatus performs first interleaving on the to-be-interleaved bits, to obtain interleaved bits.

The first interleaving includes: writing the to-be-interleaved bits onto a first matrix column by column left to right, and reading the to-be-interleaved bits from the first matrix row by row from left to right. In this scenario, a quantity of columns of the first matrix is a modulation order M, and M is greater than or equal to 3. A first bit read row by row is an MSB, and an $M^{th}$ bit read row by row is an LSB. For a quantity of rows of the first matrix, refer to related descriptions in step S1402. Details are not described herein again.

S2903: The transmitting apparatus performs modulation on the interleaved bits to obtain modulation symbols.

A constellation diagram used for the modulation includes $2^M$ constellation points, the $2^M$ constellation points are distributed on N rings, a constellation point on at least one of the N rings meets a Gray mapping principle, and N is a positive integer.

S2904: The transmitting apparatus sends the modulation symbol. Correspondingly, the receiving apparatus receives the modulation symbol.

For related implementation of step S2904, refer to detailed descriptions in step S1404. Details are not described herein again.

S2905: The receiving apparatus performs demodulation on the modulation symbols to obtain a to-be-deinterleaved LLR sequence.

It may be understood that a constellation diagram of a modulation type corresponding to the demodulation is the constellation diagram described in step S2903.

S2906: The receiving apparatus performs first deinterleaving on the to-be-deinterleaved LLR sequence, to obtain a first deinterleaved LLR sequence.

The first deinterleaving includes: writing the to-be-deinterleaved LLR sequence onto a second matrix row by row from left to right, and reading the to-be-deinterleaved LLR sequence from the second matrix column by column from left to right. A quantity of columns of the second matrix is a modulation order M. For a quantity of rows of the second matrix, refer to related descriptions of the first matrix. Details are not described herein again. A first bit written row by row is an MSB, and an $M^{th}$ bit written row by row is an LSB.

S2907: The receiving apparatus determines an information bit based on the deinterleaved first LLR sequence.

For related implementation of step S2907, refer to detailed descriptions in step S1407. Details are not described herein again.

The following separately describes in detail constellation diagrams in S2903 when the transmitting apparatus uses the first interleaving and the modulation order M is equal to 3, 4, or 5.

When the modulation order M is equal to 3, the constellation diagram in step S2903 includes eight constellation points, and the eight constellation points are evenly distributed on one ring. For example, distribution of the 8 constellation points may be implemented in the following four manners.

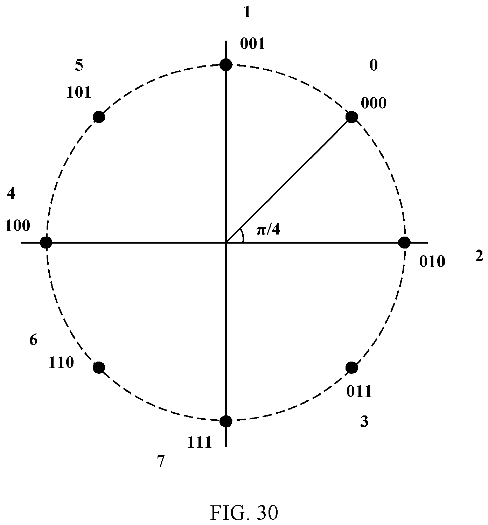

Manner 41: As shown in FIG. 30, a phase corresponding to a first constellation point is $\pi/4$. Bits corresponding to the first constellation point are 000. By using the first constellation point as a reference, bits corresponding to the remaining seven constellation points in a clockwise direction are respectively 010, 011, 111, 110, 100, 101, and 001.

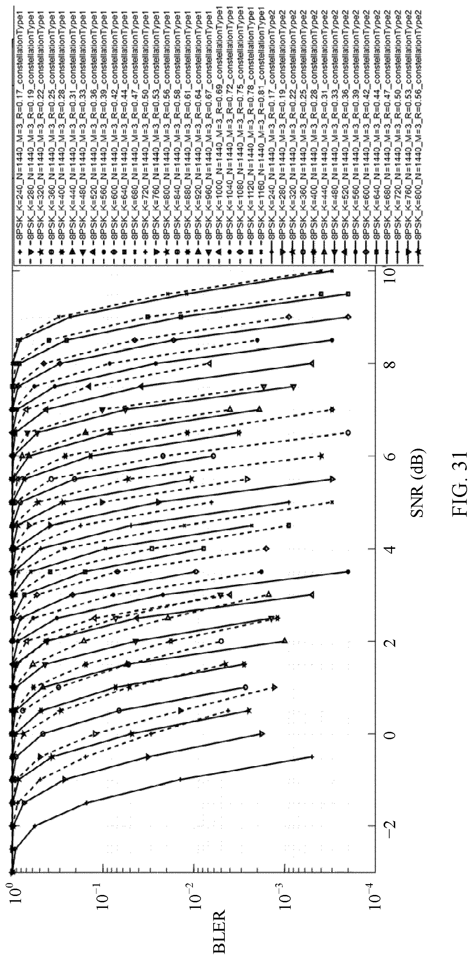

As shown in FIG. 31, in a case in which the first interleaving described in step S2902 is used, performance comparison between a BLER generated when DVB-S2 8PSK shown in FIG. 2 is used and a BLER generated when the constellation diagram shown in the manner 41 is used. Simulation conditions are shown in Table 5 below.

**Table 5**

| Channel (Channel) | AWGN |
|---|---|
| Interleaver (Interleaver) | First interleaving in step S2902 |
| Transport block size (including 16-bit CRC) | 240:40:1160 |
| Coded LDPC length (Coded LDPC length) | 1440 |
| Channel estimation (Channel estimation) | Ideal (Ideal) |
| Modulation type (Modulation type) | 8PSK |
| Constellation diagram | ConstellationType1 represents the constellation diagram shown in FIG. 2 |

(continued)

| Channel (Channel) | AWGN |
|---|---|
| | ConstellationType2 represents a constellation diagram shown in FIG. 30 |

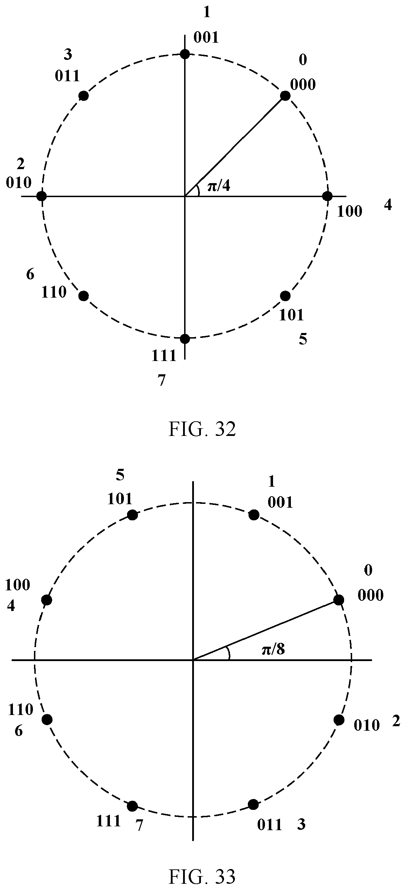

For related parameters in Table 5 and FIG. 32, refer to related descriptions in Table 2 and FIG. 16a. Details are not described herein again. It can be learned from FIG. 32 that, under a same BLER, an SNR of the constellation diagram shown in FIG. 30 is 0.1-1.2 dB lower than that of the constellation diagram shown in FIG. 2, that is, BLER performance may be improved by 0.1-1.2 dB when the constellation diagram shown in FIG. 30 is used.

Manner 42: As shown in FIG. 32, a phase corresponding to the first constellation point is $\pi/4$. Bits corresponding to the first constellation point are 000. By using the first constellation point as a reference, bits corresponding to the remaining seven constellation points in a clockwise direction are respectively 100, 101, 111, 110, 010, 011, and 001.

Manner 43: As shown in FIG. 33, a phase corresponding to the first constellation point is $\pi/8$. Bits corresponding to the first constellation point are 000. By using the first constellation point as a reference, bits corresponding to the remaining seven constellation points in a clockwise direction are respectively 010, 011, 111, 110, 100, 101, and 001.

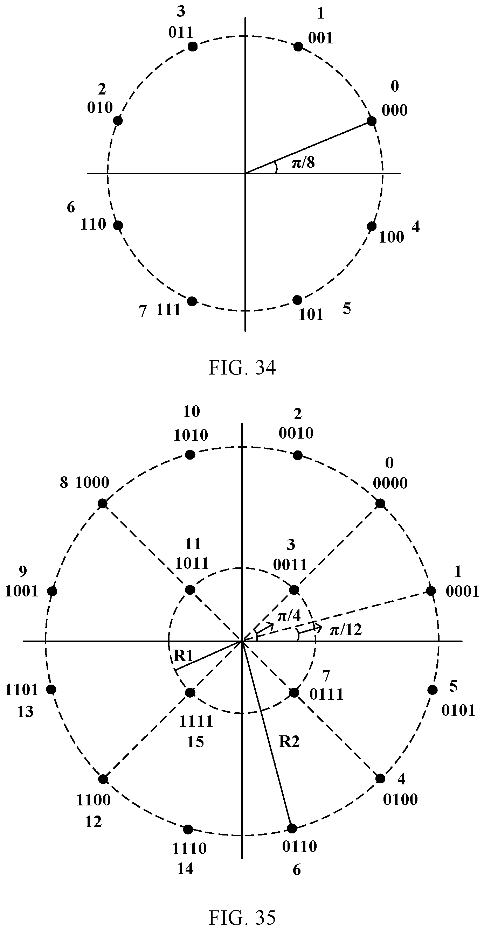

Manner 44: As shown in FIG. 34, a phase corresponding to the first constellation point is $\pi/8$ . Bits corresponding to the first constellation point are 000. By using the first constellation point as a reference, bits corresponding to the remaining seven constellation points in a clockwise direction are respectively 100, 101, 111, 110, 010, 011, and 001.

It may be understood that, in the constellation diagrams described in the manner 41, the manner 42, the manner 43, and the manner 44, constellation points on a first ring meet the Gray mapping principle.

When the modulation order M is equal to 4, the constellation diagram in step S2903 includes 16 constellation points, four constellation points of the 16 constellation points are evenly distributed on the first ring, and the other 12 constellation points are evenly distributed on a second ring. The first ring and the second ring are concentric rings. A phase corresponding to a first constellation point on the first ring and a phase corresponding to a second constellation point on the second ring are $\pi/4$.

For example, distribution of the 16 constellation points may be implemented in the following four manners.

Manner 51: As shown in FIG. 35, bits corresponding to the first constellation point are 0011, and by using the first constellation point as a reference, bits corresponding to the remaining three constellation points on the first ring in a clockwise direction are respectively 0111, 1111, and 1011.

Bits corresponding to the second constellation point are 0000, and by using the second constellation point as a reference, bits corresponding to the remaining 11 constellation points on the second ring in a clockwise direction are respectively 0001, 0101, 0100, 0110, 1110, 1100, 1101, 1001, 1000, 1010 and 0010.

As shown in FIG. 35, phases corresponding to 0011 and 0000 are $\pi/4$, and a phase corresponding to 0001 is $\pi/12$. R1 represents a radius of the first ring, and R2 represents a radius of the second ring.

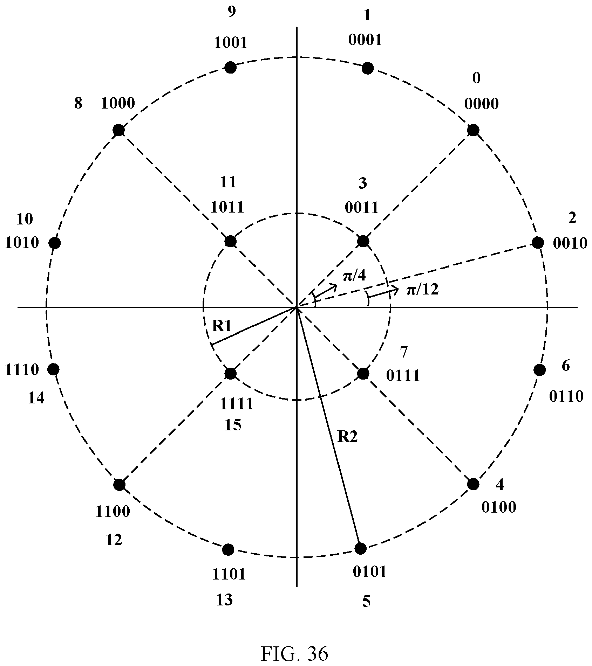

Manner 52: As shown in FIG. 36, bits corresponding to the first constellation point are 0011, and by using the first constellation point as a reference, bits corresponding to the remaining three constellation points on the first ring in a clockwise direction are respectively 0111, 1111, and 1011.

Bits corresponding to the second constellation point are 0000, and by using the second constellation point as a reference, bits corresponding to the remaining 11 constellation points on the second ring in a clockwise direction are respectively 0010, 0110, 0100, 0101, 1101, 1100, 1110, 1010, 1000, 1001 and 0001.

As shown in FIG. 36, phases corresponding to 0011 and 0000 are $\pi/4$, and a phase corresponding to 0010 is $\pi/12$. R1 represents a radius of the first ring, and R2 represents a radius of the second ring. The constellation diagram shown in FIG. 36 may be obtained by swapping values of a bit 0 and a bit 1 in the constellation diagram shown in FIG. 35.

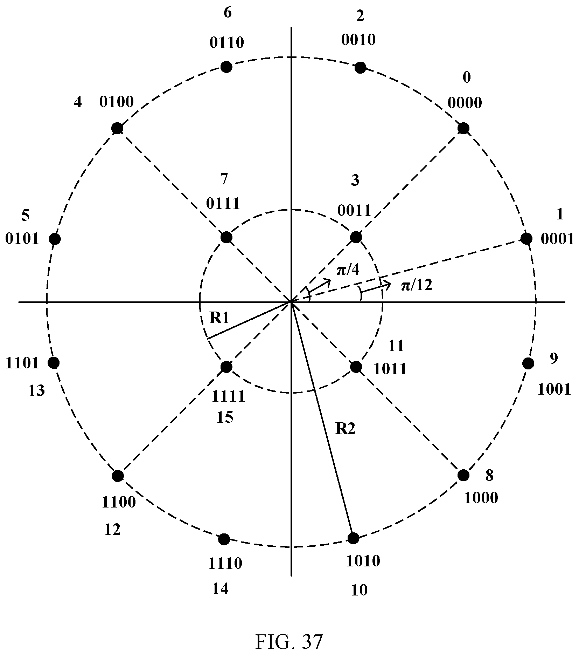

Manner 53: As shown in FIG. 37, bits corresponding to the first constellation point are 0011, and by using the first constellation point as a reference, bits corresponding to the remaining three constellation points on the first ring in a clockwise direction are respectively 1011, 1111, and 0111.

Bits corresponding to the second constellation point are 0000, and by using the second constellation point as a reference, bits corresponding to the remaining 11 constellation points on the second ring in a clockwise direction are respectively 0001, 1001, 1000, 1010, 1110, 1100, 1101, 0101, 0100, 0110 and 0010.

As shown in FIG. 37, phases corresponding to 0011 and 0000 are $\pi/4$, and a phase corresponding to 0001 is $\pi/12$. R1 represents a radius of the first ring, and R2 represents a radius of the second ring. The constellation diagram shown in FIG. 37 may be obtained by swapping values of a bit 2 and a bit 3 in the constellation diagram shown in FIG. 35.

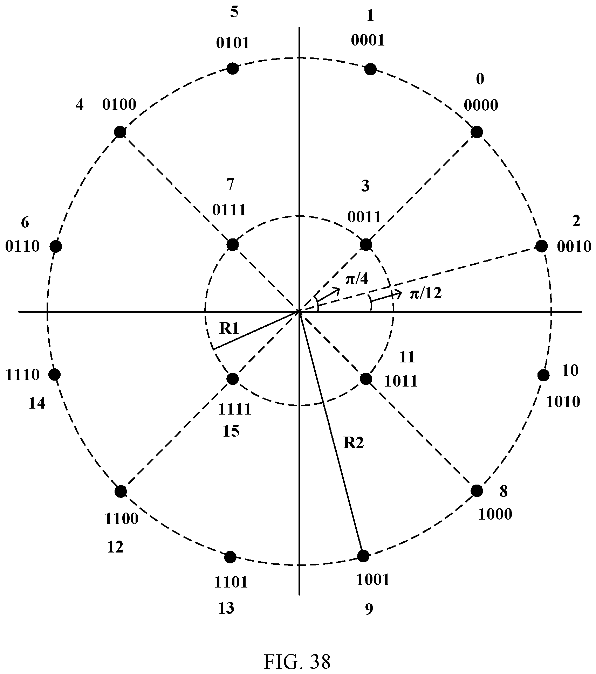

Manner 54: As shown in FIG. 38, bits corresponding to the first constellation point are 0011, and by using the first constellation point as a reference, bits corresponding to the remaining three constellation points on the first ring in a clockwise direction are respectively 1011, 1111, and 0111.

Bits corresponding to the second constellation point are 0000, and by using the second constellation point as a reference, bits corresponding to the remaining 11 constellation points on the second ring in a clockwise direction are respectively 0010, 1010, 1000, 1001, 1101, 1100, 1110, 0110, 0100, 0101 and 0001.

As shown in FIG. 38, phases corresponding to 0011 and 0000 are $\pi / 4$, and a phase corresponding to 0010 is $\pi /12$. R1 represents a radius of the first ring, and R2 represents a radius of the second ring. The constellation diagram shown in FIG. 38 may be obtained by swapping the values of the bit 0 and the bit 1 and the values of the bit 2 and the bit 3 in the constellation diagram shown in FIG. 35.

It may be understood that, in the constellation diagrams described in the manner 51, the manner 52, the manner 53, and the manner 54, constellation points on the first ring and the second ring all meet the Gray mapping principle.

When the modulation order M is equal to 5, the constellation diagram in step S2903 includes 32 constellation points, four constellation points of the 32 constellation points are evenly distributed on the first ring, other 12 constellation points are evenly distributed on the second ring, and the remaining 16 constellation points are evenly distributed on a third ring. The first ring, the second ring, and the third ring are concentric rings. Phases corresponding to the first constellation point on the first ring, the second constellation point on the second ring, and a third constellation point on the third ring are $\pi / 4$. For example, distribution of the 32 constellation points may be implemented in the following four manners.

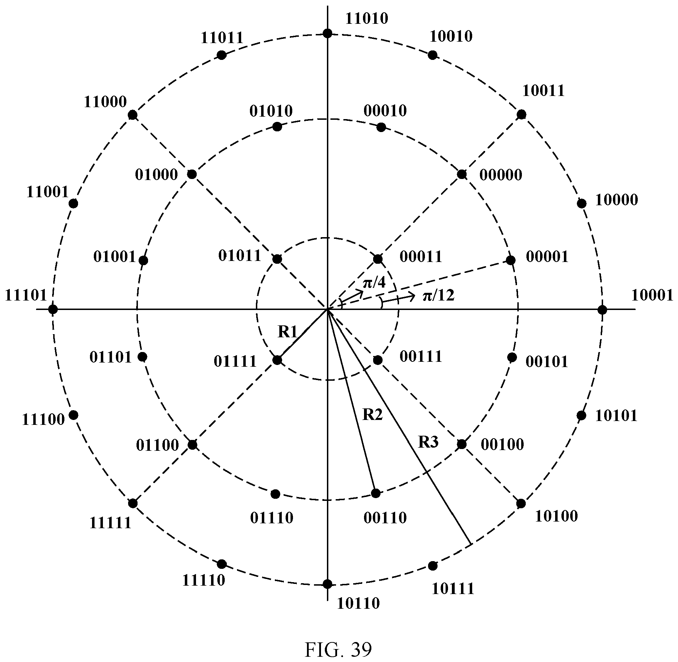

Manner 61: As shown in FIG. 39, bits corresponding to the first constellation point are 00011, and by using the first constellation point as a reference, bits corresponding to the remaining three constellation points on the first ring in a clockwise direction are respectively 00111, 01111, and 01011.

Bits corresponding to the second constellation point are 00000, and by using the second constellation point as a reference, bits corresponding to the remaining 11 constellation points on the second ring in a clockwise direction are respectively 00001, 00101, 00100, 00110, 01110, 01100, 01101, 01001, 01000, 01010 and 00010.

Bits corresponding to the third constellation point are 10011, and by using the third constellation point as a reference, bits corresponding to the remaining 15 constellation points on the third ring in a clockwise direction are respectively 10000, 10001, 10101, 10100, 10111, 10110, 11110, 11111, 11100, 11101, 11001, 11000, 11011, 11010 and 10010.

As shown in FIG. 39, phases corresponding to 00011, 00000, and 10011 are $\pi / 4$, and a phase corresponding to 00001 is $\pi /12$. R1 represents a radius of the first ring, R2 represents a radius of the second ring, and R3 represents a radius of the third ring.

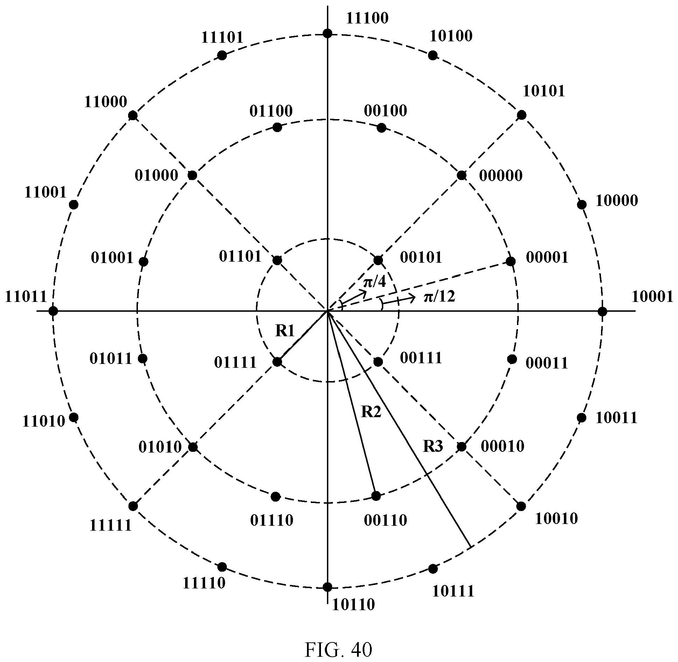

Manner 62: As shown in FIG. 40, bits corresponding to the first constellation point are 00101, and by using the first constellation point as a reference, bits corresponding to the remaining three constellation points on the first ring in a clockwise direction are respectively 00111, 01111, and 01101.

Bits corresponding to the second constellation point are 00000, and by using the second constellation point as a reference, bits corresponding to the remaining 11 constellation points on the second ring in a clockwise direction are respectively 00001, 00011, 00010, 00110, 01110, 01010, 01011, 01001, 01000, 01100 and 00100.

Bits corresponding to the third constellation point are 10101, and by using the third constellation point as a reference, bits corresponding to the remaining 15 constellation points on the third ring in a clockwise direction are respectively 10000, 10001, 10011, 10010, 10111, 10110, 11110, 11111, 11010, 11011, 11001, 11000, 11101, 11100 and 10100.

As shown in FIG. 40, phases corresponding to 00101, 00000, and 10101 are $\pi / 4$, and a phase corresponding to 00001 is $\pi /12$. R1 represents a radius of the first ring, R2 represents a radius of the second ring, and R3 represents a radius of the third ring. The constellation diagram shown in FIG. 40 may be obtained by swapping values of a bit 2 and a bit 1 in the constellation diagram shown in FIG. 39.

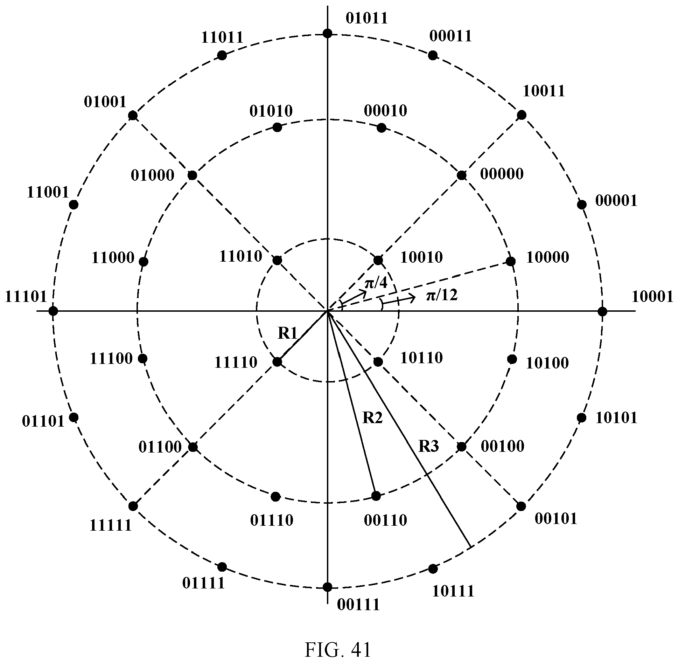

Manner 63: As shown in FIG. 41, bits corresponding to the first constellation point are 10010, and by using the first constellation point as a reference, bits corresponding to the remaining three constellation points on the first ring in a clockwise direction are respectively 10110, 11110, and 11010.

Bits corresponding to the second constellation point are 00000, and by using the second constellation point as a reference, bits corresponding to the remaining 11 constellation points on the second ring in a clockwise direction are respectively 10000, 10100, 00100, 00110, 01110, 01100, 11100, 11000, 01000, 01010 and 00010.

Bits corresponding to the third constellation point are 10011, and by using the third constellation point as a reference, bits corresponding to the remaining 15 constellation points on the third ring in a clockwise direction are respectively 00001, 10001, 10101, 00101, 10111, 00111, 01111, 11111, 01101, 11101, 11001, 01001, 11011, 01011 and 00011.

As shown in FIG. 41, phases corresponding to 10010, 00000, and 10011 are $\pi / 4$, and a phase corresponding to 10000 is $\pi /12$. R1 represents a radius of the first ring, R2 represents a radius of the second ring, and R3 represents a radius of the third ring. The constellation diagram shown in FIG. 41 may be obtained by swapping values of a bit 0 and a bit 4 in the constellation diagram shown in FIG. 39.

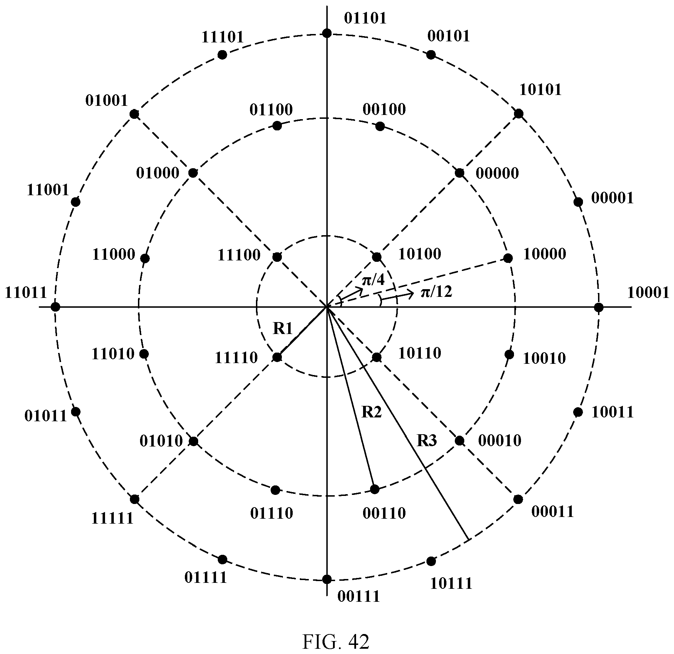

Manner 64: As shown in FIG. 42, bits corresponding to the first constellation point are 10100, and by using the first constellation point as a reference, bits corresponding to the remaining three constellation points on the first ring in a clockwise direction are respectively 10110, 11110, and 11100.

Bits corresponding to the second constellation point are 00000, and by using the second constellation point as a reference, bits corresponding to the remaining 11 constellation points on the second ring in a clockwise direction are respectively 10000, 10010, 00010, 00110, 01110, 01010, 11010, 11000, 01000, 01100 and 00100.

Bits corresponding to the third constellation point are 10101, and by using the third constellation point as a reference, bits corresponding to the remaining 15 constellation points on the third ring in a clockwise direction are respectively 00001, 10001, 10011, 00011, 10111, 00111, 01111, 11111, 01011, 11011, 11001, 01001, 11101, 01101 and 00101.

As shown in FIG. 42, phases corresponding to 10100, 00000, and 10101 are $\pi/4$, and a phase corresponding to 10000 is $\pi/12$. R1 represents a radius of the first ring, R2 represents a radius of the second ring, and R3 represents a radius of the third ring. The constellation diagram shown in FIG. 42 may be obtained by swapping the values of the bit 0 and the bit 4 and the values of the bit 2 and the bit 1 in the constellation diagram shown in FIG. 39.

It may be understood that, in the constellation diagrams described in the manner 61, the manner 62, the manner 63, and the manner 64, constellation points on the first ring and the second ring meet the Gray mapping principle.

In the embodiment shown in FIG. 29, a new modulation type (or a constellation mapping mode) is proposed. When the modulation type is used in combination with an interleaving manner (that is, writing from left to right column by column, and reading from left to right row by row) in NR, the modulation type may have high BLER performance, thereby improving transmission reliability and system decoding performance.

Optionally, the second interleaving in step S1401 and step S2901 may include: performing random interleaving or pseudo-random interleaving on the last N-X bits of the coded bits. X is greater than or equal to a quantity of system bits, and N is a quantity of coded bits. That is, in the second interleaving, the first X bits do not participate in interleaving, and a sequence remains unchanged. For example, when a code rate is low, for example, the code rate is lower than 1/5, X may be equal to N divided by the modulation order M.

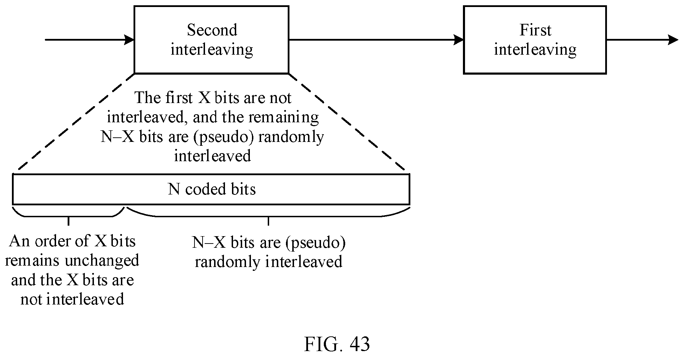

In other words, as shown in FIG. 43, the transmitting apparatus performs interleaving on the coded bits twice to obtain the interleaved bits. Subsequently, modulation is performed on the interleaved bits.

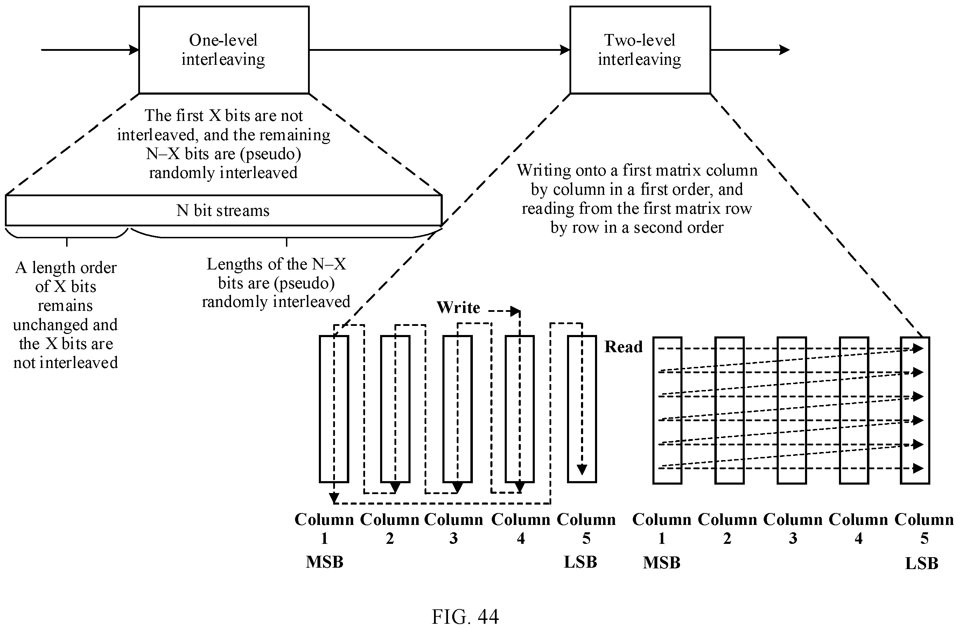

It may be understood that the first interleaving may be the interleaving manner described in step S1401. Correspondingly, the modulation type in DVB-S2 is used. For example, as shown in FIG. 44, when the modulation order M is equal to 5, the foregoing manner 31 is used for the first interleaving. Alternatively, the first interleaving may be the interleaving manner described in step S2901. Correspondingly, the modulation type described in step S2903 is used.

For example, a quantity K of system bits is equal to 352, a quantity N of coded bits is equal to 2640, and the modulation order M is equal to 5. Assuming that $X = N / M = 528$, an order of the first 528 coded bits remains unchanged, and pseudo-random interleaving is performed on the last $N - X = 2112$ coded bits.

During pseudo-random interleaving, the transmitting apparatus may segment the last 2112 bits, each bit segment includes Y (300 is used as an example) bits, a quantity of segments is $\lfloor 2112 / 300 \rfloor = 7$, and remaining 2112-300×7=12 bits obtained after segmentation may not be interleaved. Finally, the first 528 bits, 2100 bits obtained after segment-based pseudo-random interleaving, and remaining 12 bits that are not interleaved are used as to-be-interleaved bits.

Optionally, the transmitting apparatus and the receiving apparatus may negotiate to agree on or set a pseudo-random interleaving sequence. For example, when a segment length is 300, a pseudo-random interleaving order used by the transmitting apparatus may be shown as follows, where a number is an index of a bit, and is used to indicate a location of the bit. For example, 123 represents the 123rd bit in the 300 bits, and 99 represents the 99th bit in the 300 bits.

[123, 99, 174, 294, 244, 281, 32, 40, 22, 261, 175, 34, 152, 92, 170, 91, 146, 119, 190, 112, 127, 241, 165, 35, 6, 265, 121, 271, 228, 160, 236, 55, 148, 3, 96, 166, 136, 269, 68, 16, 140, 135, 69, 115, 11, 101, 54, 105, 296, 176, 218, 30, 133, 291, 186, 149, 224, 45, 184, 216, 77, 280, 211, 235, 60, 217, 219, 113, 214, 254, 171, 249, 147, 292, 150, 163, 74, 78, 72, 62, 70, 229, 129, 266, 232, 242, 107, 134, 51, 33, 7, 86, 182, 237, 212, 196, 221, 103, 38, 238, 278, 267, 100, 157, 58, 76, 205, 143, 81, 172, 259, 187, 159, 202, 89, 42, 162, 28, 258, 128, 145, 164, 230, 151, 17, 239, 223, 131, 220, 194, 41, 227, 120, 47, 195, 111, 180, 250, 98, 213, 300, 80, 284, 14, 193, 247, 255,156,46,295,155,273,56,283,299,63,240,197,198,144,253,104,93,204,117,252, 8, 181, 67, 84, 139, 208, 90, 97, 169, 290, 248, 138, 83, 59, 210, 231, 106, 233, 286, 79, 287, 142, 209, 256, 188, 5, 201, 48, 179, 177, 272, 108, 53, 29, 21, 25, 257, 52, 268, 185, 109, 37, 279, 64, 31, 49, 234, 298, 275, 270, 246, 178, 27, 282, 183, 110, 61, 88, 50, 87, 26, 43, 124, 192, 274, 94, 189, 161, 19, 102, 200, 44, 264, 130, 15, 243, 289, 203, 73, 1, 125, 199, 173, 36, 116, 82, 71, 215, 23, 141, 288, 126, 137, 207, 262, 293, 65, 277, 158, 153, 276, 285, 225, 2, 132, 263, 114, 4, 18, 85, 222, 245, 75, 191, 24, 95, 206, 167, 154, 39, 168, 13, 9, 66, 20, 57, 122, 251, 10, 12, 297, 226, 260, 118].

Based on the second interleaving, the second deinterleaving in step S1407 and step S2907 may include: performing deinterleaving on the last N-X elements of the first LLR sequence in a preset order. The preset order is an order of pseudo-random interleaving or random interleaving used by the transmitting end.

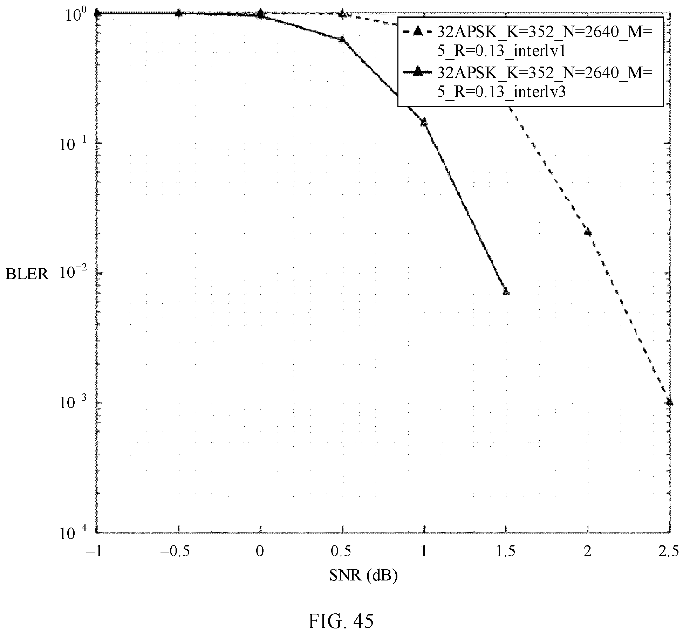

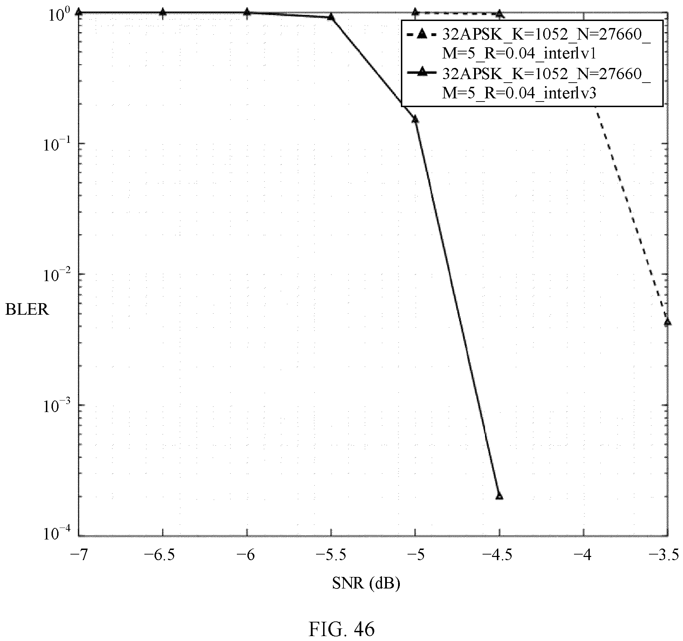

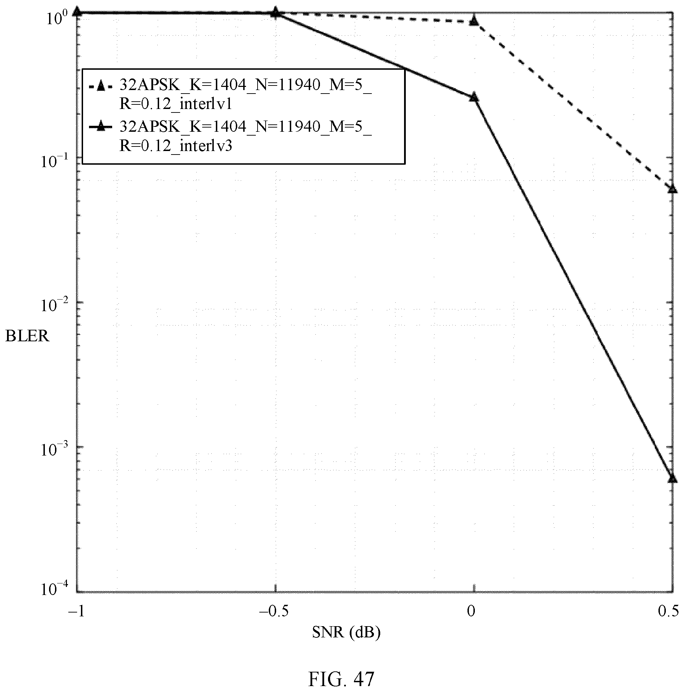

As shown in FIG. 45, FIG. 46, and FIG. 47, a BLER performance simulation result is shown when the modulation order M is equal to 5 and the transmitting end performs second interleaving and first interleaving on coded bits by using 32APSK modulation. Simulation conditions are shown in Table 6 below.

**Table 6**

| Channel (Channel) | AW GN |
|---|---|
| Interleaver (Interleaver) | Interlv1 indicates an NR interleaver<br>Interlv2 indicates an interleaver that implements the manner shown in FIG. 44 |
| Transport block size (including 16-bit CRC) | FIG. 45: 352<br><br>FIG. 46: 1052<br>FIG. 47: 1404 |
| Coded LDPC length (Coded LDPC length) | FIG. 45: 2640<br><br>FIG. 46: 27660<br>FIG. 47: 11940 |
| Channel estimation (Channel estimation) | Ideal (Ideal) |
| Modulation type (Modulation type) | 32APSK |
| Constellation diagram | Constellation diagram shown in FIG. 3 |

For related parameters in Table 6, FIG. 45, FIG. 46, and FIG. 47, refer to related descriptions in Table 2 and FIG. 16a. Details are not described herein again. It can be learned from

FIG. 45, FIG. 46, and FIG. 47 that, under a same BLER, an SNR in the interleaving manner shown in FIG. 44 is 0.5-1 dB lower than that of the NR interleaving manner, that is, BLER performance may be improved by 0.5-1 dB when the interleaving manner shown in FIG. 44 is used.

In addition, Table 7 shows mapping probabilities of different constellation points in a scenario in which a modulation symbol is obtained, after LDPC coding, second interleaving, and first interleaving are performed on a system bit to which CRC is added and scrambling is performed, through mapping by using the constellation diagram shown in FIG. 3.

**Table 7**

| Constellation point | Probability (%) | Constellation point | Probability (%) | Constellation point | Probability (%) | Constellation point | Probability (%) |
|---|---|---|---|---|---|---|---|
| 0 | 3.14 | 8 | 3.09 | 16 | 3.12 | 24 | 3.12 |
| 1 | 3.11 | 9 | 3.16 | 17 | 3.12 | 25 | 3.11 |
| 2 | 3.11 | 10 | 3.14 | 18 | 3.11 | 26 | 3.15 |
| 3 | 3.15 | 11 | 3.13 | 19 | 3.09 | 27 | 3.13 |
| 4 | 3.10 | 12 | 3.12 | 20 | 3.13 | 28 | 3.12 |
| 5 | 3.12 | 13 | 3.14 | 21 | 3.14 | 29 | 3.14 |
| 6 | 3.09 | 14 | 3.13 | 22 | 3.12 | 30 | 3.10 |
| 7 | 3.15 | 15 | 3.15 | 23 | 3.14 | 31 | 3.13 |

Table 8 shows mapping probabilities of different constellation points in a scenario in which a modulation symbol is obtained, after LDPC coding and NR interleaving and scrambling are performed on a system bit to which the CRC is added, through mapping by using the constellation diagram shown in FIG. 3. In Table 7 and Table 8, quantities K of system bits is equal to 1404 (including a 16-bit CRC), and quantities N of coded bits is equal to 11940. A BG2 matrix is used for LDPC coding.

Table 8

| Constellation point | Probability (%) | Constellation point | Probability (%) | Constellation point | Probability (%) | Constellation point | Probability (%) |
|---|---|---|---|---|---|---|---|
| 0 | 4.03 | 8 | 2.97 | 16 | 3.04 | 24 | **2.46** |
| 1 | 2.98 | 9 | 4.02 | 17 | 2.45 | 25 | 3.06 |
| 2 | 3.04 | 10 | 2.46 | 18 | 4.03 | 26 | 3.01 |
| 3 | **2.45** | 11 | 3.02 | 19 | 2.99 | 27 | 4.01 |
| 4 | 4.01 | 12 | 2.98 | 20 | 3.05 | 28 | **2.45** |
| 5 | 2.98 | 13 | **4.00** | 21 | 2.46 | 29 | 3.03 |
| 6 | 3.04 | 14 | 2.45 | 22 | 4.02 | 30 | 2.99 |
| 7 | **2.45** | 15 | **3.04** | 23 | 2.97 | 31 | **4.02** |

It can be learned from Table 8 that a fluctuation range of mapping probabilities of the 32 constellation points is 2.45%-4.02%. That is, a mapping probability distribution difference is large, and there is a problem of uneven constellation mapping. Consequently, system decoding performance deteriorates.

It can be learned from Table 7 that, when interleaving is performed twice, mapping probabilities of the 32 constellation points are similar, and a fluctuation range is 3.09%-3.16%, which is greatly improved compared with a result shown in Table 7. In other words, performing interleaving twice can reduce a fluctuation range of a mapping probability of a constellation point, and improve decoding performance.

It may be understood that, in the foregoing embodiments, the method and/or the step implemented by the receiving apparatus may also be implemented by a component (for example, a processor, a chip, a chip system, a circuit, a logical module, or software) that can be used in the receiving apparatus; and the method and/or the step implemented by the transmitting apparatus may also be implemented by a component (for example, a processor, a chip system, a circuit, a logical module, or software) that can be used in the transmitting apparatus.

The foregoing mainly describes, from a perspective of interaction between the apparatuses, the solutions provided in this application. Correspondingly, this application further provides a communication apparatus, and the communication apparatus is configured to implement the foregoing methods. The communication apparatus may be the receiving apparatus in the foregoing method embodiment, a device including the receiving apparatus, or a component that may be used in the receiving apparatus. Alternatively, the communication apparatus may be the transmitting apparatus in the foregoing method embodiment, a device including the transmitting apparatus, or a component that may be used in the transmitting apparatus.

It may be understood that to implement the foregoing functions, the communication apparatus includes a hardware structure and/or a software module for performing a corresponding function. A person skilled in the art should be easily aware that, with reference to units and algorithm steps in the examples described in embodiments disclosed in this specification, this application can be implemented in a form of hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the communication apparatus may be divided into functional modules based on the foregoing method embodiments. For example, each functional module may be obtained through division based on each corresponding function, or two or more functions may be integrated into one processing module. The integrated module may be implemented in a form of hardware, or may be implemented in a form of a software functional module. It should be noted that, in embodiments of this application, division into the modules is an example, and is merely logical function division and may be other division during actual implementation.

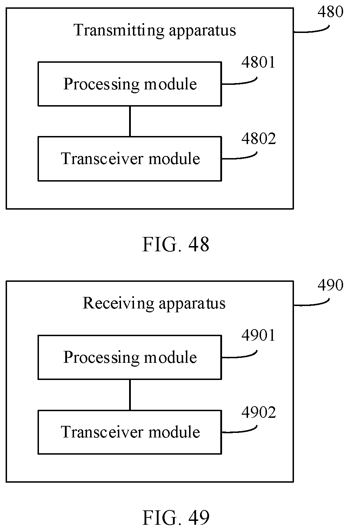

In an implementation scenario, an example in which the communication apparatus is the transmitting apparatus in the foregoing method embodiment is used. FIG. 48 is a schematic of a structure of a transmitting apparatus 480. The transmitting apparatus 480 includes a processing module 4801 and a transceiver module 4802.

In some embodiments, the transmitting apparatus 480 may further include a storage module (not shown in FIG. 48), configured to store program instructions and data.

In some embodiments, the transceiver module 4802 may also be referred to as a transceiver unit, and is configured to implement a sending function and/or a receiving function. The transceiver module 4802 may include a transceiver circuit, a transceiver machine, a transceiver, or a communication interface.

In some embodiments, the transceiver module 4802 may include a receiving module and a sending module, respectively configured to perform receiving-type steps and sending-type steps performed by the transmitting apparatus in the foregoing method embodiments, and/or configured to support another process of the technology described in this specification; and the processing module 4801 may be configured to perform processing-type (for example, determining, obtaining, and generating) steps performed by the transmitting apparatus in the foregoing method embodiments, and/or configured to support another process of the technology described in this specification.

In a possible implementation, the processing module 4801 is configured to obtain to-be-interleaved bits; and the processing module 4801 is further configured to perform first interleaving on the to-be-interleaved bits to obtain interleaved bits. The first interleaving includes: writing the to-be-interleaved bits onto a first matrix column by column in a first order, and reading the to-be-interleaved bits from the first matrix row by row in a second order. A quantity of columns of the first matrix is a modulation order M, M is greater than or equal to 3, a first bit read row by row is a most significant bit MSB, and an $M^{th}$ bit read row by row is a least significant bit LSB. The processing module 4801 is further configured to perform modulation on the interleaved bits to obtain modulation symbols. The transceiver module 4802 is configured to send the modulation symbols.

In another possible implementation, the processing module 4801 is configured to obtain to-be-interleaved bits; and the processing module 4801 is further configured to perform first interleaving on the to-be-interleaved bits to obtain interleaved bits. The first interleaving includes: writing the to-be-interleaved bits onto a first matrix column by column from left to right, and reading the to-be-interleaved bits from the first matrix row by row from left to right. A quantity of columns of the first matrix is a modulation order M, M is greater than or equal to 3, a first bit read row by row is a most significant bit MSB, and an $M^{th}$ bit read row by row is a least significant bit LSB. The processing module 4801 is further configured to perform modulation on the interleaved bits to obtain modulation symbols. A constellation diagram used for the modulation includes $2^M$ constellation points, the $2^M$ constellation points are distributed on N rings, a constellation point on at least one of the N rings meets a Gray mapping principle, and N is a positive integer. The transceiver module 4802 is configured to send the modulation symbols.

All related content of each step involved in the foregoing method embodiment may be referenced to a function description of a corresponding functional module, and details are not described herein again.

In this application, the transmitting apparatus 480 is presented in a form of functional modules obtained through division in an integrated manner. The "module" herein may be an application-specific integrated circuit (application-specific integrated circuit, ASIC), a circuit, a processor and a memory that execute one or more software or firmware programs, an integrated logic circuit, and/or another component that can provide the foregoing functions.

In some embodiments, in hardware implementation, when the transmitting apparatus is a terminal device, a person skilled in the art may figure out that the transmitting apparatus 480 may be in a form of the terminal device 40 shown in FIG. 13.

In an example, functions/implementation processes of the processing module 4801 in FIG. 48 may be implemented by the processor 401 in the terminal device 40 shown in FIG. 13 by invoking the computer-executable instructions stored in the memory 402, and functions/implementation processes of the transceiver module 4802 in FIG. 48 may be implemented by the transceiver 403 in the terminal device 40 shown in FIG. 13.

In some embodiments, in hardware implementation, when the transmitting apparatus is a network device, a person skilled in the art may figure out that the transmitting apparatus 480 may be in a form of the network device 30 shown in FIG. 13.

In an example, functions/implementation processes of the processing module 4801 in FIG. 48 may be implemented by the processor 301 in the network device 30 shown in FIG. 13 by invoking the computer-executable instructions stored in the memory 302, and functions/implementation processes of the transceiver module 4802 in FIG. 48 may be implemented by the transceiver 303 in the network device 30 shown in FIG. 13.

In some embodiments, when the transmitting apparatus 480 in FIG. 48 is a chip or a chip system, a function/implementation process of the transceiver module 4802 may be implemented through an input/output interface (or a communication interface) of the chip or the chip system, and a function/implementation process of the processing module 4801 may be implemented through a processor (or a processing circuit) of the chip or the chip system.

The transmitting apparatus 480 provided in embodiments may perform the foregoing method. Therefore, for technical effects that can be achieved by the transmitting apparatus 480, refer to the foregoing method embodiments. Details are not described herein again.

In an implementation scenario, an example in which the communication apparatus is the receiving apparatus in the foregoing method embodiment is used. FIG. 49 is a schematic of a structure of a receiving apparatus 490. The receiving apparatus 490 includes a processing module 4901 and a transceiver module 4902.

In some embodiments, the receiving apparatus 490 may further include a storage module (not shown in FIG. 49), configured to store program instructions and data.

In some embodiments, the transceiver module 4902 may also be referred to as a transceiver unit, and is configured to implement a sending function and/or a receiving function. The transceiver module 4902 may include a transceiver circuit, a transceiver machine, a transceiver, or a communication interface.

In some embodiments, the transceiver module 4902 may include a receiving module and a sending module, respectively configured to perform receiving-type steps and sending-type steps performed by the receiving apparatus in the foregoing method embodiments, and/or configured to support another process of the technology described in this specification; and the processing module 4901 may be configured to perform processing-type (for example, determining, obtaining, and generating) steps performed by the receiving apparatus in the foregoing method embodiments, and/or configured to support another process of the technology described in this specification.

In a possible implementation, the transceiver module 4902 is configured to receive a modulation symbol; the processing module 4901 is configured to perform demodulation on the modulation symbol to obtain a to-be-deinterleaved log-likelihood ratio LLR sequence; and the processing module 4901 is further configured to perform first deinterleaving on the to-be-deinterleaved LLR sequence to obtain a first deinterleaved LLR sequence. The first deinterleaving includes: writing the to-be-deinterleaved LLR sequence onto a second matrix row by row in a second order, and reading the to-be-deinterleaved LLR sequence from the second matrix column by column in a first order. A quantity of columns of the second matrix is a modulation order M, and M is greater than or equal to 3. A first bit written row by row is a most significant bit MSB, and an $M^{th}$ bit written row by row is a least significant bit LSB. The processing module 4901 is further configured to determine an information bit based on the first deinterleaved LLR sequence.

In another possible implementation, the transceiver module 4902 is configured to receive the modulation symbol.

The processing module 4901 is configured to perform demodulation on the modulation symbol to obtain a to-be-deinterleaved log-likelihood ratio LLR sequence. The processing module 4901 is further configured to perform first deinterleaving on the to-be-deinterleaved LLR sequence to obtain a first deinterleaved LLR sequence. The first deinterleaving includes: writing the to-be-deinterleaved LLR sequence onto a second matrix row by row from left to right, and reading the to-be-deinterleaved LLR sequence from the second matrix column by column from left to right. A quantity of columns of the second matrix is a modulation order M, M is greater than or equal to 3, a first bit written row by row is a most significant bit MSB, and an $M^{th}$ bit written row by row is a least significant bit LSB. The processing module 4901 is further configured to determine an information bit based on the first deinterleaved LLR sequence. A constellation diagram used for the demodulation includes $2^M$ constellation points, the $2^M$ constellation points are distributed on N rings, a constellation point on at least one of the N rings meets a Gray mapping principle, and N is a positive integer.

Optionally, that the processing module 4901 is configured to determine an information bit based on the first deinterleaved LLR sequence includes: The processing module 4901 is configured to decode the first deinterleaved LLR sequence, to obtain the information bit.

Optionally, that the processing module 4901 is configured to determine an information bit based on the first deinterleaved LLR sequence includes: The processing module 4901 is configured to perform second deinterleaving on the first deinterleaved LLR sequence, to obtain a second deinterleaved LLR sequence. The processing module 4901 is further configured to decode the second deinterleaved LLR sequence, to obtain the information bit.

All related content of each step involved in the foregoing method embodiment may be referenced to a function description of a corresponding functional module, and details are not described herein again.

In this application, the receiving apparatus 490 is presented in a form of functional modules obtained through division in an integrated manner. The "module" herein may be an application-specific integrated circuit (application-specific integrated circuit, ASIC), a circuit, a processor and a memory that execute one or more software or firmware programs, an integrated logic circuit, and/or another component that can provide the foregoing functions.

In some embodiments, in hardware implementation, when the receiving apparatus is a network device, a person skilled in the art may figure out that the receiving apparatus 490 may be in a form of the network device 30 shown in FIG. 13.

In an example, functions/implementation processes of the processing module 4901 in FIG. 49 may be implemented by the processor 301 in the network device 30 shown in FIG. 13 by invoking the computer-executable instructions stored in the memory 302, and functions/implementation processes of the transceiver module 4902 in FIG. 49 may be implemented by the transceiver 303 in the network device 30 shown in FIG. 13.

In some embodiments, in hardware implementation, when the receiving apparatus is a terminal device, a person skilled in the art may figure out that the receiving apparatus 490 may be in a form of the terminal device 40 shown in FIG. 13.

In an example, functions/implementation processes of the processing module 4901 in FIG. 49 may be implemented by the processor 401 in the terminal device 40 shown in FIG. 13 by invoking the computer-executable instructions stored in the memory 402, and functions/implementation processes of the transceiver module 4902 in FIG. 49 may be implemented by the transceiver 403 in the terminal device 40 shown in FIG. 13.

In some embodiments, when the receiving apparatus 490 in FIG. 49 is a chip or a chip system, a function/implementation process of the transceiver module 4902 may be implemented through an input/output interface (or a communication interface) of the chip or the chip system, and a function/implementation process of the processing module 4901 may be implemented through a processor (or a processing circuit) of the chip or the chip system.

The receiving apparatus 490 provided in embodiments may perform the foregoing methods. Therefore, for technical effects that can be achieved by receiving apparatus 490, refer to the foregoing method embodiments. Details are not described herein again.

In some embodiments, an embodiment of this application further provides a communication apparatus. The communication apparatus includes a processor, configured to implement the method in any one of the foregoing method embodiments.

In a possible implementation, the communication apparatus further includes a memory. The memory is configured to store necessary program instructions and data. The processor may invoke program code stored in the memory, to indicate the communication apparatus to perform the method in any one of the foregoing method embodiments. Certainly, the memory may alternatively not be in the communication apparatus.

In another possible implementation, the communication apparatus further includes an interface circuit. The interface circuit is a code/data read/write interface circuit, and the interface circuit is configured to receive computer-executable instructions (the computer-executable instructions are stored in the memory, and may be directly read from the memory, or may be read via another component) and send the computer-executable instructions to the processor.

In still another possible implementation, the communication apparatus further includes a communication interface, and the communication interface is configured to communicate with a module other than the communication apparatus.

It may be understood that the communication apparatus may be a chip or a chip system. When the communication apparatus is a chip system, the communication apparatus may include a chip, or may include a chip and another discrete component. This is not specifically limited in embodiments of this application.

In some embodiments, an embodiment of this application further provides a communication apparatus. The communication apparatus includes an interface circuit and a logic circuit. The interface circuit is configured to input and/or output information. The logic circuit is configured to perform the method in any one of the foregoing method embodiments, to process input information and/or generate output information.

In a possible implementation, when the communication apparatus is configured to implement a function of the foregoing transmitting apparatus, the output information is a modulation symbol.

In a possible implementation, when the communication apparatus is configured to implement a function of the foregoing receiving apparatus, the input information is a modulation symbol. The processing input information includes: performing demodulation on the modulation symbol to obtain a to-be-deinterleaved log-likelihood ratio LLR sequence; performing first deinterleaving on the to-be-deinterleaved LLR sequence to obtain a first deinterleaved LLR sequence; and determining an information bit based on the first deinterleaved LLR sequence.

In a possible product form, the transmitting apparatus and the receiving apparatus in embodiments of this application may be further implemented through the following: one or more field programmable gate arrays (field programmable gate arrays, FPGAs), a programmable logic device (programmable logic device, PLD), a controller, a state machine, gate logic, a discrete hardware component, any other appropriate circuit, or any combination of circuits capable of performing various functions described in this application.

This application further provides a computer-readable storage medium. The computer-readable storage medium stores computer programs or instructions. When the computer programs or instructions are executed by a computer, functions in any foregoing method embodiment are implemented.

This application further provides a computer program product. When the computer program product is executed by a computer, functions in any foregoing method embodiment are implemented.

A person of ordinary skill in the art may understand that, for the purpose of convenient and brief description, for a detailed working process of the foregoing system, apparatuses, and units, refer to a corresponding process in the foregoing method embodiment. Details are not described herein again.

It may be understood that the system, apparatuses, and methods described in this application may alternatively be implemented in another manner. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, that is, may be located in one position or distributed on a plurality of network units. Parts displayed as units may or may not be physical units. Some or all of the units may be selected based on an actual requirement, to achieve the objectives of the solutions of embodiments.

In addition, functional units in embodiments of this application may be integrated into one processing unit, or each of the units may exist alone physically, or two or more units may be integrated into one unit.

All or some of the foregoing embodiments may be implemented by software, hardware, firmware, or any combination thereof. When a software program is used to implement the embodiments, all or some of the embodiments may be implemented in a form of a computer program product. The computer program product includes one or more computer instructions. When the computer program instructions are loaded and executed on the computer, the procedures or functions according to embodiments of this application are completely or partially generated. The computer may be a general-purpose computer, a special-purpose computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like. In embodiments of this application, the computer may include the apparatus described above.

Although this application is described with reference to embodiments, in a process of implementing this application that claims protection, a person skilled in the art may understand and implement another variation of the disclosed embodiments by viewing the accompanying drawings, disclosed content, and the appended claims. In the claims, "comprising" (comprising) does not exclude another component or another step, and "a" or "one" does not exclude a case of "a plurality of". A single processor or another unit may implement several functions enumerated in the claims. Some measures are recorded in dependent claims that are different from each other, but this does not mean that these measures cannot be combined to produce better effect.

Although this application is described with reference to specific features and embodiments thereof, it is clear that various modifications and combinations may be made to them without departing from the spirit and scope of this application. Correspondingly, the specification and accompanying drawings are merely example description of this application defined by the appended claims, and are considered as any of or all modifications, variations, combinations, or equivalents that cover the scope of this application. It is clear that a person skilled in the art can make various modifications and variations to this application without departing from the spirit and scope of this application. This application is intended to cover these modifications and variations of this application provided that they fall within the scope of protection defined by the claims of this application and their equivalent technologies.

**Claims**

1. An interleaving and modulation method, wherein the method comprises:

   obtaining to-be-interleaved bits;
   performing first interleaving on the to-be-interleaved bits, to obtain interleaved bits, wherein the first interleaving comprises: writing the to-be-interleaved bits onto a first matrix column by column in a first order, and reading the to-be-interleaved bits from the first matrix row by row in a second order, wherein a quantity of columns of the first matrix is a modulation order M, M is greater than or equal to 3, a first bit read row by row is a most significant bit MSB, and an $M^{th}$ bit read row by row is a least significant bit LSB;
   performing modulation on the interleaved bits to obtain modulation symbols; and
   sending the modulation symbols, wherein
   when M is equal to 3, a mode used for the modulation is digital video broadcasting-satellite second generation DVB-S2 8 phase shift keying PSK; and
   the first order is the third column to the second column to the first column of the first matrix, and the second order is the first column to the second column to the third column of the first matrix; or
   the first order is the second column to the third column to the first column of the first matrix, and the second order is the first column to the second column to the third column of the first matrix; or
   the first order is the first column to the second column to the third column of the first matrix, and the second order is the second column to the third column to the first column of the first matrix.

2. The method according to claim 1, wherein when M is equal to 4, a mode used for the modulation is DVB-S2 16 amplitude phase shift keying APSK; and the second order is the first column to the second column to the third column to the fourth column of the first matrix; and

   the first order is the fourth column to the third column to the second column to the first column of the first matrix; or
   the first order is the fourth column to the third column to the first column to the second column of the first matrix; or
   the first order is the third column to the fourth column to the second column to the first column of the first matrix; or
   the first order is the third column to the fourth column to the first column to the second column of the first matrix.

3. The method according to claim 1 or 2, wherein when M is equal to 5, a mode used for the modulation is DVB-S2 32APSK; and the second order is the first column to the second column to the third column to the fourth column to the fifth column of the first matrix; and

   the first order is the fourth column to the third column to the second column to the first column to the fifth column of the first matrix; or
   the first order is the fourth column to the second column to the third column to the first column to the fifth column of the first matrix; or
   the first order is the fourth column to the third column to the second column to the fifth column to the first column of the first matrix; or
   the first order is the fourth column to the second column to the third column to the fifth column to the first column of the first matrix.

4. An interleaving and modulation method, wherein the method comprises:

   obtaining to-be-interleaved bits;

performing first interleaving on the to-be-interleaved bits, to obtain interleaved bits, wherein the first interleaving comprises: writing the to-be-interleaved bits onto a first matrix column by column from left to right, and reading the to-be-interleaved bits from the first matrix row by row from left to right, wherein a quantity of columns of the first matrix is a modulation order M, M is greater than or equal to 3, a first bit read row by row is a most significant bit MSB, and an $M^{th}$ bit read row by row is a least significant bit LSB;

performing modulation on the interleaved bits to obtain modulation symbols, wherein a constellation diagram used for the modulation comprises $2^M$ constellation points, the $2^M$ constellation points are distributed on N rings, a constellation point on at least one of the N rings meets a Gray mapping principle, and N is a positive integer; and sending the modulation symbols.

5. The method according to claim 4, wherein when M is equal to 3, the eight constellation points are evenly distributed on one ring; and

a phase corresponding to a first constellation point is $\pi/4$ or $\pi/8$, bits corresponding to the first constellation point are 000, and by using the first constellation point as a reference, bits corresponding to the remaining seven constellation points in a clockwise direction are respectively 010, 011, 111, 110, 100, 101, and 001, or are respectively 100, 101, 111, 110, 010, 011, and 001.

6. The method according to claim 4 or 5, wherein when M is equal to 4, four constellation points of the 16 constellation points are evenly distributed on a first ring, the other 12 constellation points are evenly distributed on a second ring, the first ring and the second ring are concentric rings, and phases corresponding to a first constellation point on the first ring and a second constellation point on the second ring are $\pi/4$, wherein

bits corresponding to the first constellation point are 0011, and by using the first constellation point as a reference, bits corresponding to the remaining three constellation points on the first ring in a clockwise direction are respectively 0111, 1111, and 1011; and
bits corresponding to the second constellation point are 0000, and by using the second constellation point as a reference, bits corresponding to the remaining 11 constellation points on the second ring in a clockwise direction are respectively 0001, 0101, 0100, 0110, 1110, 1100, 1101, 1001, 1000, 1010 and 0010; or
bits corresponding to the first constellation point are 0011, and by using the first constellation point as a reference, bits corresponding to the remaining three constellation points on the first ring in a clockwise direction are respectively 0111, 1111, and 1011; and
bits corresponding to the second constellation point are 0000, and by using the second constellation point as a reference, bits corresponding to the remaining 11 constellation points on the second ring in a clockwise direction are respectively 0010, 0110, 0100, 0101, 1101, 1100, 1110, 1010, 1000, 1001 and 0001; or
bits corresponding to the first constellation point are 0011, and by using the first constellation point as a reference, bits corresponding to the remaining three constellation points on the first ring in a clockwise direction are respectively 1011, 1111, and 0111; and
bits corresponding to the second constellation point are 0000, and by using the second constellation point as a reference, bits corresponding to the remaining 11 constellation points on the second ring in a clockwise direction are respectively 0001, 1001, 1000, 1010, 1110, 1100, 1101, 0101, 0100, 0110 and 0010; or
bits corresponding to the first constellation point are 0011, and by using the first constellation point as a reference, bits corresponding to the remaining three constellation points on the first ring in a clockwise direction are respectively 1011, 1111, and 0111; and
bits corresponding to the second constellation point are 0000, and by using the second constellation point as a reference, bits corresponding to the remaining 11 constellation points on the second ring in a clockwise direction are respectively 0010, 1010, 1000, 1001, 1101, 1100, 1110, 0110, 0100, 0101 and 0001.

7. The method according to any one of claims 4 to 6, wherein when M is equal to 5, four constellation points of the 32 constellation points are evenly distributed on the first ring, other 12 constellation points are evenly distributed on the second ring, the remaining 16 constellation points are evenly distributed on a third ring, the first ring, the second ring, and the third ring are concentric rings, and phases corresponding to the first constellation point on the first ring, the second constellation point on the second ring, and a third constellation point on the third ring are $\pi/4$, wherein

bits corresponding to the first constellation point are 00011, and by using the first constellation point as a reference, bits corresponding to the remaining three constellation points on the first ring in a clockwise direction are respectively 00111, 01111, and 01011;
bits corresponding to the second constellation point are 00000, and by using the second constellation point as a reference, bits corresponding to the remaining 11 constellation points on the second ring in a clockwise direction are respectively 00001, 00101, 00100, 00110, 01110, 01100, 01101, 01001, 01000, 01010 and 00010; and

bits corresponding to the third constellation point are 10011, and by using the third constellation point as a reference, bits corresponding to the remaining 15 constellation points on the third ring in a clockwise direction are respectively 10000, 10001, 10101, 10100, 10111, 10110, 11110, 11111, 11100, 11101, 11001, 11000, 11011, 11010 and 10010; or

bits corresponding to the first constellation point are 00101, and by using the first constellation point as a reference, bits corresponding to the remaining three constellation points on the first ring in a clockwise direction are respectively 00111, 01111, and 01101;

bits corresponding to the second constellation point are 00000, and by using the second constellation point as a reference, bits corresponding to the remaining 11 constellation points on the second ring in a clockwise direction are respectively 00001, 00011, 00010, 00110, 01110, 01010, 01011, 01001, 01000, 01100 and 00100; and

bits corresponding to the third constellation point are 10101, and by using the third constellation point as a reference, bits corresponding to the remaining 15 constellation points on the third ring in a clockwise direction are respectively 10000, 10001, 10011, 10010, 10111, 10110, 11110, 11111, 11010, 11011, 11001, 11000, 11101, 11100 and 10100; or

bits corresponding to the first constellation point are 10010, and by using the first constellation point as a reference, bits corresponding to the remaining three constellation points on the first ring in a clockwise direction are respectively 10110, 11110, and 11010;

bits corresponding to the second constellation point are 00000, and by using the second constellation point as a reference, bits corresponding to the remaining 11 constellation points on the second ring in a clockwise direction are respectively 10000, 10100, 00100, 00110, 01110, 01100, 11100, 11000, 01000, 01010 and 00010; and

bits corresponding to the third constellation point are 10011, and by using the third constellation point as a reference, bits corresponding to the remaining 15 constellation points on the third ring in a clockwise direction are respectively 00001, 10001, 10101, 00101, 10111, 00111, 01111, 11111, 01101, 11101, 11001, 01001, 11011, 01011 and 00011; or

bits corresponding to the first constellation point are 10100, and by using the first constellation point as a reference, bits corresponding to the remaining three constellation points on the first ring in a clockwise direction are respectively 10110, 11110, and 11100;

bits corresponding to the second constellation point are 00000, and by using the second constellation point as a reference, bits corresponding to the remaining 11 constellation points on the second ring in a clockwise direction are respectively 10000, 10010, 00010, 00110, 01110, 01010, 11010, 11000, 01000, 01100 and 00100; and

bits corresponding to the third constellation point are 10101, and by using the third constellation point as a reference, bits corresponding to the remaining 15 constellation points on the third ring in a clockwise direction are respectively 00001, 10001, 10011, 00011, 10111, 00111, 01111, 11111, 01011, 11011, 11001, 01001, 11101, 01101 and 00101.

8. The method according to any one of claims 1 to 7, wherein the to-be-interleaved bits are coded bits, or the to-be-interleaved bits are bits obtained after second interleaving is performed on coded bits.

9. The method according to claim 8, wherein the second interleaving comprises: performing random or pseudo-random interleaving on the last N-X bits of the coded bits, wherein X is greater than or equal to a quantity of system bits, and N is a quantity of the coded bits.

10. A deinterleaving and demodulation method, wherein the method comprises:

receiving a modulation symbol;
performing demodulation on the modulation symbol to obtain a to-be-deinterleaved log-likelihood ratio LLR sequence;
performing first deinterleaving on the to-be-deinterleaved LLR sequence to obtain a first deinterleaved LLR sequence, wherein the first deinterleaving comprises: writing the to-be-deinterleaved LLR sequence onto a second matrix row by row in a second order, and reading the to-be-deinterleaved LLR sequence from the second matrix column by column in a first order, wherein a quantity of columns of the second matrix is a modulation order M, M is greater than or equal to 3, and a first bit written row by row is a most significant bit MSB, and an $M^{th}$ bit written row by row is a least significant bit LSB; and

determining an information bit based on the first deinterleaved LLR sequence, wherein
when M is equal to 3, a modulation type corresponding to the demodulation is digital video broadcasting-satellite second generation DVB-S2 8 phase shift keying PSK; and
the first order is the third column to the second column to the first column of the second matrix, and the second order is the first column to the second column to the third column of the second matrix; or
the first order is the second column to the third column to the first column of the second matrix, and the second order is the first column to the second column to the third column of the second matrix; or
the first order is the first column to the second column to the third column of the second matrix, and the second order is the second column to the third column to the first column of the second matrix.

11. The method according to claim 10, wherein when M is equal to 4, a modulation type corresponding to the demodulation is DVB-S2 16 amplitude phase shift keying APSK; and the second order is the first column to the second column to the third column to the fourth column of the second matrix; and

the first order is the fourth column to the third column to the second column to the first column of the second matrix; or
the first order is the fourth column to the third column to the first column to the second column of the second matrix; or
the first order is the third column to the fourth column to the second column to the first column of the second matrix; or
the first order is the third column to the fourth column to the first column to the second column of the second matrix.

12. The method according to claim 10 or 11, wherein when M is equal to 5, a modulation type corresponding to the demodulation is DVB-S2 32APSK; and the second order is the first column to the second column to the third column to the fourth column to the fifth column of the second matrix; and

the first order is the fourth column to the third column to the second column to the first column to the fifth column of the second matrix; or
the first order is the fourth column to the second column to the third column to the first column to the fifth column of the second matrix; or
the first order is the fourth column to the third column to the second column to the fifth column to the first column of the second matrix; or
the first order is the fourth column to the second column to the third column to the fifth column to the first column of the second matrix.

13. A deinterleaving and demodulation method, wherein the method comprises:

receiving a modulation symbol;
performing demodulation on the modulation symbol to obtain a to-be-deinterleaved log-likelihood ratio LLR sequence;
performing first deinterleaving on the to-be-deinterleaved LLR sequence to obtain a first deinterleaved LLR sequence, wherein the first deinterleaving comprises: writing the to-be-deinterleaved LLR sequence onto a second matrix row by row from left to right, and reading the to-be-deinterleaved LLR sequence from the second matrix column by column from left to right, wherein a quantity of columns of the second matrix is a modulation order M, M is greater than or equal to 3, a first bit written row by row is a most significant bit MSB, and an M$^{th}$ bit written row by row is a least significant bit LSB; and
determining an information bit based on the first deinterleaved LLR sequence, wherein
a constellation diagram used for the demodulation comprises $2^M$ constellation points, the $2^M$ constellation points are distributed on N rings, a constellation point on at least one of the N rings meets a Gray mapping principle, and N is a positive integer.

14. The method according to claim 13, wherein when M is equal to 3, the eight constellation points are evenly distributed on one ring; and
a phase corresponding to a first constellation point is $\pi/4$ or $\pi/8$, bits corresponding to the first constellation point are 000, and by using the first constellation point as a reference, bits corresponding to the remaining seven constellation points in a clockwise direction are respectively 010, 011, 111, 110, 100, 101, and 001, or are respectively 100, 101, 111, 110, 010, 011, and 001.

15. The method according to claim 13 or 14, wherein when M is equal to 4, four constellation points of the 16 constellation points are evenly distributed on a first ring, the other 12 constellation points are evenly distributed on a second ring, the first ring and the second ring are concentric rings, and phases corresponding to a first constellation point on the first ring and a second constellation point on the second ring are $\pi/4$, wherein

bits corresponding to the first constellation point are 0011, and by using the first constellation point as a reference, bits corresponding to the remaining three constellation points on the first ring in a clockwise direction are respectively 0111, 1111, and 1011; and
bits corresponding to the second constellation point are 0000, and by using the second constellation point as a reference, bits corresponding to the remaining 11 constellation points on the second ring in a clockwise direction are respectively 0001, 0101, 0100, 0110, 1110, 1100, 1101, 1001, 1000, 1010 and 0010; or
bits corresponding to the first constellation point are 0011, and by using the first constellation point as a reference, bits corresponding to the remaining three constellation points on the first ring in a clockwise direction are respectively 0111, 1111, and 1011; and
bits corresponding to the second constellation point are 0000, and by using the second constellation point as a reference, bits corresponding to the remaining 11 constellation points on the second ring in a clockwise direction are respectively 0010, 0110, 0100, 0101, 1101, 1100, 1110, 1010, 1000, 1001 and 0001; or
bits corresponding to the first constellation point are 0011, and by using the first constellation point as a reference, bits corresponding to the remaining three constellation points on the first ring in a clockwise direction are respectively 1011, 1111, and 0111; and
bits corresponding to the second constellation point are 0000, and by using the second constellation point as a reference, bits corresponding to the remaining 11 constellation points on the second ring in a clockwise direction are respectively 0001, 1001, 1000, 1010, 1110, 1100, 1101, 0101, 0100, 0110 and 0010; or
bits corresponding to the first constellation point are 0011, and by using the first constellation point as a reference, bits corresponding to the remaining three constellation points on the first ring in a clockwise direction are respectively 1011, 1111, and 0111; and
bits corresponding to the second constellation point are 0000, and by using the second constellation point as a reference, bits corresponding to the remaining 11 constellation points on the second ring in a clockwise direction are respectively 0010, 1010, 1000, 1001, 1101, 1100, 1110, 0110, 0100, 0101 and 0001.

16. The method according to any one of claims 13 to 15, wherein when M is equal to 5, four constellation points of the 32 constellation points are evenly distributed on the first ring, other 12 constellation points are evenly distributed on the second ring, the remaining 16 constellation points are evenly distributed on a third ring, the first ring, the second ring, and the third ring are concentric rings, and phases corresponding to the first constellation point on the first ring, the second constellation point on the second ring, and a third constellation point on the third ring are $\pi/4$, wherein

bits corresponding to the first constellation point are 00011, and by using the first constellation point as a reference, bits corresponding to the remaining three constellation points on the first ring in a clockwise direction are respectively 00111, 01111, and 01011;
bits corresponding to the second constellation point are 00000, and by using the second constellation point as a reference, bits corresponding to the remaining 11 constellation points on the second ring in a clockwise direction are respectively 00001, 00101, 00100, 00110, 01110, 01100, 01101, 01001, 01000, 01010 and 00010; and
bits corresponding to the third constellation point are 10011, and by using the third constellation point as a reference, bits corresponding to the remaining 15 constellation points on the third ring in a clockwise direction are respectively 10000, 10001, 10101, 10100, 10111, 10110, 11110, 11111, 11100, 11101, 11001, 11000, 11011, 11010 and 10010; or
bits corresponding to the first constellation point are 00101, and by using the first constellation point as a reference, bits corresponding to the remaining three constellation points on the first ring in a clockwise direction are respectively 00111, 01111, and 01101;
bits corresponding to the second constellation point are 00000, and by using the second constellation point as a reference, bits corresponding to the remaining 11 constellation points on the second ring in a clockwise direction are respectively 00001, 00011, 00010, 00110, 01110, 01010, 01011, 01001, 01000, 01100 and 00100; and
bits corresponding to the third constellation point are 10101, and by using the third constellation point as a reference, bits corresponding to the remaining 15 constellation points on the third ring in a clockwise direction are respectively 10000, 10001, 10011, 10010, 10111, 10110, 11110, 11111, 11010, 11011, 11001, 11000, 11101, 11100 and 10100; or

bits corresponding to the first constellation point are 10010, and by using the first constellation point as a reference, bits corresponding to the remaining three constellation points on the first ring in a clockwise direction are respectively 10110, 11110, and 11010;

bits corresponding to the second constellation point are 00000, and by using the second constellation point as a reference, bits corresponding to the remaining 11 constellation points on the second ring in a clockwise direction are respectively 10000, 10100, 00100, 00110, 01110, 01100, 11100, 11000, 01000, 01010 and 00010; and

bits corresponding to the third constellation point are 10011, and by using the third constellation point as a reference, bits corresponding to the remaining 15 constellation points on the third ring in a clockwise direction are respectively 00001, 10001, 10101, 00101, 10111, 00111, 01111, 11111, 01101, 11101, 11001, 01001, 11011, 01011 and 00011; or

bits corresponding to the first constellation point are 10100, and by using the first constellation point as a reference, bits corresponding to the remaining three constellation points on the first ring in a clockwise direction are respectively 10110, 11110, and 11100;

bits corresponding to the second constellation point are 00000, and by using the second constellation point as a reference, bits corresponding to the remaining 11 constellation points on the second ring in a clockwise direction are respectively 10000, 10010, 00010, 00110, 01110, 01010, 11010, 11000, 01000, 01100 and 00100; and

bits corresponding to the third constellation point are 10101, and by using the third constellation point as a reference, bits corresponding to the remaining 15 constellation points on the third ring in a clockwise direction are respectively 00001, 10001, 10011, 00011, 10111, 00111, 01111, 11111, 01011, 11011, 11001, 01001, 11101, 01101 and 00101.

17. The method according to any one of claims 10 to 16, wherein the determining an information bit based on the first deinterleaved LLR sequence comprises:
decoding the first deinterleaved LLR sequence, to obtain the information bit.

18. The method according to any one of claims 10 to 16, wherein the determining an information bit based on the first deinterleaved LLR sequence comprises:

performing second deinterleaving on the first deinterleaved LLR sequence, to obtain a second deinterleaved LLR sequence; and
decoding the second deinterleaved LLR sequence, to obtain the information bit.

19. The method according to claim 18, wherein the second deinterleaving comprises: performing deinterleaving on the last N-X elements of the first LLR sequence in a preset order, wherein N is a quantity of information bits, and X is greater than or equal to a quantity of system bits.

20. A communication apparatus, comprising a module configured to perform the method according to any one of claims 1 to 9, or comprising a module configured to perform the method according to any one of claims 10 to 19.

21. A communication apparatus, wherein the communication apparatus comprises a processor, wherein
the processor is configured to execute a computer program or instructions stored in a memory, to enable the communication apparatus to perform the method according to any one of claims 1 to 9, or to enable the communication apparatus to perform the method according to any one of claims 10 to 19.

22. A communication apparatus, wherein the communication apparatus comprises an interface circuit and a logic circuit, wherein

the interface circuit is configured to input and/or output information; and
the logic circuit is configured to: perform the method according to any one of claims 1 to 9, to generate information output by the interface circuit; or perform the method according to any one of claims 10 to 19, to process information input by the interface circuit.

23. A computer-readable storage medium, configured to store instructions, wherein when the instructions are executed, the method according to any one of claims 1 to 9 is implemented, or the method according to any one of claims 10 to 19 is implemented.

24. A computer program product, wherein when the computer program product runs on a communication apparatus, the method according to any one of claims 1 to 9 is implemented, or the method according to any one of claims 10 to 19 is implemented.

25. A communication system, wherein the communication system comprises a communication apparatus configured to perform the method according to any one of claims 1 to 9, and a communication apparatus configured to perform the method according to any one of claims 10 to 19.

FIG. 1

FIG. 2

FIG. 3

FIG. 4

FIG. 5

FIG. 6

FIG. 7

FIG. 8

FIG. 9

Write

Column 1
MSB

Column 2

Column 3

Column 4
LSB

Read

Column 1
MSB

Column 2

Column 3

Column 4
LSB

Diagram of LDPC coded bits

| System bit | Non-system bit |
|---|---|

Write

Column 1
MSB

Column 2

Column 3

Column 4
LSB

Read

Column 1
MSB

Column 2

Column 3

Column 4
LSB

FIG. 10

EP 4 418 577 A1

FIG. 11

FIG. 12

FIG. 13

EP 4 418 577 A1

```
┌──────────────────┐                    ┌──────────────────┐
│   Transmitting   │                    │    Receiving     │
│    apparatus     │                    │    apparatus     │
└──────────────────┘                    └──────────────────┘
```

S1401: Obtain to-be-interleaved bits

S1402: Perform first interleaving on the to-be-interleaved bits, to obtain interleaved bits, where the first interleaving includes: writing the to-be-interleaved bits onto a first matrix column by column in a first order, and reading the to-be-interleaved bits from the first matrix row by row in a second order

S1403: Perform modulation on the interleaved bits to obtain modulation symbols

S1404: Modulation symbols

S1405: Perform demodulation on the modulation symbols to obtain a to-be-deinterleaved LLR sequence

S1406: Perform first deinterleaving on the to-be-deinterleaved LLR sequence to obtain a first deinterleaved LLR sequence

S1407: Determine an information bit based on the first deinterleaved LLR sequence

FIG. 14

FIG. 15

FIG. 16a

Read

Write

Column 1    Column 2    Column 3

Column 1    Column 2    Column 3

FIG. 16b

Write

Read

Column 1    Column 2    Column 3
MSB                     LSB

Column 1    Column 2    Column 3
MSB                     LSB

FIG. 17

Write

Column 1
MSB

Column 2

Column 3
LSB

Read

Column 1
LSB

Column 2
MSB

Column 3

FIG. 18

Write

Column
1
MSB

Column
2

Column
3

Column
4
LSB

Read

Column
1
MSB

Column
2

Column
3

Column
4
LSB

FIG. 19

FIG. 20

FIG. 21

FIG. 22

FIG. 23

Write - - - →

Column 1    Column 2    Column 3    Column 4    Column 5
MSB                                             LSB

Read

Column 1    Column 2    Column 3    Column 4    Column 5
MSB                                             LSB

FIG. 24

EP 4 418 577 A1

FIG. 25

Read

Write

Column 1 MSB   Column 2   Column 3   Column 4   Column 5 LSB

Column 1 MSB   Column 2   Column 3   Column 4   Column 5 LSB

FIG. 26

FIG. 27

EP 4 418 577 A1

FIG. 28

```
┌─────────────────┐                              ┌─────────────────┐
│   Transmitting  │                              │    Receiving    │
│    apparatus    │                              │    apparatus    │
└─────────────────┘                              └─────────────────┘
         │                                                │
┌──────────────────────────────────────┐                 │
│  S2901: Obtain to-be-interleaved bits │                 │
└──────────────────────────────────────┘                 │
         │                                                │
┌──────────────────────────────────────┐                 │
│  S2902: Perform first interleaving on │                 │
│  the to-be-interleaved bits, to obtain│                 │
│  interleaved bits, where the first    │                 │
│  interleaving includes: writing the   │                 │
│  to-be-interleaved bits onto a first  │                 │
│  matrix column by column from left to │                 │
│  right, and reading the to-be-        │                 │
│  interleaved bits from the first      │                 │
│  matrix row by row from left to right │                 │
└──────────────────────────────────────┘                 │
         │                                                │
┌──────────────────────────────────────┐                 │
│  S2903: Perform modulation on the     │                 │
│  interleaved bits to obtain           │                 │
│  modulation symbols                   │                 │
└──────────────────────────────────────┘                 │
         │         S2904: Modulation symbols              │
         └───────────────────────────────────────────────▶
                                                          │
                                   ┌──────────────────────────────────┐
                                   │  S2905: Perform demodulation on  │
                                   │  the modulation symbols to obtain│
                                   │  a to-be-deinterleaved LLR       │
                                   │  sequence                        │
                                   └──────────────────────────────────┘
                                                          │
                                   ┌──────────────────────────────────┐
                                   │  S2906: Perform first            │
                                   │  deinterleaving on the           │
                                   │  to-be-deinterleaved LLR sequence│
                                   │  to obtain a first deinterleaved │
                                   │  LLR sequence                    │
                                   └──────────────────────────────────┘
                                                          │
                                   ┌──────────────────────────────────┐
                                   │  S2907: Determine an information │
                                   │  bit based on the first          │
                                   │  deinterleaved LLR sequence      │
                                   └──────────────────────────────────┘
                                                          │
```

FIG. 29

FIG. 30

FIG. 31

FIG. 32

FIG. 33

FIG. 34

FIG. 35

FIG. 36

FIG. 37

FIG. 38

FIG. 39

FIG. 40

FIG. 41

FIG. 42

Second interleaving → First interleaving →

The first X bits are not interleaved, and the remaining N–X bits are (pseudo) randomly interleaved

N coded bits

An order of X bits remains unchanged and the X bits are not interleaved

N–X bits are (pseudo) randomly interleaved

FIG. 43

```
┌─────────────────┐                              ┌─────────────────┐
│   One-level     │                              │   Two-level     │
│  interleaving   │ ────────────────────────────▶│  interleaving   │ ──▶
└─────────────────┘                              └─────────────────┘
```

The first X bits are not interleaved, and the remaining N–X bits are (pseudo) randomly interleaved

Writing onto a first matrix column by column in a first order, and reading from the first matrix row by row in a second order

N bit streams

A length order of X bits remains unchanged and the X bits are not interleaved

Lengths of the N–X bits are (pseudo) randomly interleaved

Write

Read

Column 1 MSB   Column 2   Column 3   Column 4   Column 5 LSB

Column 1 MSB   Column 2   Column 3   Column 4   Column 5 LSB

FIG. 44

FIG. 45

FIG. 46

FIG. 47

480

Transmitting apparatus

Processing module    4801

Transceiver module    4802

FIG. 48

490

Receiving apparatus

Processing module    4901

Transceiver module    4902

FIG. 49

| INTERNATIONAL SEARCH REPORT | | International application No. |
|---|---|---|
| | | **PCT/CN2022/130890** |

**A. CLASSIFICATION OF SUBJECT MATTER**

H04L1/00(2006.01)i;H03M13/00(2006.01)i;H04L27/34(2006.01)i

According to International Patent Classification (IPC) or to both national classification and IPC

**B. FIELDS SEARCHED**

Minimum documentation searched (classification system followed by classification symbols)

H04L1/-,H03M13/-,H04L27/-

Documentation searched other than minimum documentation to the extent that such documents are included in the fields searched

Electronic data base consulted during the international search (name of data base and, where practicable, search terms used)

CNABS; CNTXT; CNKI; VEN; DWPI; USTXT; EPTXT; WOTXT; IEEE; 3GPP: 交织, 调制, 卫星, 相移键控, 幅度相移键控, 星座图, 格雷, 映射, 对数似然比, 圆形, 圆环, interleaver, modulation, APSK, DVB, LLR, PSK, satelite, constellation, circle, gray, map+, digital video broadcasting satelite, amplitude phase+shift keying, phase+shift keying, logarithm likelihood ratio

**C. DOCUMENTS CONSIDERED TO BE RELEVANT**

| Category* | Citation of document, with indication, where appropriate, of the relevant passages | Relevant to claim No. |
|---|---|---|
| X | CN 110730051 A (SAMSUNG ELECTRONICS CO., LTD.) 24 January 2020 (2020-01-24) description, paragraphs 0024-0038, 0060-0061, 0256-0522, and 0582-0599 | 1-25 |
| A | CN 103581103 A (SHANGHAI NATIONAL ENGINEERING RESEARCH CENTER OF DIGITAL TELEVISION CO., LTD.) 12 February 2014 (2014-02-12) entire document | 1-25 |
| A | CN 108633324 A (MEDIATEK INC.) 09 October 2018 (2018-10-09) entire document | 1-25 |
| A | CN 109194443 A (NANJING UNIVERSITY OF POSTS AND TELECOMMUNICATIONS) 11 January 2019 (2019-01-11) entire document | 1-25 |
| A | CN 112913145 A (QUALCOMM INC.) 04 June 2021 (2021-06-04) entire document | 1-25 |
| A | US 2019334556 A1 (SAMSUNG ELECTRONICS CO., LTD.) 31 October 2019 (2019-10-31) entire document | 1-25 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **02 February 2023** | **08 February 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

| Patent document cited in search report | | | Publication date (day/month/year) | Patent family member(s) | | | Publication date (day/month/year) |
|---|---|---|---|---|---|---|---|
| CN | 110730051 | A | 24 January 2020 | US | 2015236816 | A1 | 20 August 2015 |
| | | | | CA | 2940011 | A1 | 27 August 2015 |
| | | | | CA | 3040604 | A1 | 27 August 2015 |
| | | | | CA | 3133553 | A1 | 27 August 2015 |
| | | | | KR | 20150098226 | A | 27 August 2015 |
| | | | | MX | 2016010774 | A1 | 08 November 2016 |
| | | | | WO | 2015126194 | A1 | 27 August 2015 |
| | | | | EP | 3092764 | A1 | 16 November 2016 |
| | | | | VN | 49741 | A | 25 November 2016 |
| | | | | IN | 201617030895 | A | 30 December 2016 |
| | | | | CN | 106471782 | A | 01 March 2017 |
| | | | | BR | 112016019084 | A2 | 15 August 2017 |
| | | | | EP | 3092764 | A4 | 25 October 2017 |
| | | | | KR | 101800409 | B1 | 23 November 2017 |
| | | | | KR | 20170129668 | A | 27 November 2017 |
| | | | | KR | 101944526 | B1 | 31 January 2019 |
| | | | | KR | 20190011795 | A | 07 February 2019 |
| | | | | KR | 20190064556 | A | 10 June 2019 |
| | | | | CA | 2940011 | C | 11 June 2019 |
| | | | | MX | 366541 | B | 12 July 2019 |
| | | | | MX | 2019008372 | A1 | 16 September 2019 |
| | | | | US | 10425110 | B2 | 24 September 2019 |
| | | | | KR | 101986778 | B1 | 30 September 2019 |
| | | | | CN | 106471782 | B | 15 November 2019 |
| | | | | CN | 110730052 | A | 24 January 2020 |
| | | | | KR | 102245527 | B1 | 29 April 2021 |
| | | | | KR | 20210047844 | A | 30 April 2021 |
| | | | | CA | 3040604 | C | 23 November 2021 |
| | | | | CN | 110730052 | B | 14 January 2022 |
| | | | | IN | 394483 | B | 15 April 2022 |
| | | | | EP | 3092764 | B1 | 25 May 2022 |
| | | | | CN | 110730051 | B | 02 August 2022 |
| | | | | KR | 102428466 | B1 | 03 August 2022 |
| | | | | KR | 20220111233 | A | 09 August 2022 |
| CN | 103581103 | A | 12 February 2014 | CN | 103581103 | B | 17 August 2016 |
| CN | 108633324 | A | 09 October 2018 | US | 2018212628 | A1 | 26 July 2018 |
| | | | | WO | 2018137645 | A1 | 02 August 2018 |
| | | | | EP | 3571771 | A1 | 27 November 2019 |
| | | | | IN | 201927034056 | A | 03 January 2020 |
| | | | | TW | 201836282 | A | 01 October 2018 |
| | | | | TW | 689173 | B1 | 21 March 2020 |
| | | | | EP | 3571771 | A4 | 18 March 2020 |
| | | | | US | 10630319 | B2 | 21 April 2020 |
| CN | 109194443 | A | 11 January 2019 | CN | 109194443 | B | 29 December 2020 |
| CN | 112913145 | A | 04 June 2021 | US | 2020099472 | A1 | 26 March 2020 |
| | | | | WO | 2020068572 | A1 | 02 April 2020 |
| | | | | US | 10972219 | B2 | 06 April 2021 |
| | | | | EP | 3857715 | A1 | 04 August 2021 |
| US | 2019334556 | A1 | 31 October 2019 | US | 11012096 | B2 | 18 May 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111473306